# EUROPEAN PATENT APPLICATION

(11) **EP 2 189 508 A2**
(43) Date of publication of application: **26.05.2010**
(21) Application number: 09157011.9
(22) Date of filing: 31.03.2009
(51) Int. Cl.: C09K 11/06, H05B 33/14

(54) **Electroluminescent device using electroluminescent compounds**

(30) Priority: 21.11.2008 KR 20080116521
(71) Applicant: Gracel Display Inc., Seoul 133-833 (KR)
(72) Inventor: Jung, Seyoung, 121-270, Seoul (KR); Jeong, Eui Soo, 130-771, Seoul (KR); Lee, Ho Joon, Marlborough, MA 01752 (US); Cho, Young Jun, 136-060, Seoul (KR); Kwon, Hyuck Joo, 130-100, Seoul (KR); Kim, Bong Ok, 135-090, Seoul (KR); Kim, Sung Min, 157-886, Seoul (KR); Yoon, Seung Soo, 135-884, Seoul (KR)
(74) Representative: Buckley, Guy Julian

(57) **Abstract**

Provided is an electroluminescent device comprising an organic layer interposed between an anode and a cathode on a substrate, wherein the organic layer includes an electroluminescent layer containing one or more dopant compound(s) represented by Chemical Formula 1, and the dopant compound is a mixture of not less than 80% by weight and less than 100% by weight of the cis-form and more than 0% by weight and not more than 20% by weight of the trans-form: 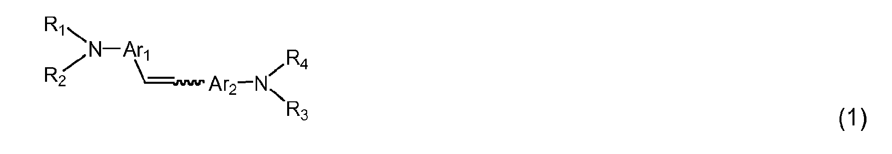 wherein 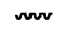 represents cis or trans configuration to the double bond.

The electroluminescent device, which includes a mixture of not less than 80% by weight and less than 100% by weight of a dopant having cis configuration and more than 0% by weight and not more than 20% by weight of the dopant having trans configuration, exhibits superior luminous efficiency, good color purity and excellent operation life.

## Description

### CROSS-REFERENCE TO RELATED APPLICATION

This application claims priority to Korean Patent Application No. 10-2008-0116521, filed on November 21, 2008, and all the benefits accruing therefrom under 35 U.S.C. §119, the contents of which in its entirety are herein incorporated by reference.

### BACKGROUND

### 1. Field

The present invention relates to an electroluminescent device in which an organic layer is interposed between an anode and a cathode on a substrate, wherein the organic layer comprises an electroluminescent layer comprising one or more dopant compound(s) represented by Chemical Formula 1, and the dopant compound is a mixture of not less than 80% by weight and less than 100% by weight of the cis-form and more than 0% by weight and not more than 20% by weight of the trans-form: 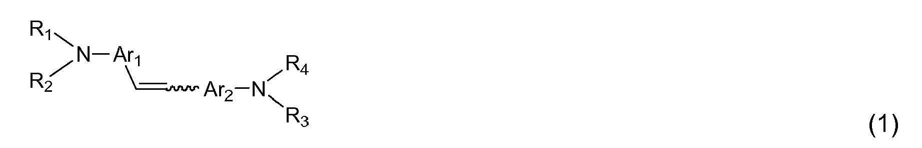 wherein
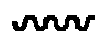 represents cis or trans configuration to the double bond.

### 2. Description of the Related Art

Among display devices, electroluminescence (EL) devices are advantageous in that they provide wide view angle, superior contrast and fast response rate as self-emissive display devices. In 1987, Eastman Kodak first developed an organic EL device using low-molecular-weight aromatic diamine and aluminum complex as electroluminescent materials [Appl. Phys. Lett. 51, 913, 1987].

In an organic EL device, when a charge is applied to an organic layer formed between an electron injection electrode (cathode) and a hole injection electrode (anode), an electron and a hole are paired and emit light as the electron-hole pair is extinguished. The organic EL device is advantageous in that it can be formed on a flexible transparent substrate such as plastic, is operable with relatively low voltage (10 V or lower) as compared to plasma display panels or inorganic EL displays, consumes less power and provides excellent color. Since an organic EL device can exhibit green, blue and red colors, it is drawing a lot of attention as a full-color display device of the next generation. A process of manufacturing an organic EL device is as follows:
(1) First, an anode material is coated on a transparent substrate. Indium tin oxide (ITO) is frequently used as the anode material.
(2) Then, a hole injecting layer (HIL) is formed thereupon. The hole injecting layer is typically formed by coating copper phthalocyanine (CuPc) to a thickness of 10 to 30 nm.
(3) Then, a hole transport layer (HTL) is formed. The hole transport layer is formed by depositing 4,4'-bis[N-(1-naphthyl)-N-phenylamino]biphenyl (NPB) to a thickness of about 30 to 60 nm.
(4) An organic emitting layer is formed thereupon. If required, a dopant is added thereto. In case of green electroluminescence, an organic emitting layer is formed frequently by depositing tris(8-hydroxyquinolato)aluminum (Alq₃) to a thickness of about 30 to 60 nm. For the dopant, N-methylquinacridone (MQD) is commonly used.
(5) An electron transport layer (ETL) and an electron injection layer (EIL) are formed sequentially, or an electron injection/transport layer is formed thereupon. In case of green electroluminescence, the ETL and/or EIL may be unnecessary because Alq₃ has good electron transport ability.
(6) Then, a cathode is formed, and, finally, a protective layer is formed thereupon.

With such a structure, blue, green and red EL devices are obtained respectively depending on how the electroluminescent layer is formed. The existing green electroluminescent compounds used to create green EL devices do not have good life property or luminous efficiency.

In an organic EL device, the most important factor affecting such quality as luminous efficiency, property, etc. is the electroluminescent material. Several requirements of the electroluminescent material include high fluorescence quantum yield in solid state, high electron and hole mobility, resistance to decomposition during vacuum deposition, ability to form uniform and thin film, and good stability.

Organic electroluminescent materials may be roughly classified into high-molecular-weight materials and low-molecular-weight materials. The low-molecular-weight materials may be classified into metal complexes and metal-free pure organic electroluminescent materials, depending on molecular structure. Chelate complexes such as tris(8-quinolato)aluminum, coumarin derivatives, tetraphenylbutadiene derivatives, bisstyrylarylene derivatives, oxadiazole derivatives, or the like are known. It is reported that electroluminescence from the blue to the red region can be obtained using these materials, and the realization of full-color display devices is being expected.

### SUMMARY

The present inventors have invented an electroluminescent device comprising an organic layer interposed between an anode and a cathode on a substrate, the organic layer comprising a combination of specific compounds, in order to realize an electroluminescent device having high color purity, high luminous efficiency and long operation life.

An object of the present invention is to provide an electroluminescent device comprising an organic layer interposed between an anode and a cathode on a substrate, wherein the organic layer comprises an electroluminescent layer comprising as dopant a mixture of cis- and trans-form electroluminescent compounds with a specific proportion. Another object of the present invention is to provide an electroluminescent device further comprising one or more host compound(s) in the electroluminescent layer in addition to the dopant. Another object of the present invention is to provide an organic solar cell comprising a mixture of cis- and trans-form electroluminescent compounds with a specific proportion.

The present invention provides an electroluminescent device comprising an organic layer interposed between an anode and a cathode on a substrate, wherein the organic layer comprises an electroluminescent layer comprising one or more dopant compound(s) represented by Chemical Formula 1, and the dopant compound is a mixture of not less than 80% by weight and less than 100% by weight of the cis-form and more than 0% by weight and not more than 20% by weight of the trans-form: 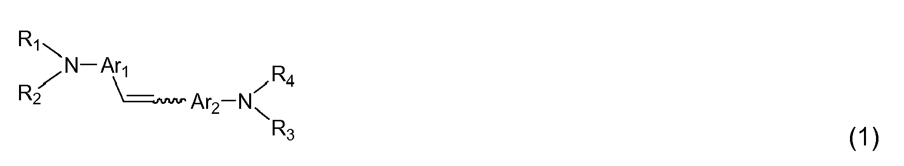 wherein
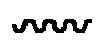 represents cis or trans configuration to the double bond;
Ar₁ and Ar₂ independently represent (C6-C60)arylene or (C5-C50)heteroarylene containing one or more heteroatom(s) selected from N, O and S;
R₁ through R₄ independently represent hydrogen, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₁ through R₄ may be linked to an adjacent substituent via (C3-C60)alkylene or (C3-C60)alkenylene with or without a fused ring to form an alicyclic ring or a monocyclic or polycyclic aromatic ring; and
the arylene or heteroarylene of Ar₁ and Ar₂, and the aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄ may be further substituted by one or more substituent(s) selected from a group consisting of deuterium, halogen, halo(C1-C60)alkyl, (C1-C60)alkyl, (C6-C60)aryl, (C3-C60)heteroaryl with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxy.

The electroluminescent layer may further comprise one or more host compound(s) represented by Chemical Formulas 2 and 3:

(Ar₁₁)ₐ-X-(Ar₁₂)_{b} (2)

(Arₗ₃)_{c}-^{y}-(Arₗ₄)_{d} (3)

wherein
X represents (C6-C60)arylene or (C4-C60)heteroarylene;
Y represents anthracenylene;
Ar11 through Ar₁₄ independently represent hydrogen, (C1-C60)alkyl, (C1-C60)alkoxy, halogen, (C4-C60)heteroaryl, (C5-C60)cycloalkyl or (C6-C60)aryl;
the alkyl, cycloalkyl, aryl or heteroaryl of Ar₁₁ through Ar₁₄ may be further substituted by one or more substituent(s) selected from a group consisting of (C6-C60)aryl or (C4-C60)heteroaryl with or without one or more substituent(s) selected from a group consisting of deuterium, (C1-C60)alkyl with or without halogen substituent, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl, (C1-C60)alkyl with or without halogen substituent, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
a, b, c and d independently represent an integer from 1 to 4.

In the present invention, "alkyl", "alkoxy" and other substituents including "alkyl" moiety may be either linear or branched.

In the present invention, "aryl" means an organic radical derived from an aromatic hydrocarbon by the removal of one hydrogen, and may include a 4- to 7-membered, particularly 5- or 6-membered, single ring or fused ring. Specific examples include phenyl, naphthyl, biphenyl, anthryl, indenyl, fluorenyl, phenanthryl, triphenylenyl, pyrenyl, perylenyl, chrysenyl, naphthacenyl, fluoranthenyl, etc., but not limited thereto.

In the present invention, "heteroaryl" means aryl group containing 1 to 4 heteroatom(s) selected from N, O and S as aromatic ring backbone atom(s), other remaining aromatic ring backbone atoms being carbon. It may be 5- or 6-membered monocyclic heteroaryl or polycyclic heteroaryl resulting from condensation with a benzene ring, and may be partially saturated. The heteroaryl includes a divalent aryl group wherein the heteroatom(s) in the ring may be oxidized or quaternized to form, for example, N-oxide or quaternary salt. Specific examples include monocyclic heteroaryl such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl, etc., polycyclic heteroaryl such as benzofuranyl, benzothiophenyl, isobenzofuranyl, benzoimidazolyl, benzothiazolyl, benzoisothiazolyl, benzoisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl, benzodioxolyl, etc., N-oxide thereof (e.g., pyridyl N-oxide, quinolyl N-oxide, etc.), quaternary salt thereof, etc., but not limited thereto.

The naphthyl includes 1-naphthyl and 2-naphthyl, the anthryl includes 1-anthryl, 2-anthryl and 9-anthryl, and the fluorenyl includes all of 1-fluorenyl, 2-fluorenyl, 3-fluorenyl, 4-fluorenyl and 9-fluorenyl.

And, in the present invention, the substituents including "(C1-C60)alkyl" moiety may have 1 to 60 carbon atoms, 1 to 20 carbon atoms, or 1 to 10 carbon atoms. The substituents including "(C6-C60)aryl" moiety may have 6 to 60 carbon atoms, 6 to 20 carbon atoms, or 6 to 12 carbon atoms. The substituents including "(C3-C60)heteroaryl" moiety may have 3 to 60 carbon atoms, 4 to 20 carbon atoms, or 4 to 12 carbon atoms. The substituents including "(C3-C60)cycloalkyl" moiety may have 3 to 60 carbon atoms, 3 to 20 carbon atoms, or 3 to 7 carbon atoms. The substituents including "(C2-C60)alkenyl or alkynyl" moiety may have 2 to 60 carbon atoms, 2 to 20 carbon atoms, or 2 to 10 carbon atoms.

The electroluminescent device according to the present invention exhibits an effective energy transfer mechanism between a host and a dopant and, therefore, may provide good, high-efficiency EL characteristics through improved electron density distribution. Further, it can overcome the problems associated with the existing materials, i.e., decrease of initial efficiency, short operation life, etc., and can provide high-performance EL characteristics with high efficiency and long operation life for individual colors.

The dopant compound represented by Chemical Formula 1 is mixture of cis-form and trans-form, comprising not less than 80% by weight and less than 100% by weight of the cis-form (80% by weight cis content < 100% by weight) and more than 0% by weight and not more than 20% by weight of the trans-form (0% by weight < trans content ≦ 20% by weight).

In the dopant compound represented by Chemical Formula 1, Ar₁ and Ar₂ are independently selected from the following structures, but not limited thereto: 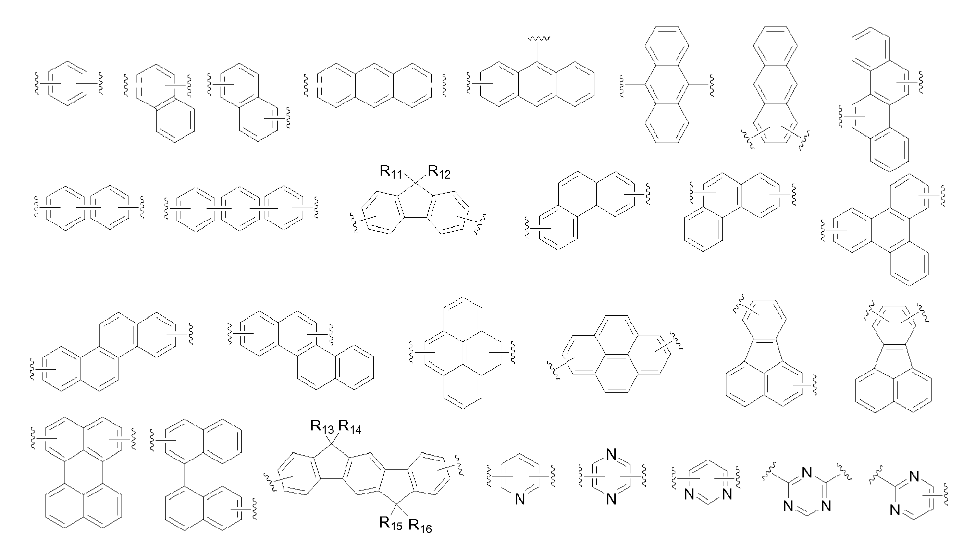 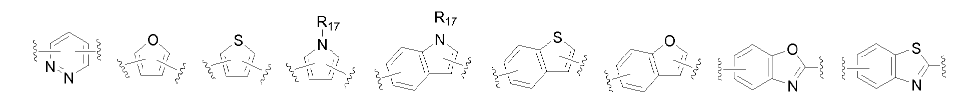 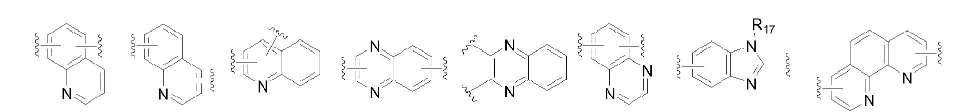 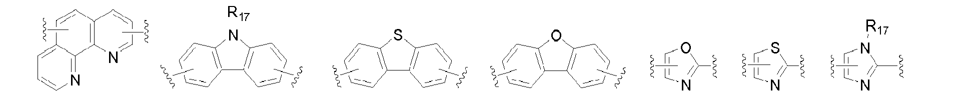 wherein
R₁₁ through R₁₇ independently represent hydrogen, deuterium, halogen, halo(C1-C60)alkyl, (C1-C60)alkyl, (C6-C60)aryl, (C3-C60)heteroaryl with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy.

And, in the dopant compound represented by Chemical Formula 1, R₁ through R₄ independently represent hydrogen, halogen, (C1-C60)alkyl, halo(C1-C60)alkyl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, cyano, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₁ through R₄ may be linked to an adjacent substituent via (C3-C60)alkylene or (C3-C60)alkenylene with or without a fused ring to form an alicyclic ring or a monocyclic or polycyclic aromatic ring. R₁ through R₄ are independently selected from the following structures, but not limited thereto: 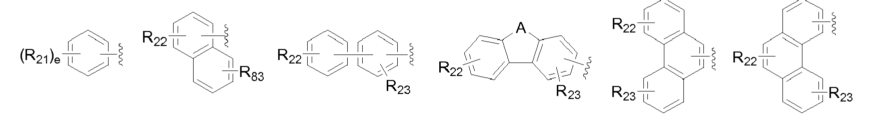 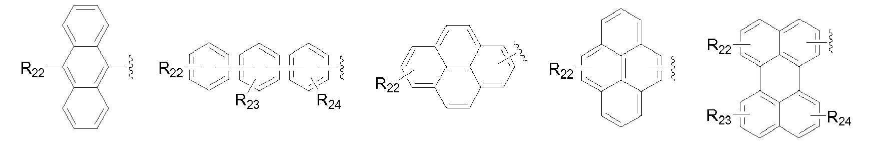 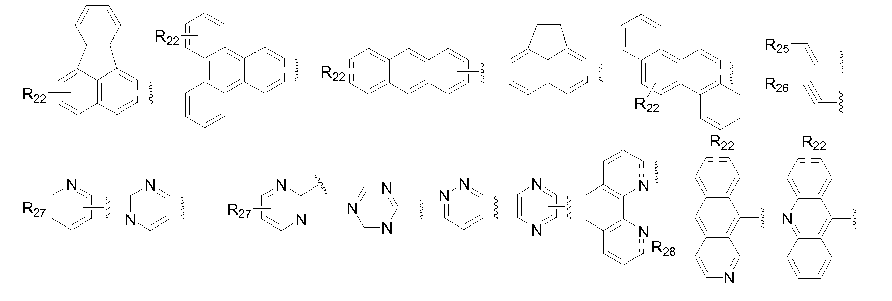 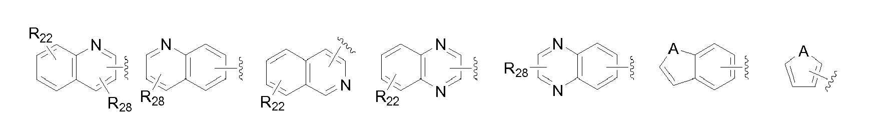 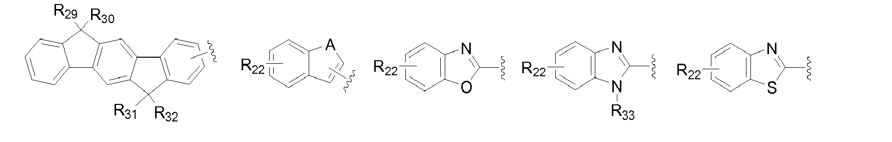 wherein
R₂₁ through R₃₃ independently represent hydrogen, deuterium, halogen, (C1-C60)alkyl, halo(C1-C60)alkyl, (C6-C60)aryl, (C3-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy;
A represents CR₃₄R₃₅, NR₃₅, S or O;
R₃₄ through R₃₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or R₃₄ and R₃₅ may be linked via (C3-C60)alkylene or (C3-C60)alkenylene with or without a fused ring to form an alicyclic ring or a monocyclic or polycyclic aromatic ring; and
e represents an integer from 1 to 5.

Specifically, in the dopant compound represented by Chemical Formula 1, Ar₁ and Ar₂ independently represent 1,2-phenylene, 1,3-phenylene, 1,4-phenylene, 9,9-dimethyl-1,2-fluorenylene, 9,9-dimethyl-1,3-fluorenylene, 9,9-dimethyl-1,4-fluorenylene, 9,9-dimethyl-1,5-fluorenylene, 9,9-dimethyl-1,6-fluorenylene, 9,9-dimethyl-1,7-fluorenylene, 9,9-dimethyl-1,8-fluorenylene, 9,9-dimethyl-2,3-fluorenylene, 9,9-dimethyl-2,4-fluorenylene, 9,9-dimethyl-2,5-fluorenylene, 9,9-dimethyl-2,6-fluorenylene, 9,9-dimethyl-2,7-fluorenylene, 9,9-dimethyl-3,4-fluorenylene, 9,9-dimethyl-3,5-fluorenylene, 9,9-dimethyl-3,6-fluorenylene, 9,9-dimethyl-4,5-fluorenylene, 4,2`-biphenylene, 4,3'-biphenylene or 4,4'-biphenylene; and R₁ through R₄ independently represent hydrogen, deuterium, fluoro, chloro, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, benzyl, trifluoromethyl, perfluoroethyl, trifluoroethyl, perfluoropropyl, perfluorobutyl, morpholinyl, thiomorpholinyl, cyclopropyl, cyclobutyl, cyclopentyl, cyclohexyl, cycloheptyl, cyclooctyl, cyclononyl, cyclodecyl, trimethylsilyl, triethylsilyl, tripropylsilyl, tri(t-butyl)silyl, t-butyldimethylsilyl, dimethylphenylsilyl, triphenylsilyl, dimethylamino, diphenylamino, adamantyl, cyano, ethenyl, phenylethenyl, ethynyl, phenylethynyl, methoxy, ethoxy, n-propoxy, i-propoxy, n-butoxy, i-butoxy, t-butoxy, n-pentoxy, i-pentoxy, n-hexyloxy, n-heptoxy, methylthio, phenyloxy, phenylthio, methoxycarbonyl, ethoxycarbonyl, t-butoxycarbonyl, methylcarbonyl, ethylcarbonyl, benzylcarbonyl, phenylcarbonyl, carboxyl, nitro or hydroxy, or they are selected from the following structures:

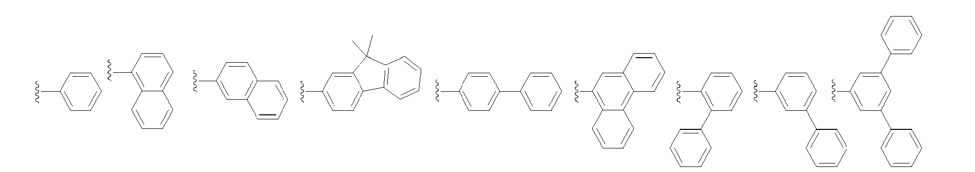

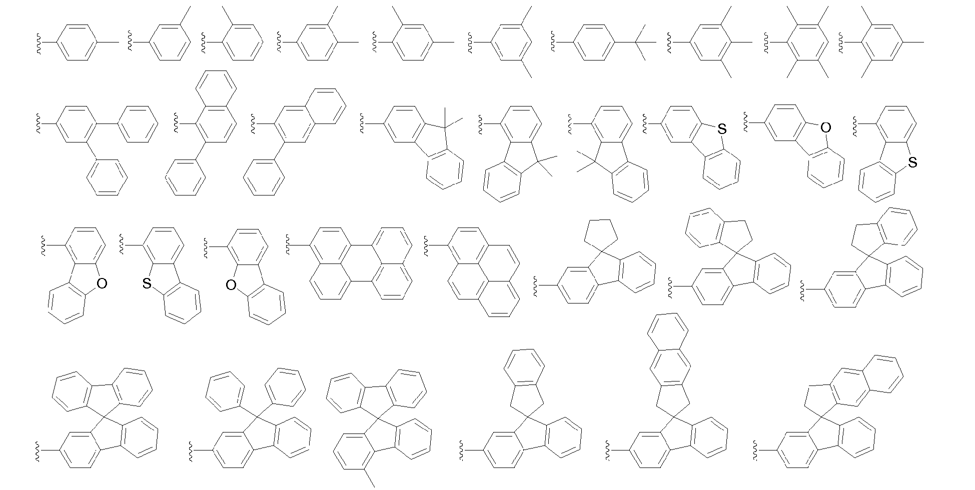

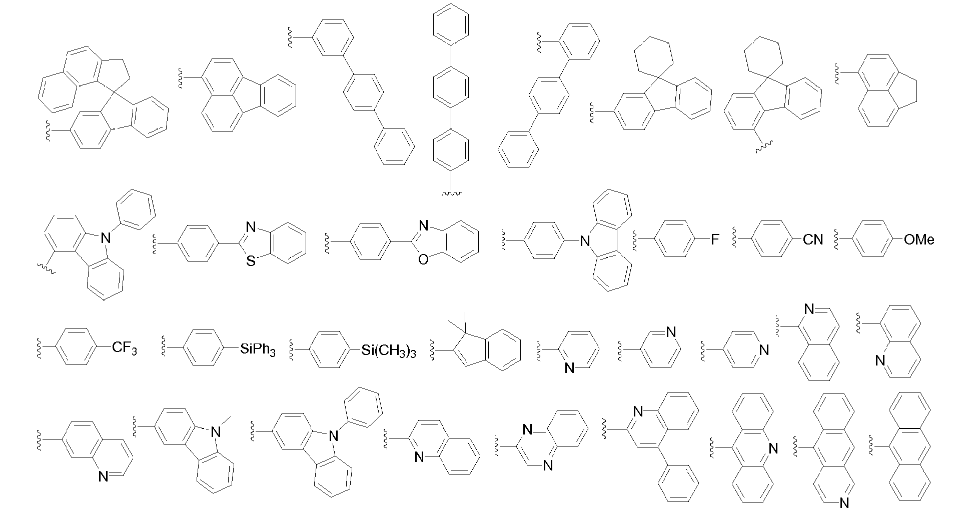

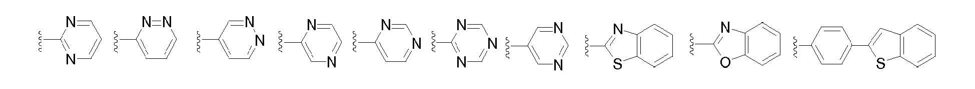

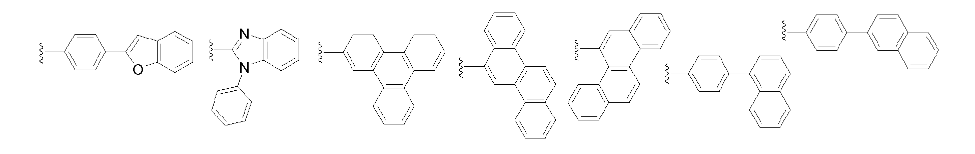

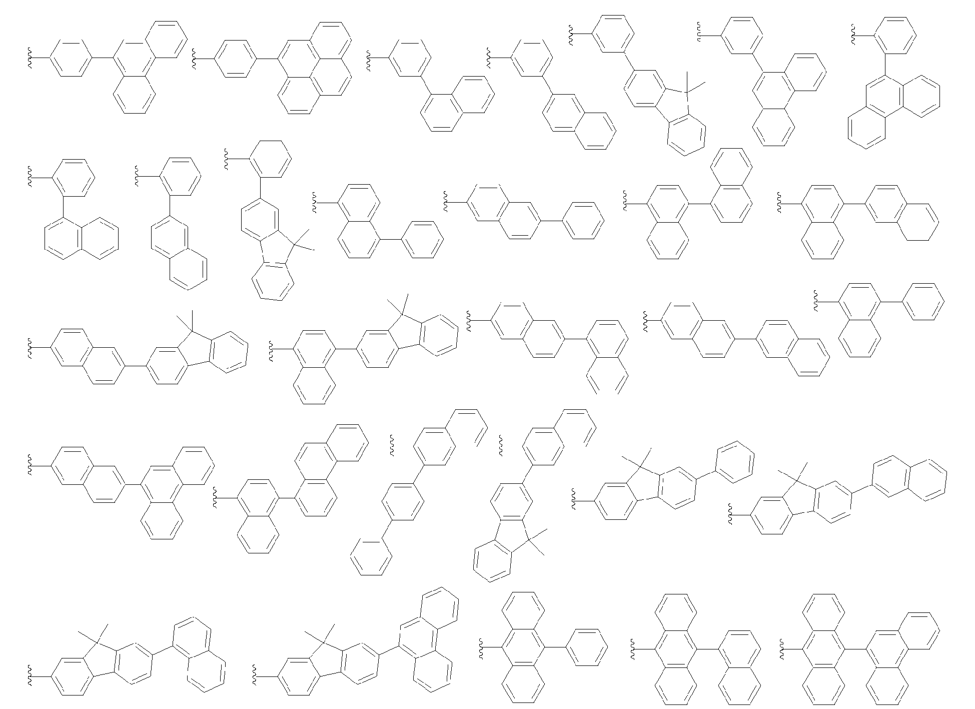

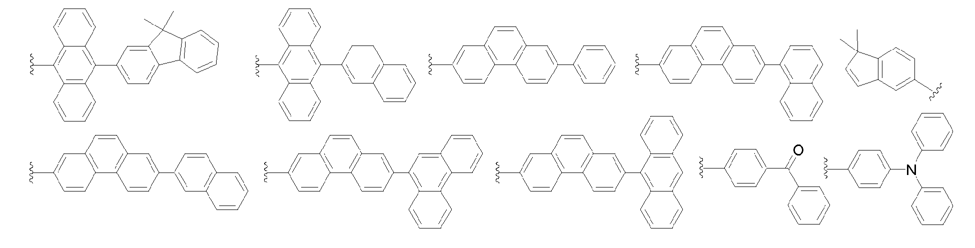

Specifically, the dopant compound represented by Chemical Formula 1 may be exemplified by the following compounds, but not limited thereto:

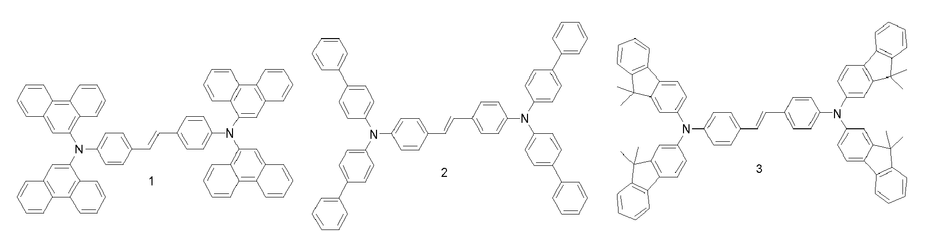

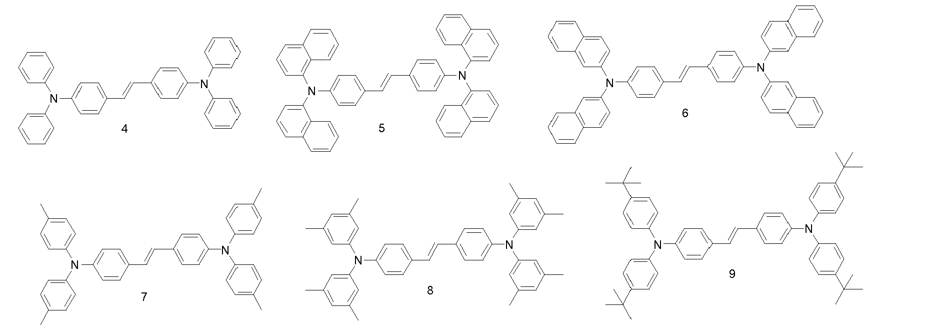

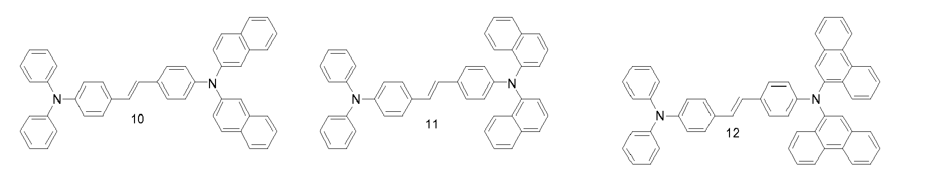

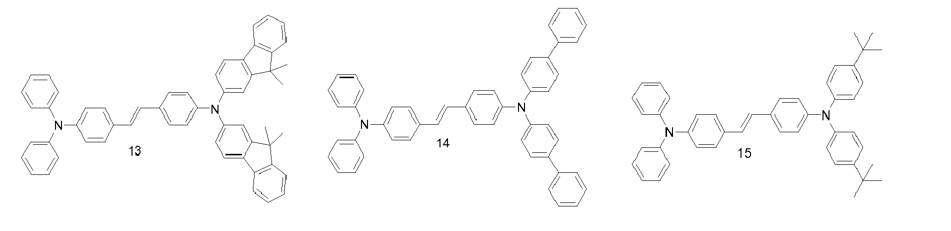

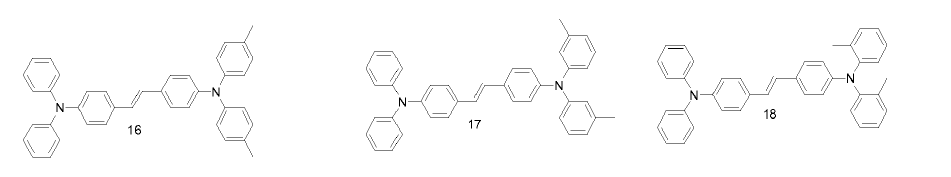

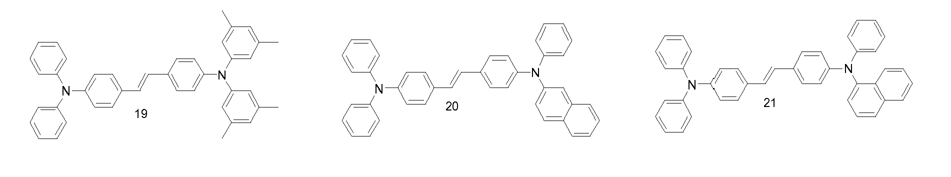

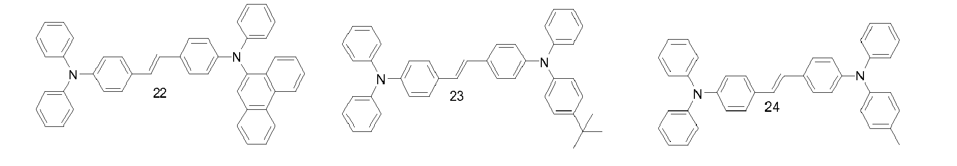

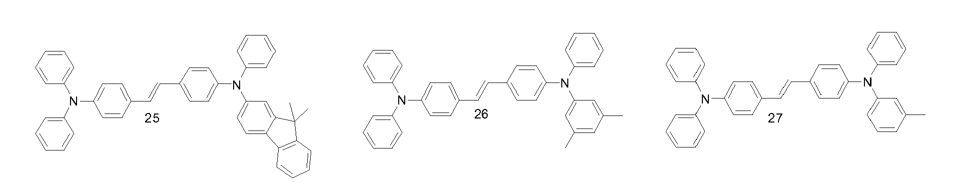

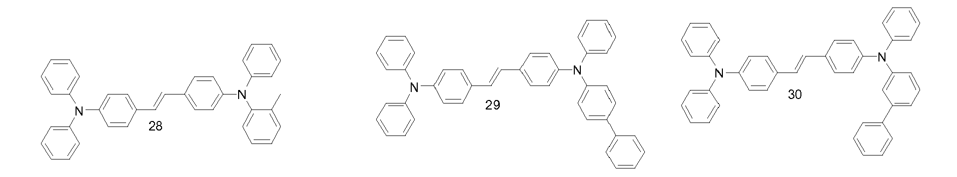

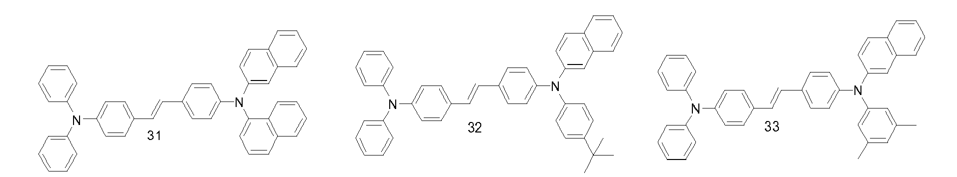

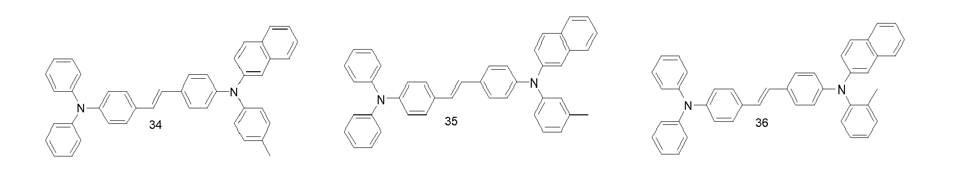

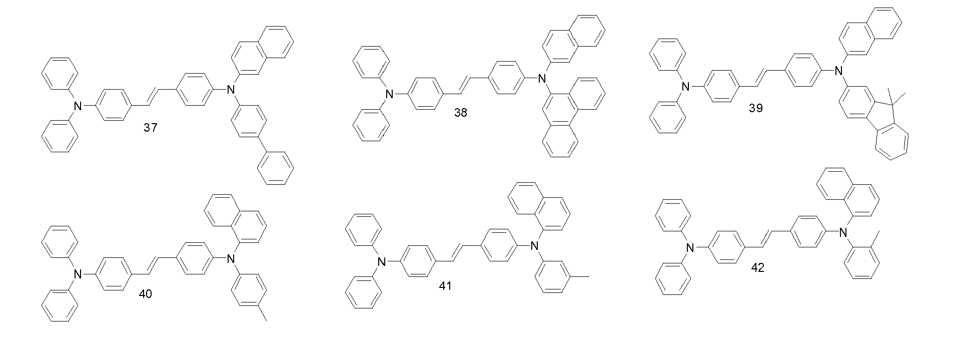

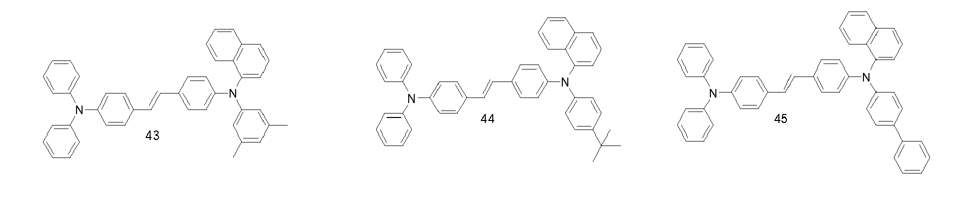

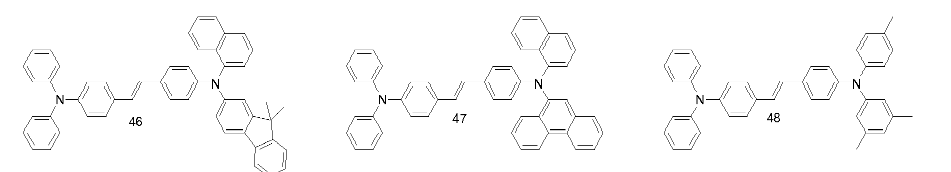

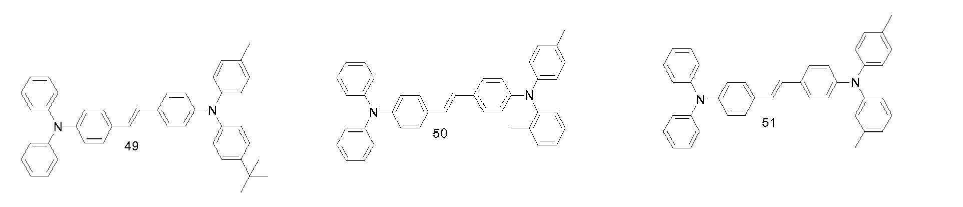

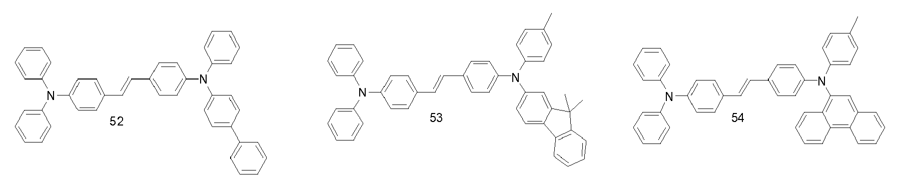

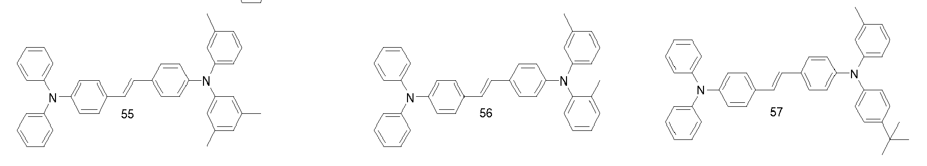

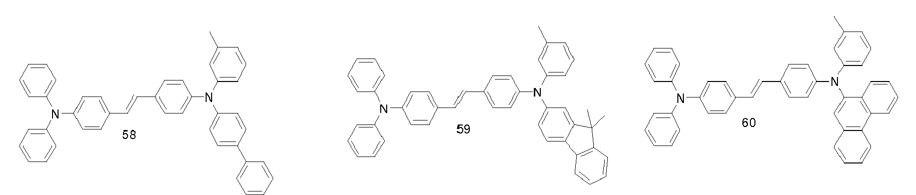

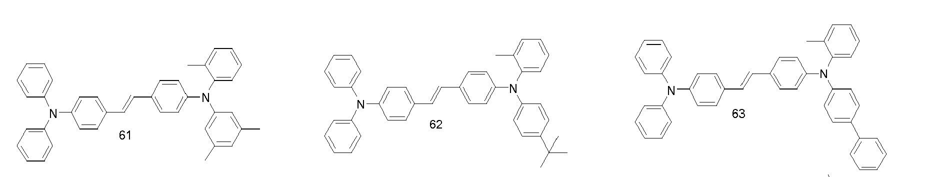

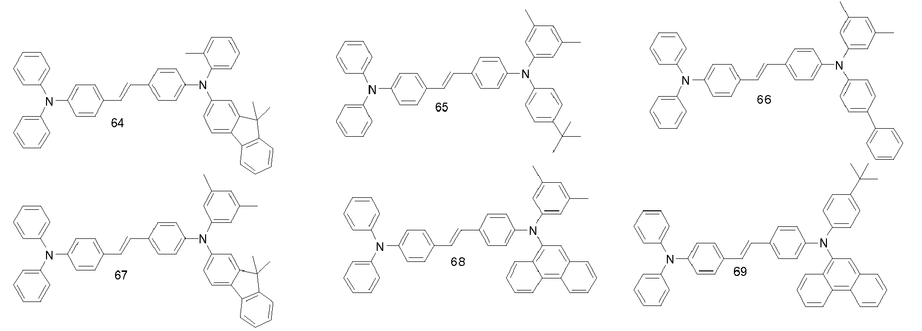

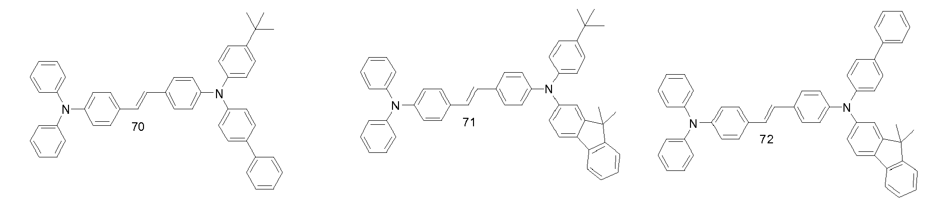

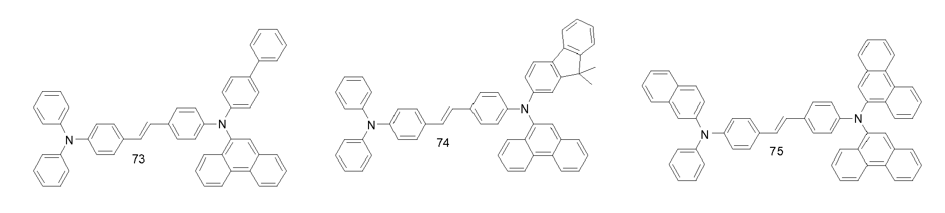

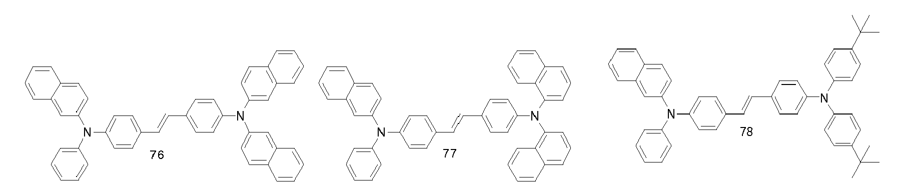

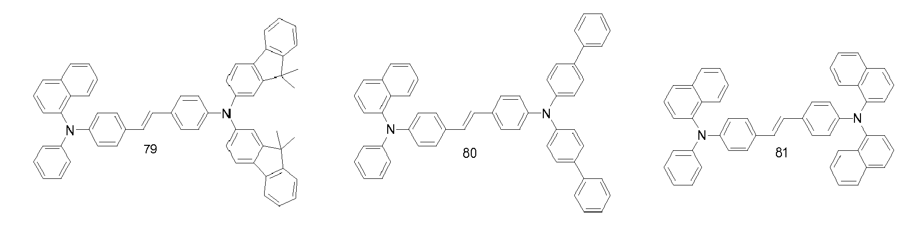

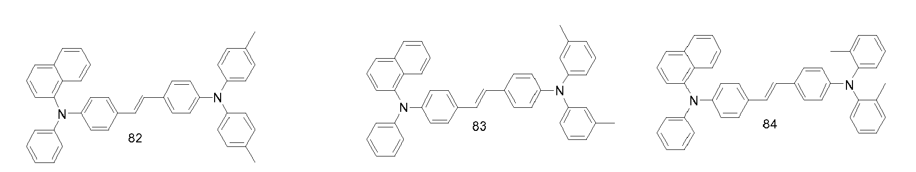

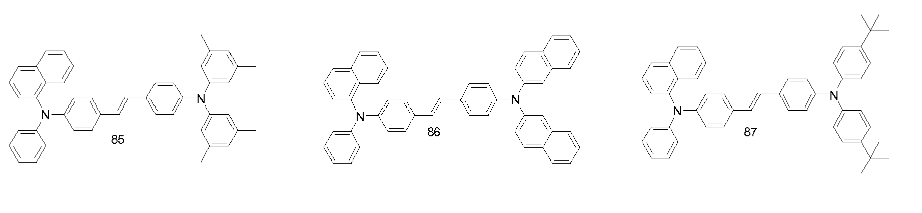

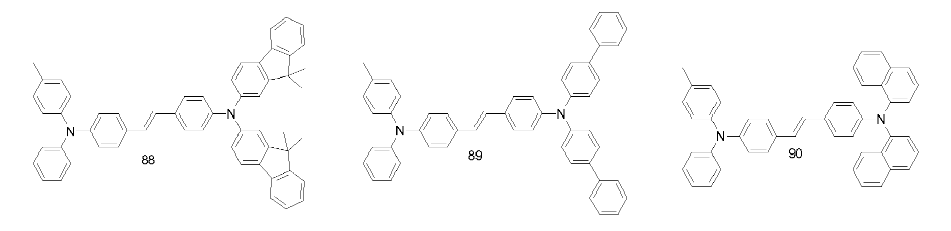

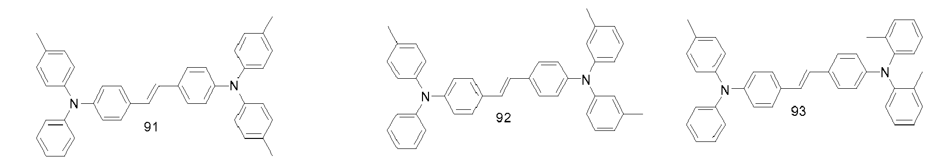

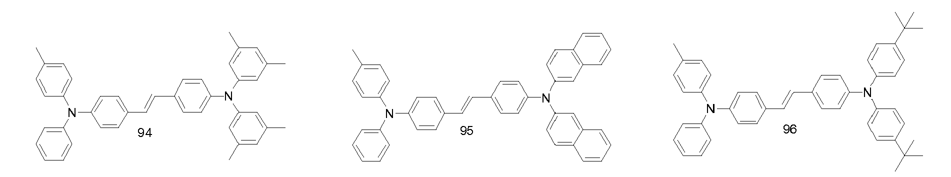

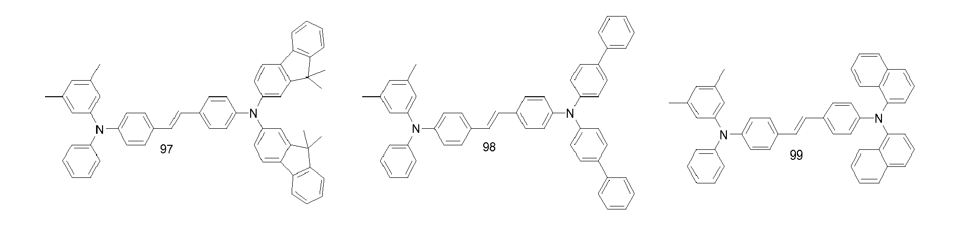

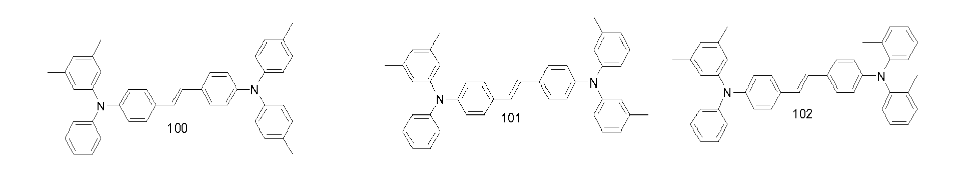

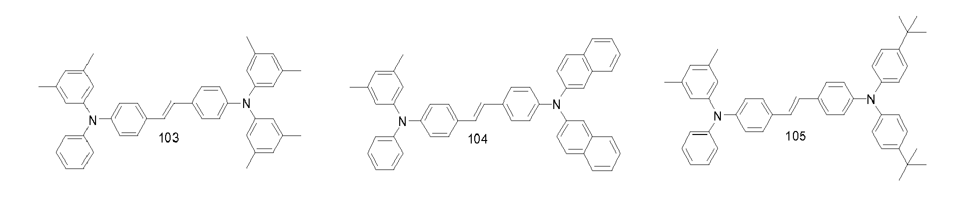

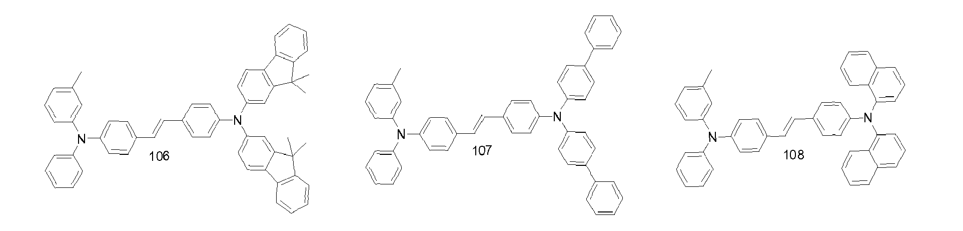

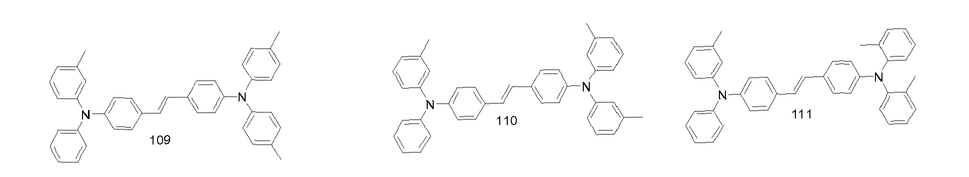

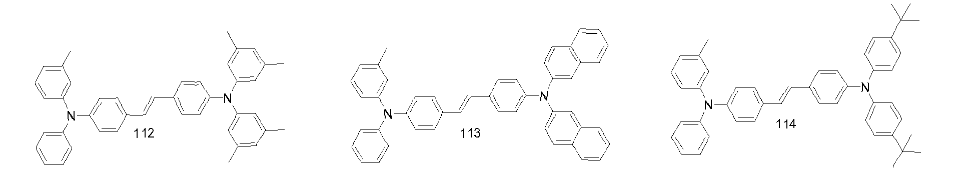

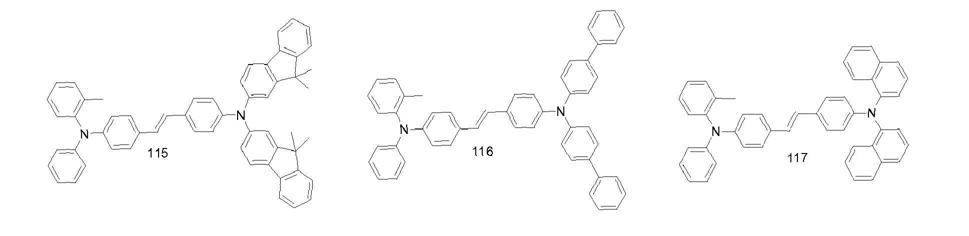

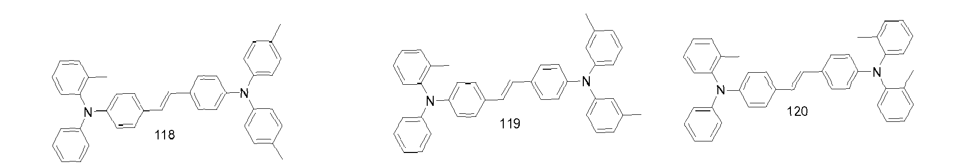

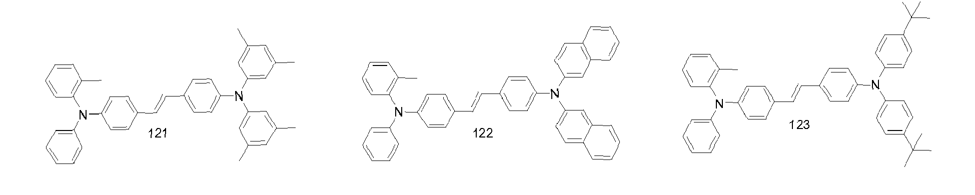

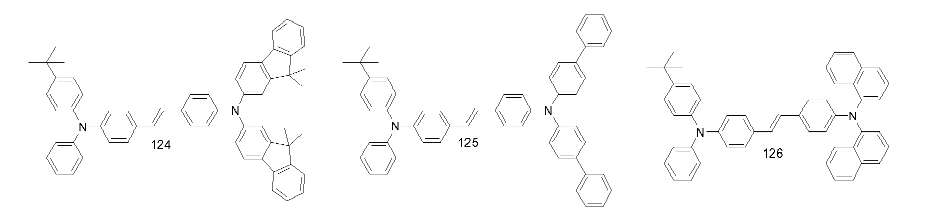

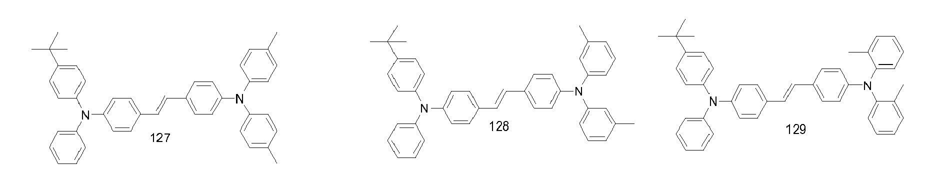

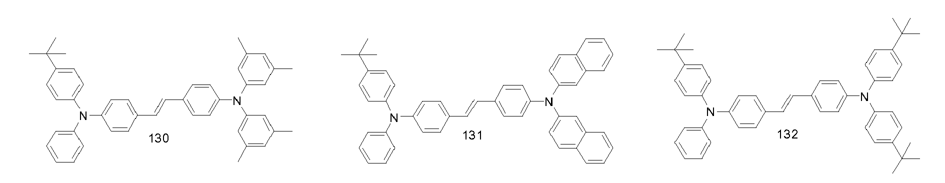

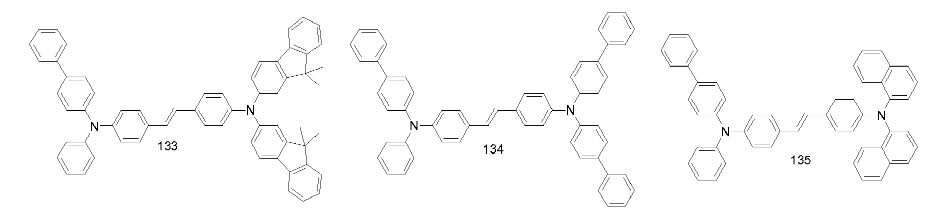

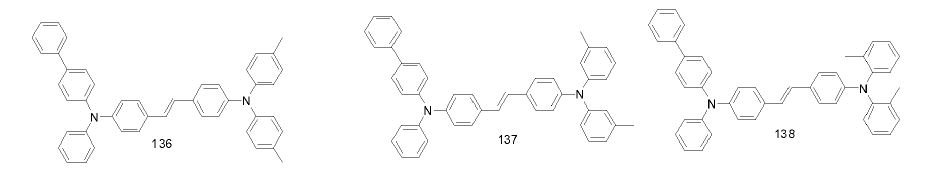

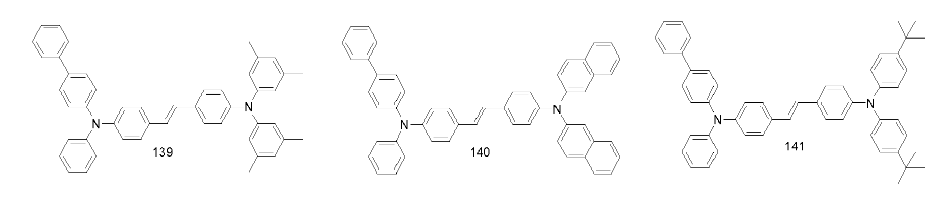

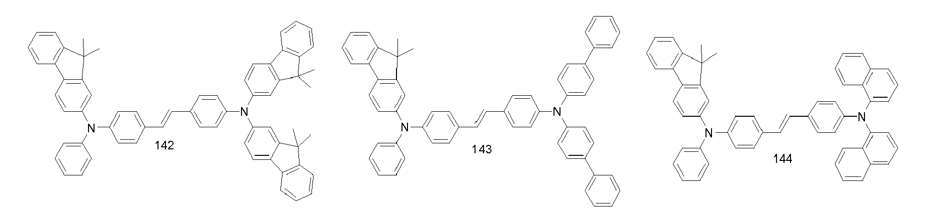

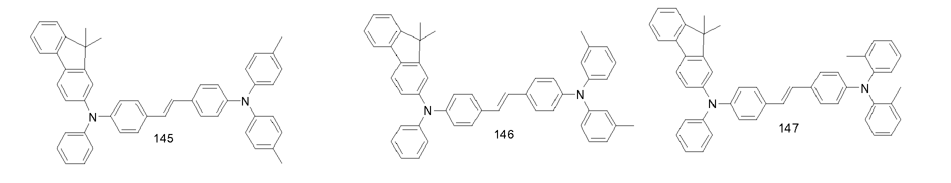

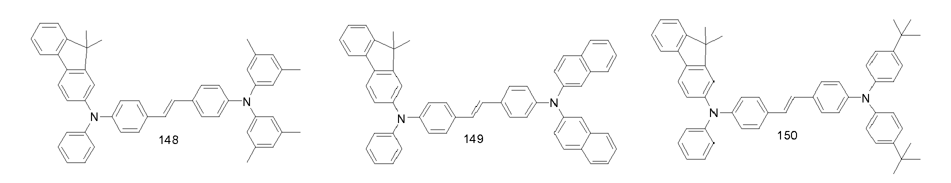

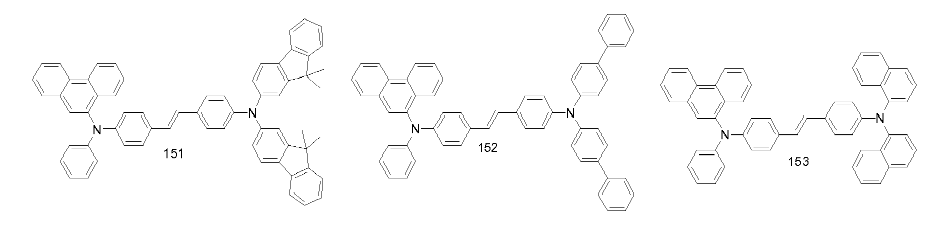

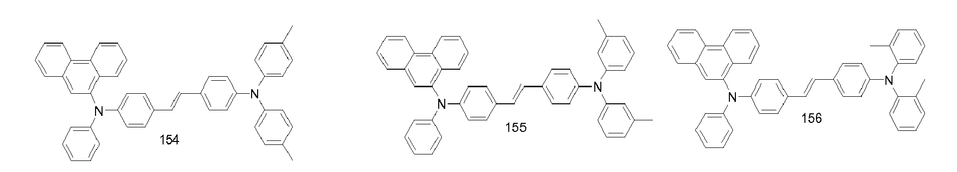

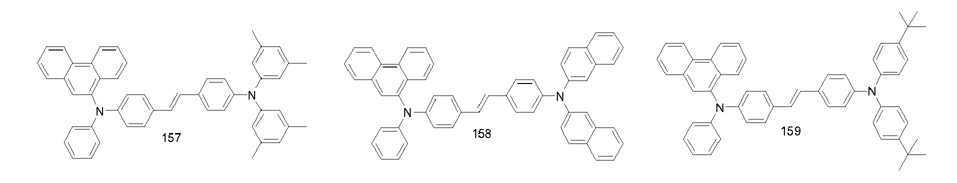

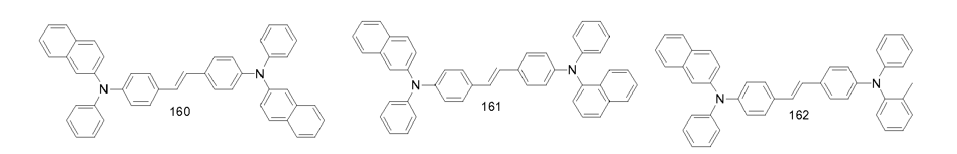

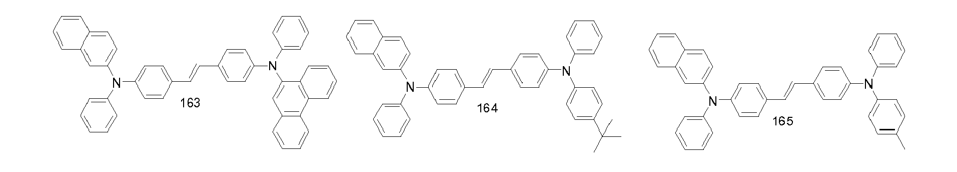

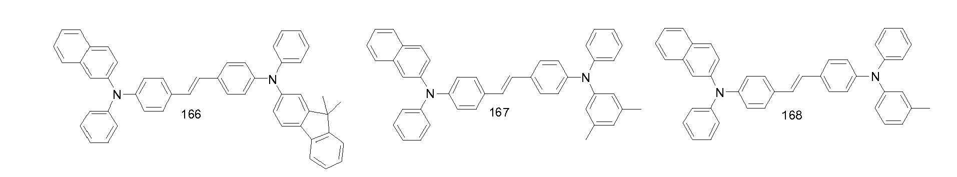

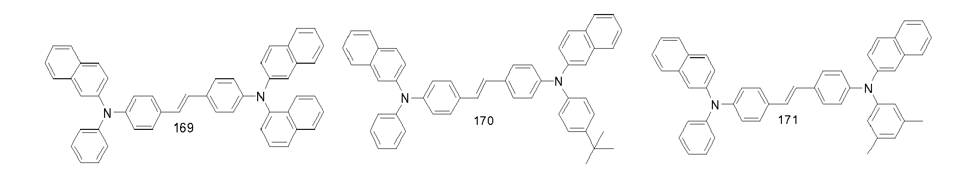

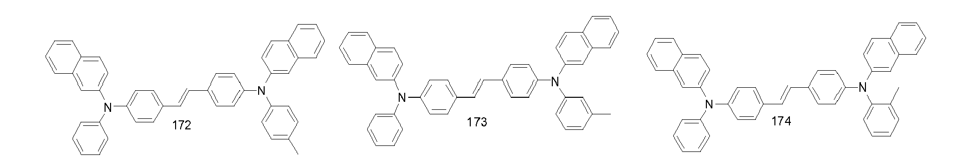

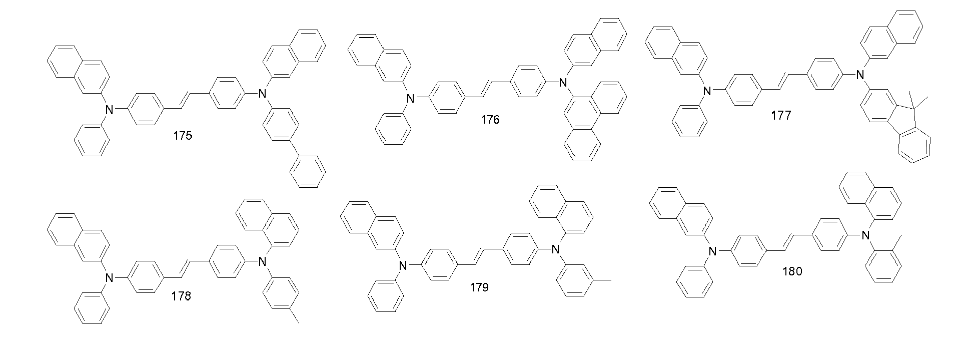

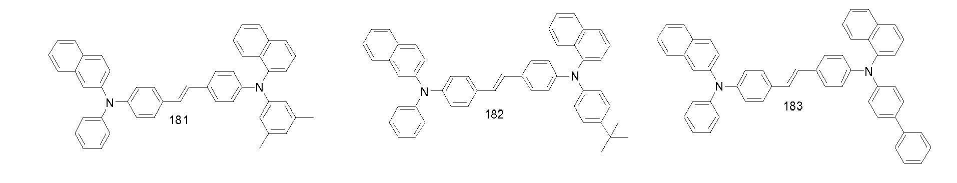

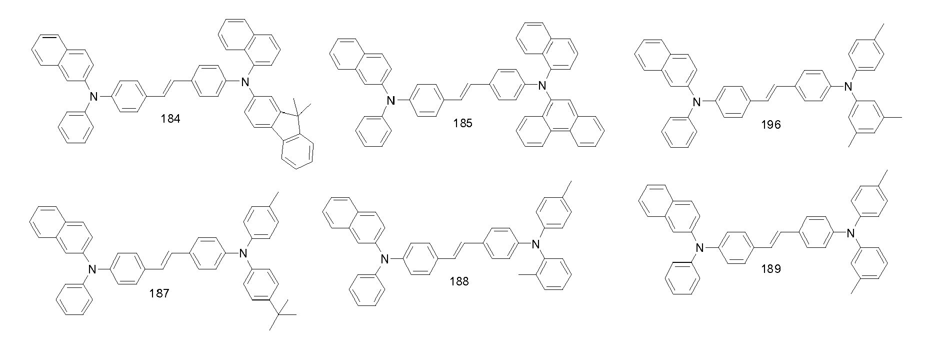

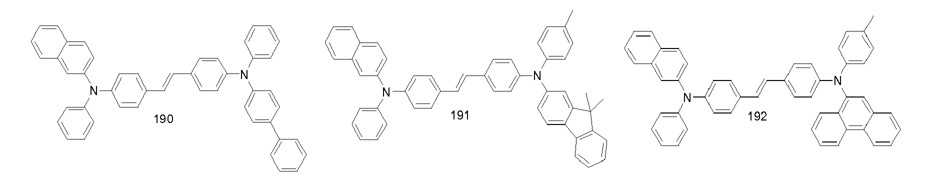

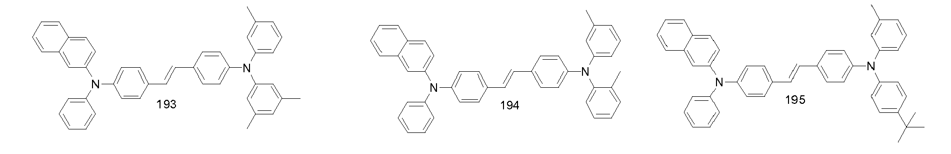

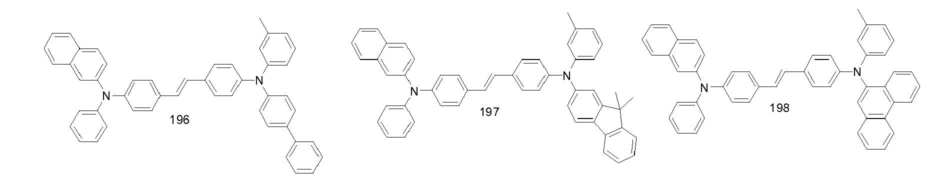

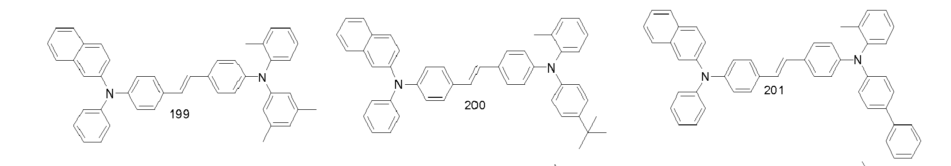

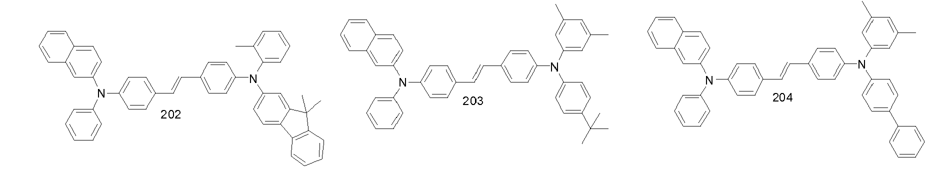

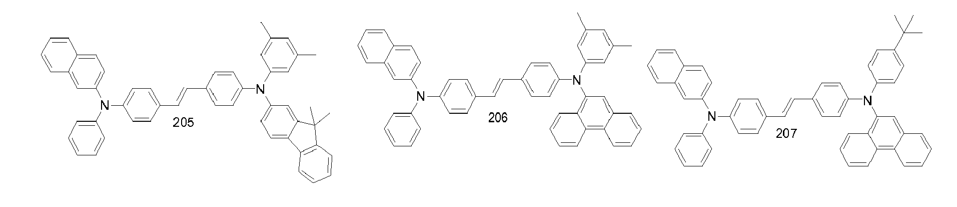

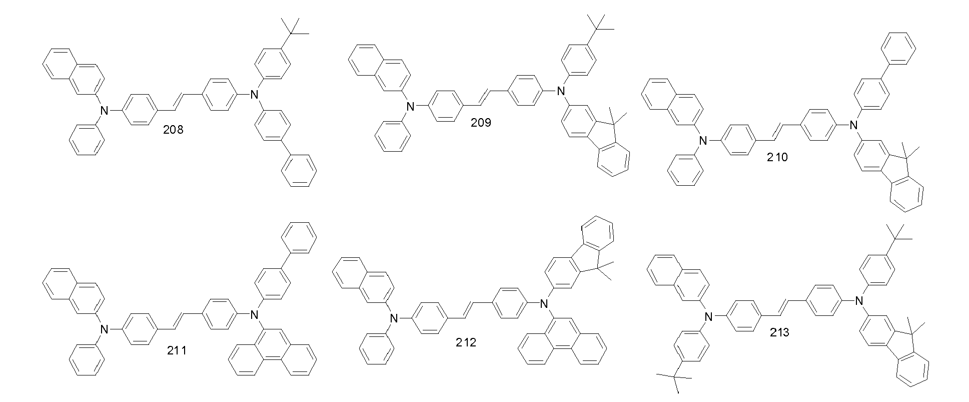

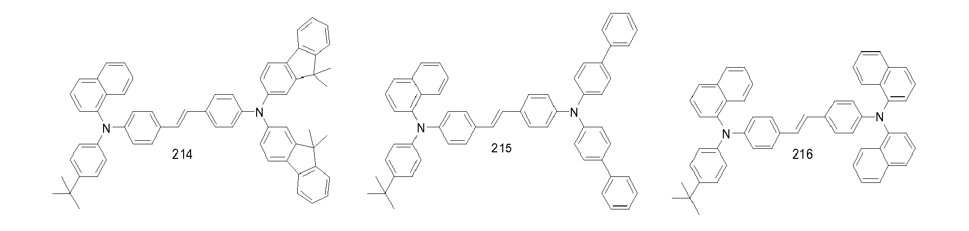

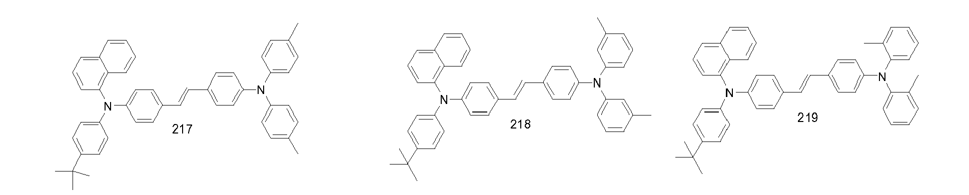

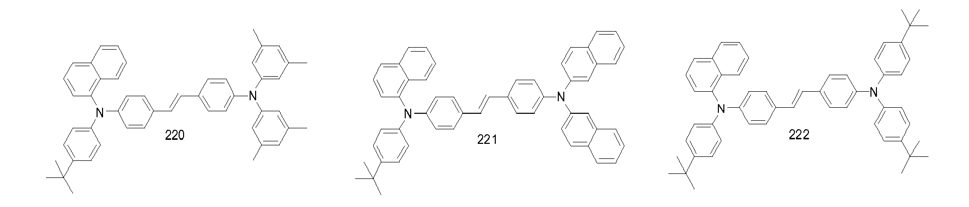

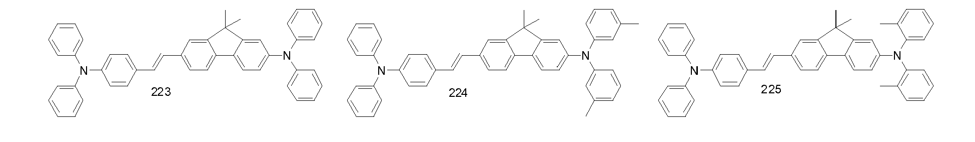

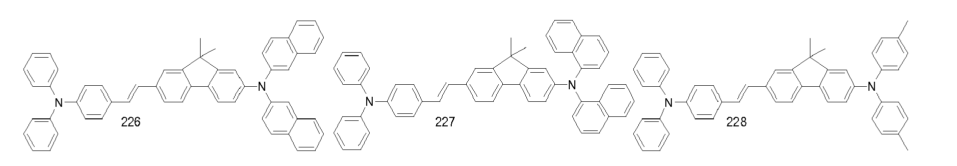

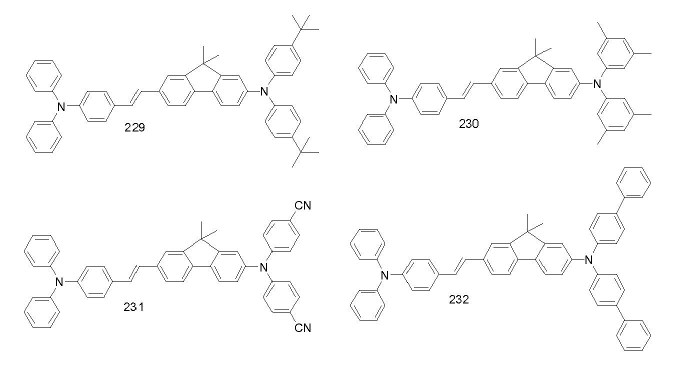

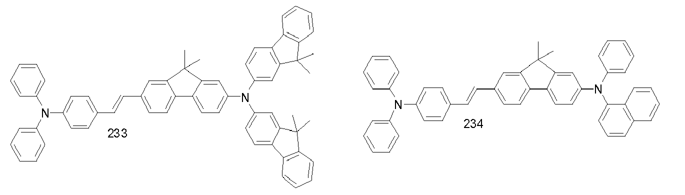

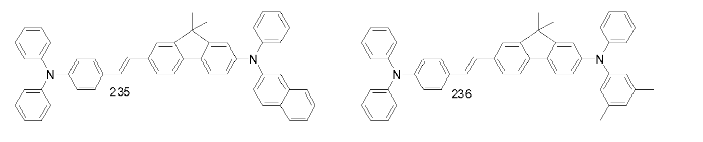

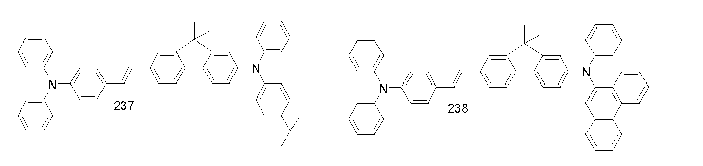

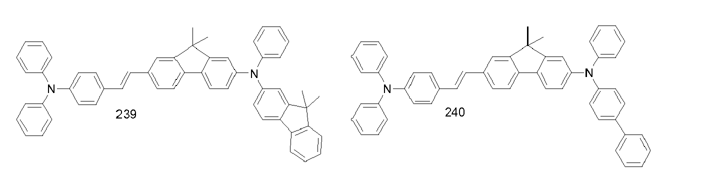

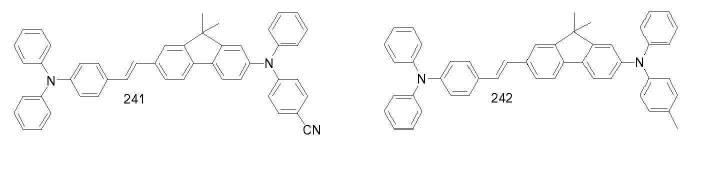

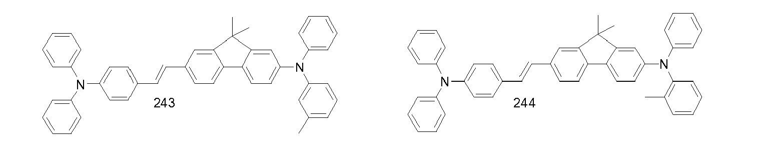

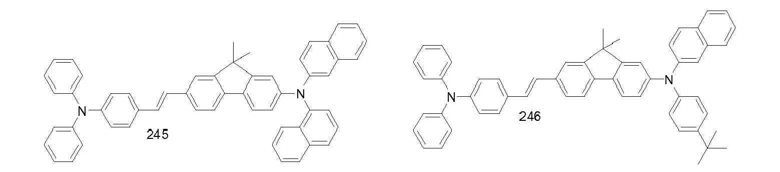

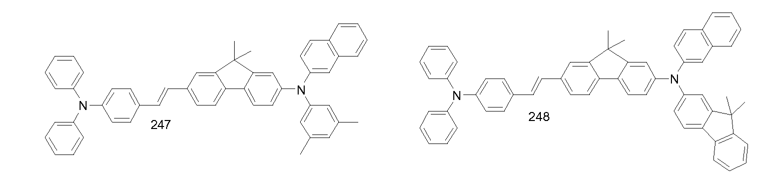

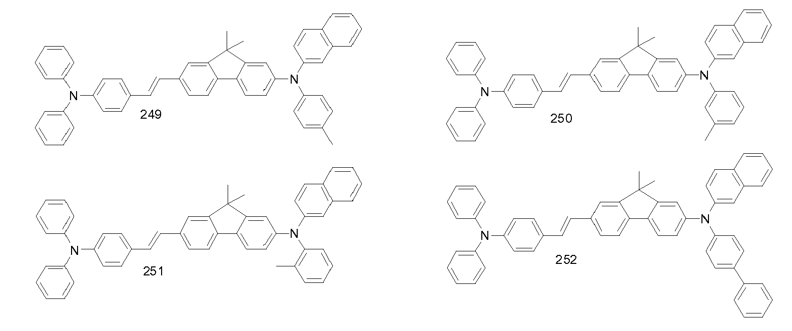

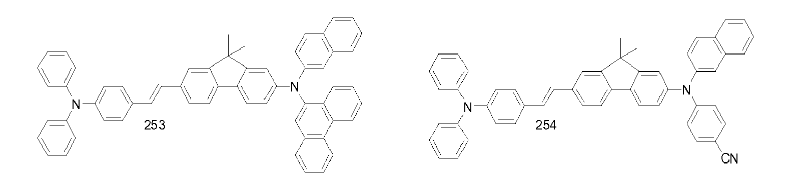

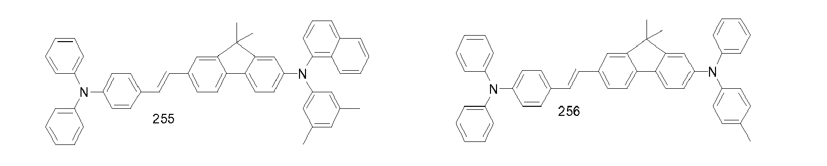

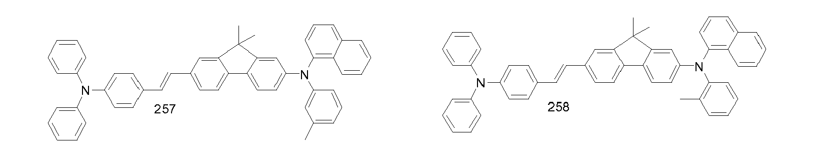

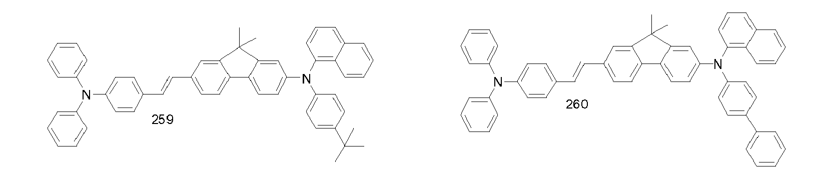

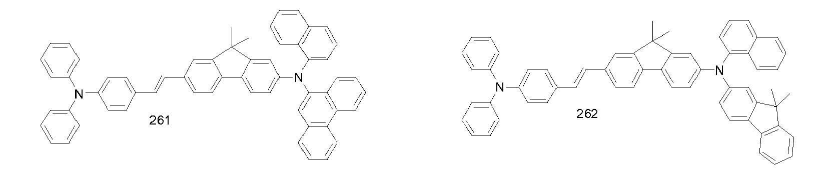

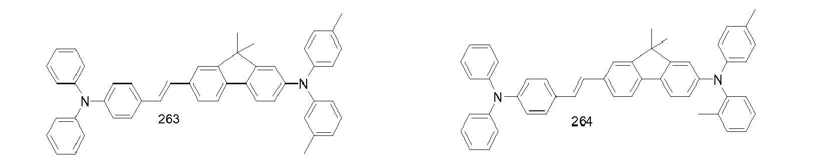

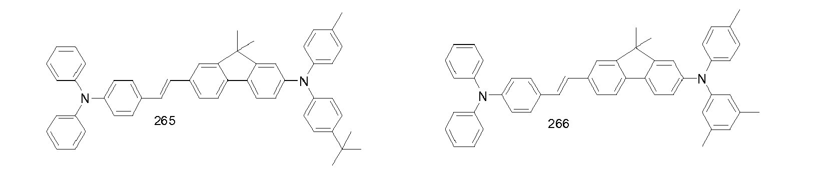

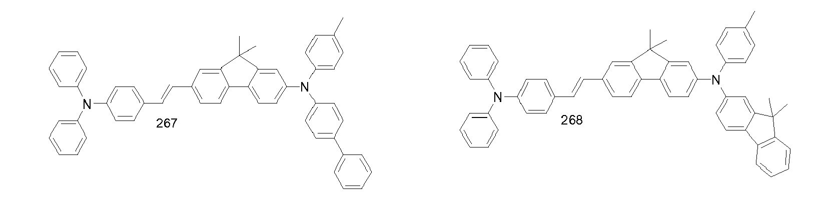

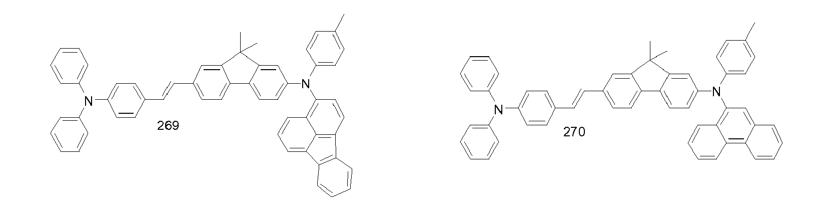

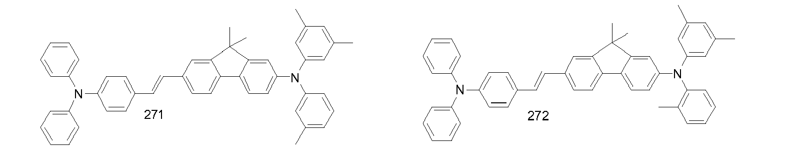

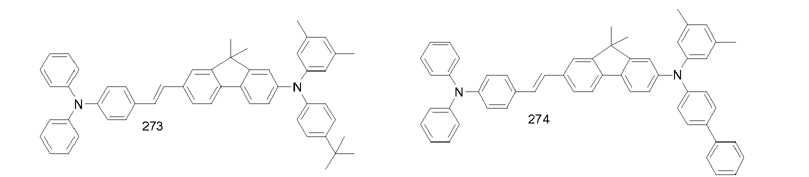

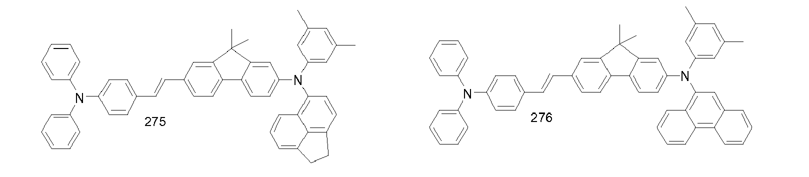

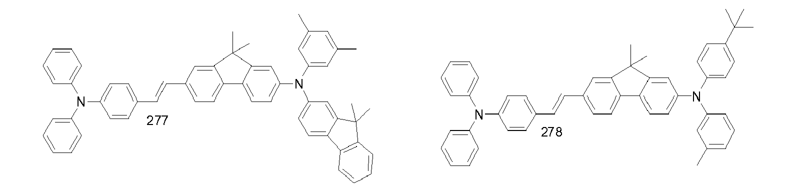

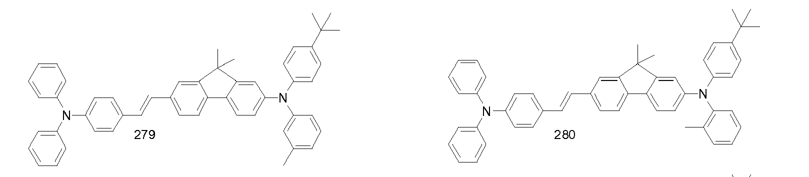

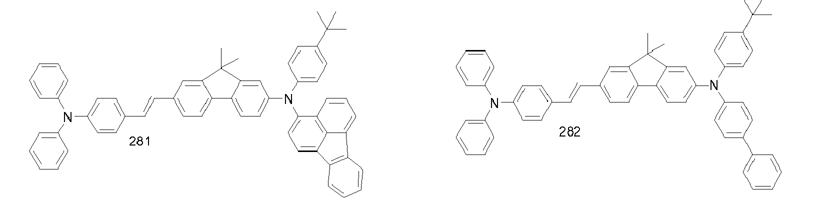

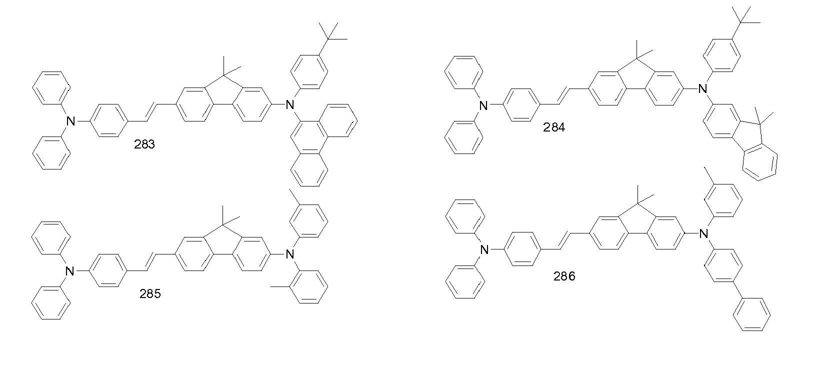

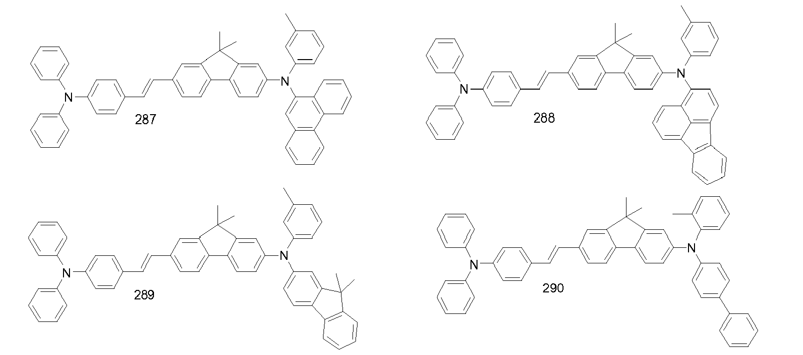

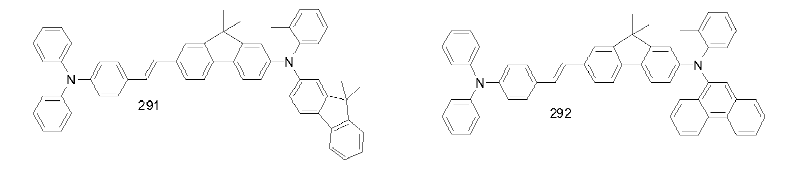

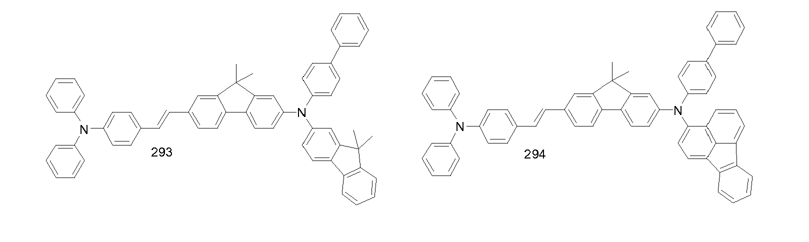

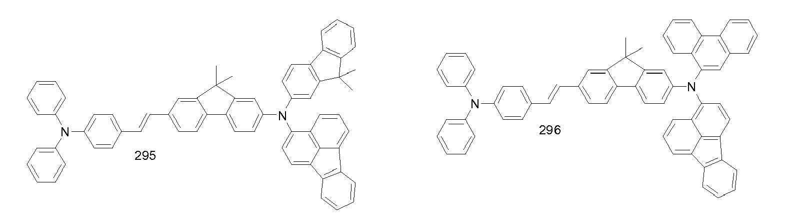

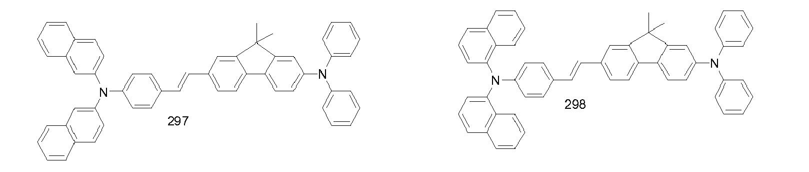

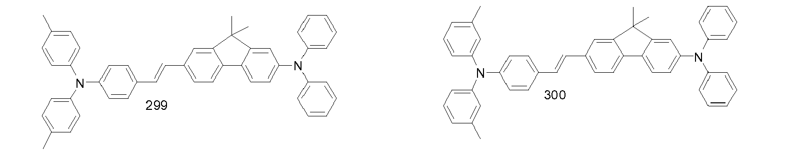

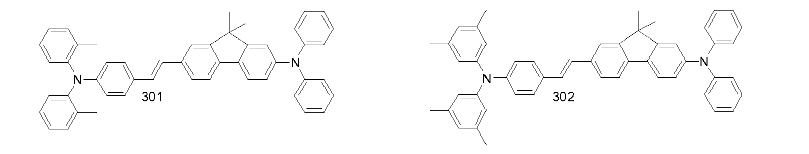

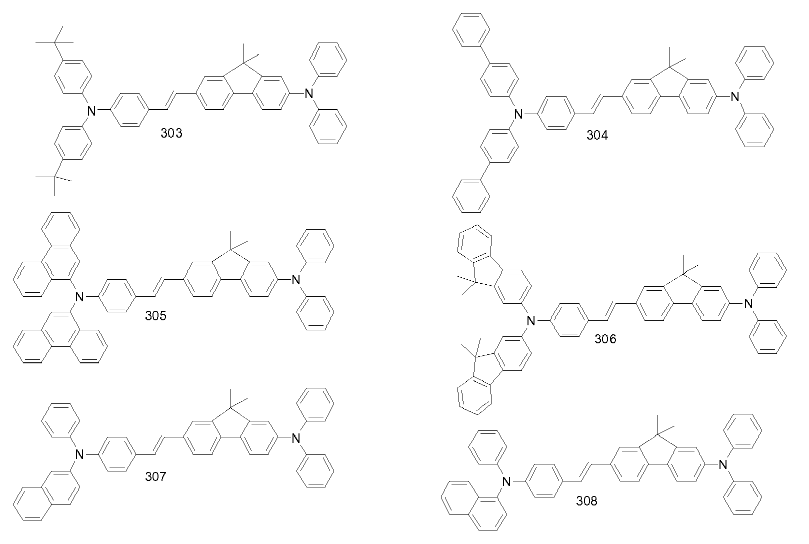

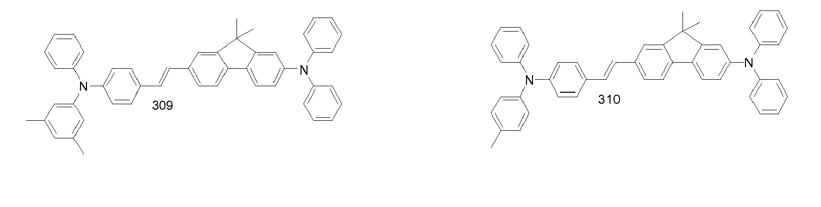

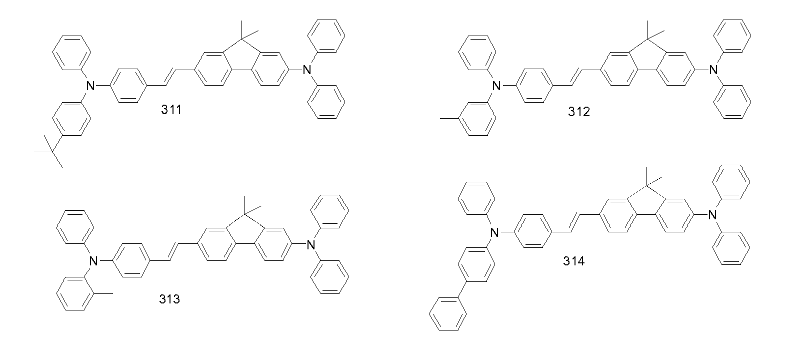

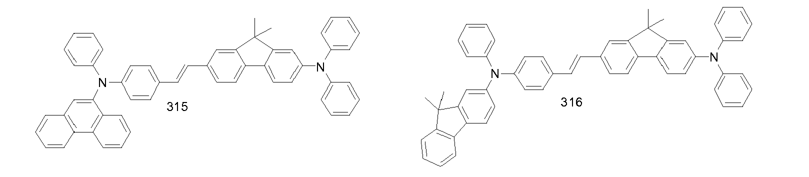

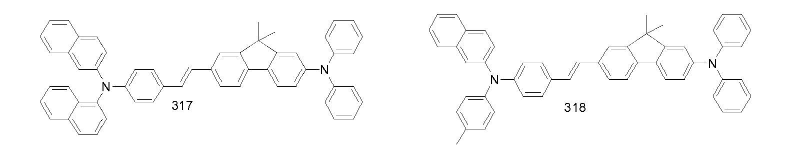

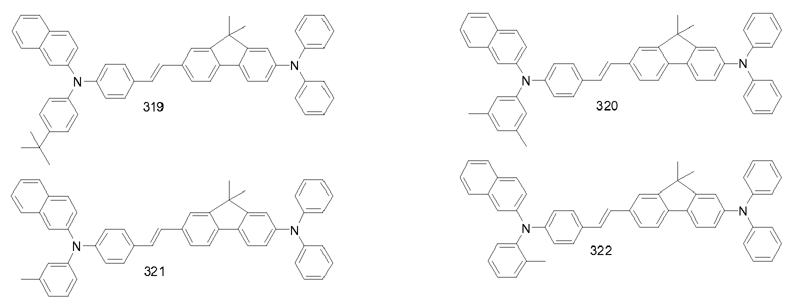

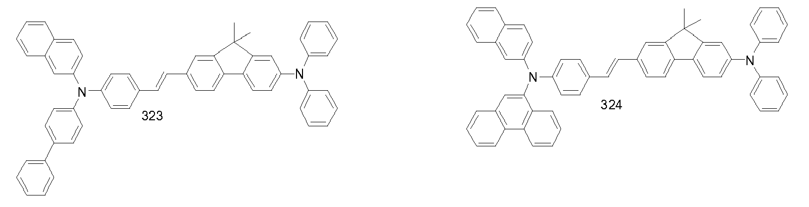

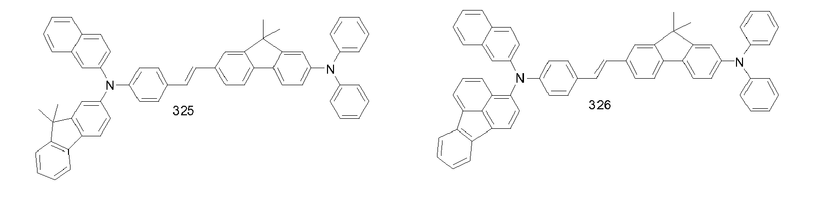

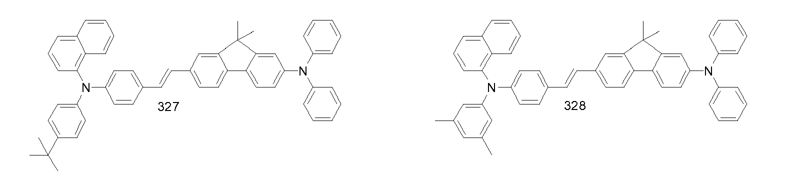

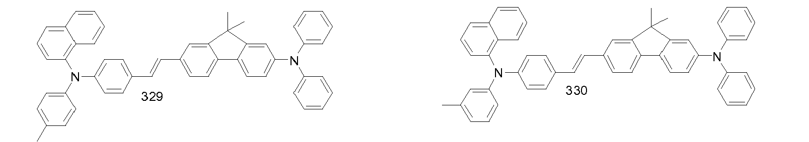

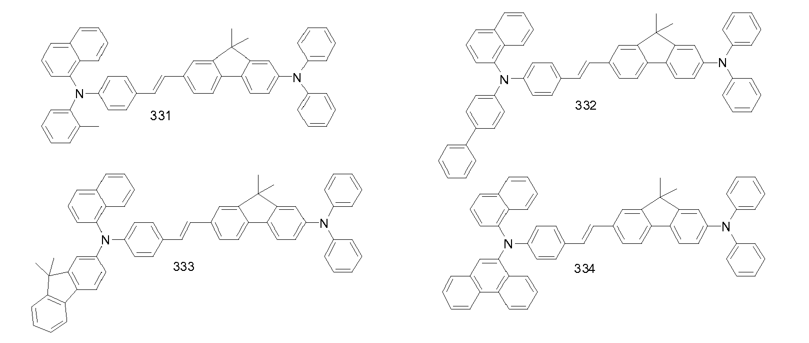

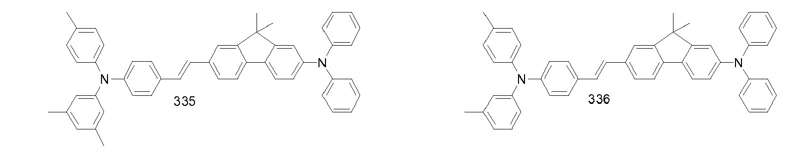

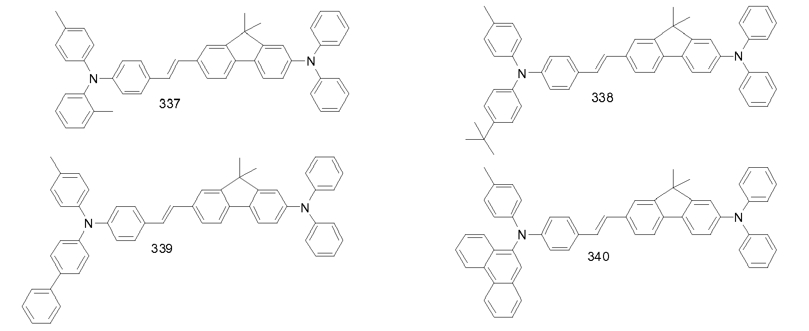

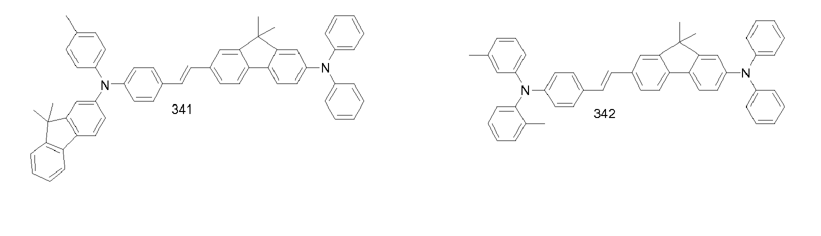

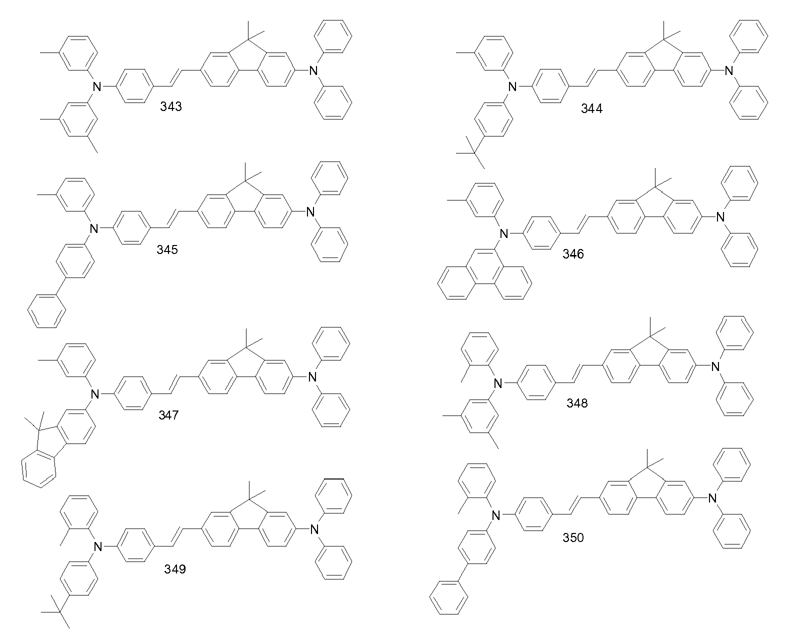

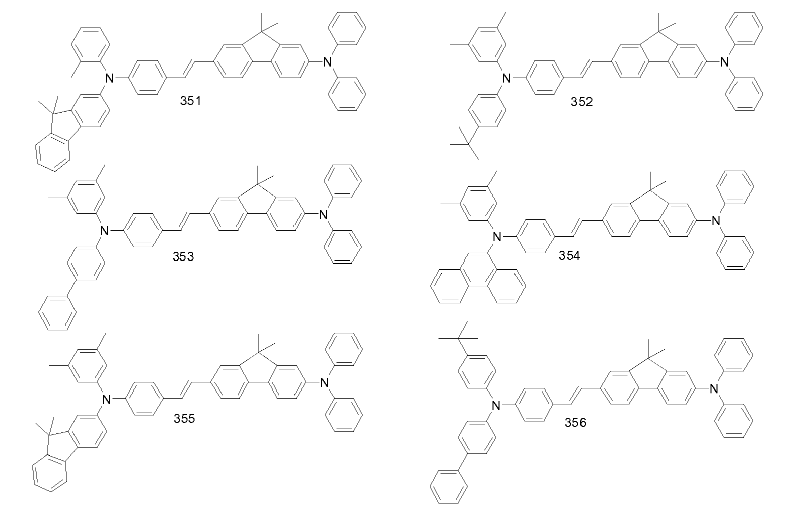

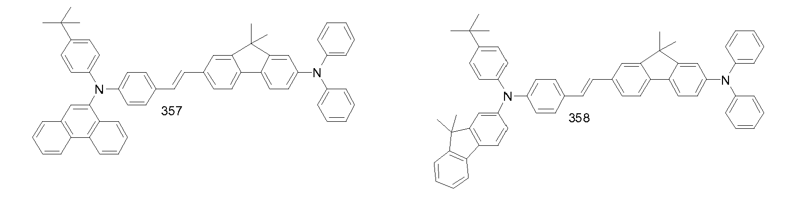

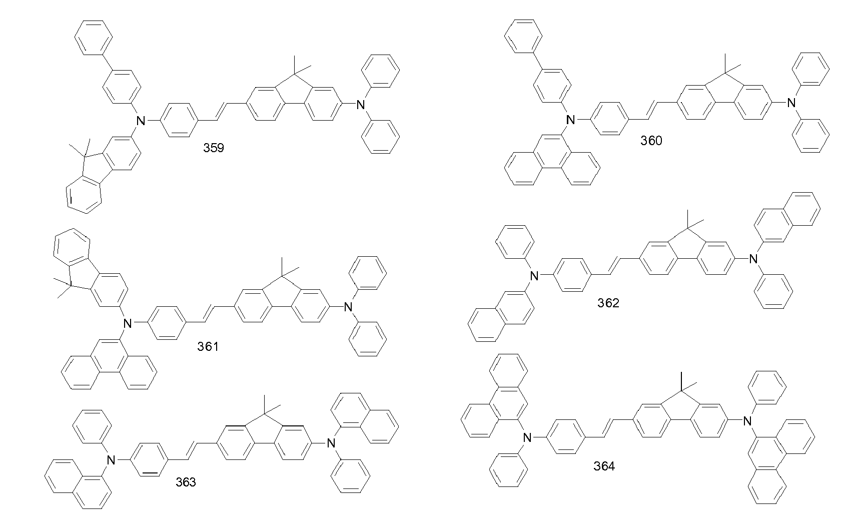

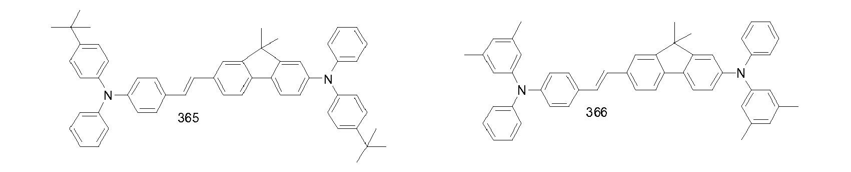

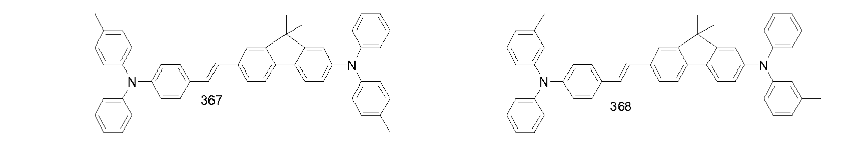

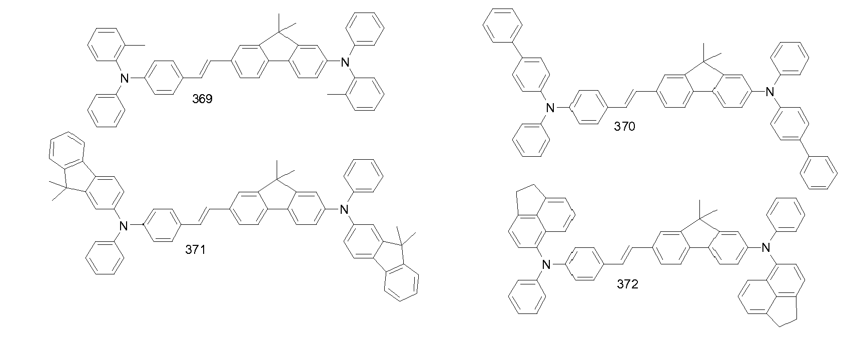

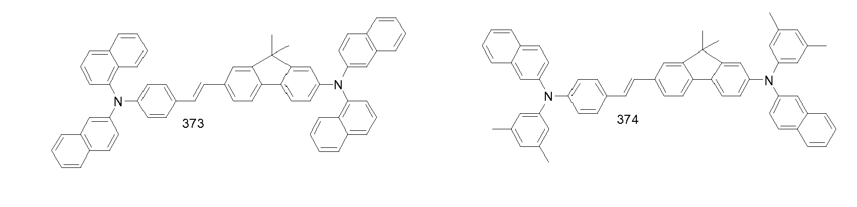

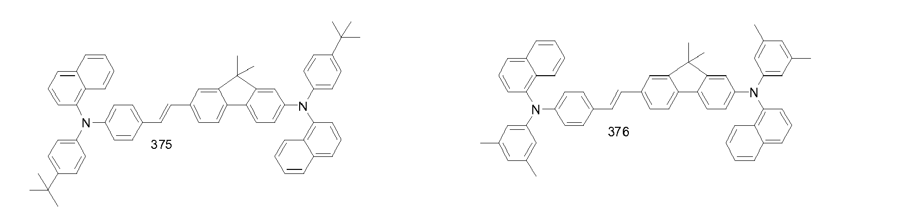

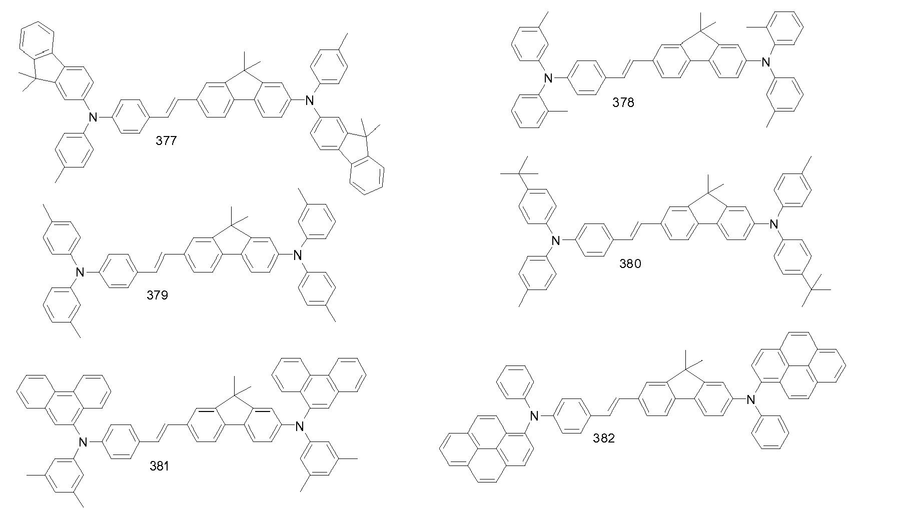

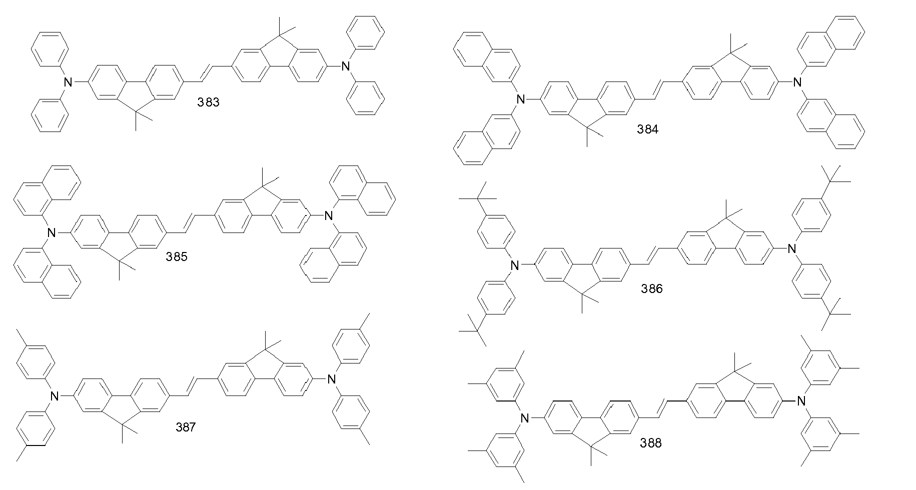

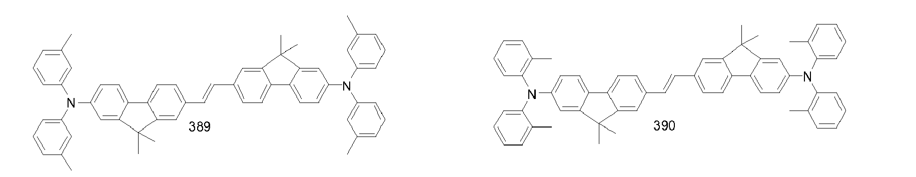

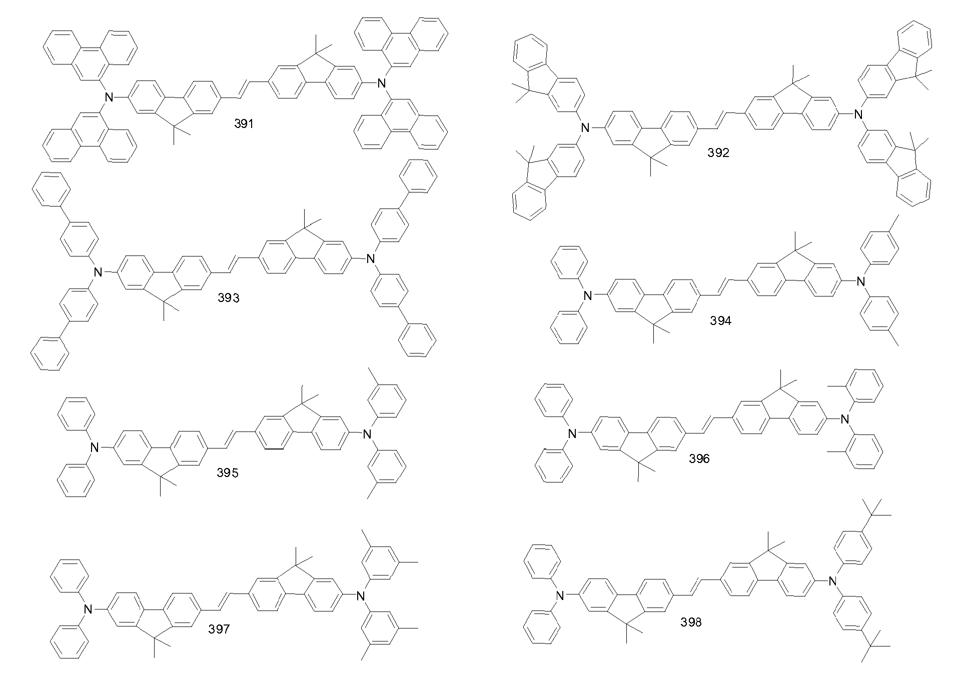

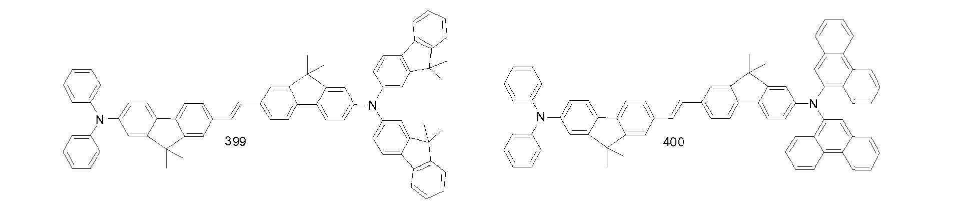

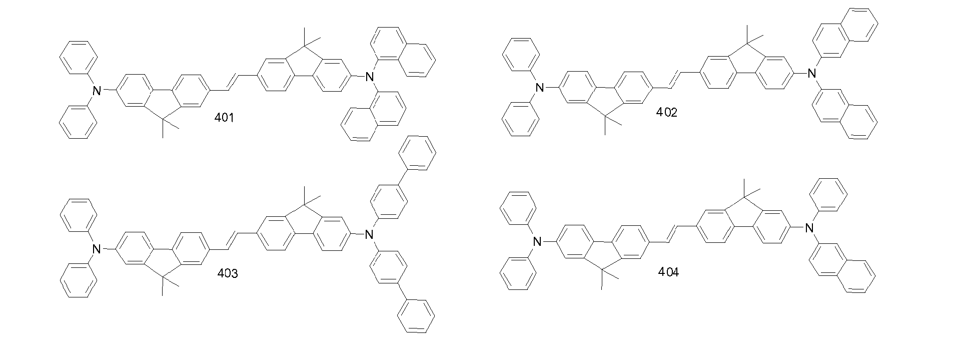

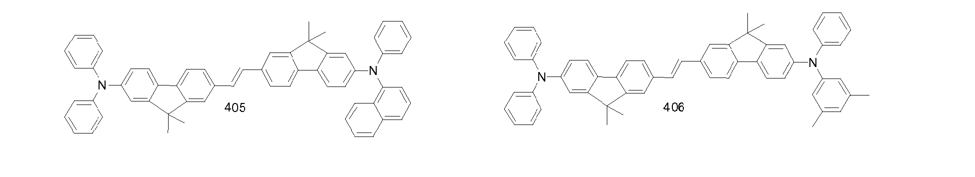

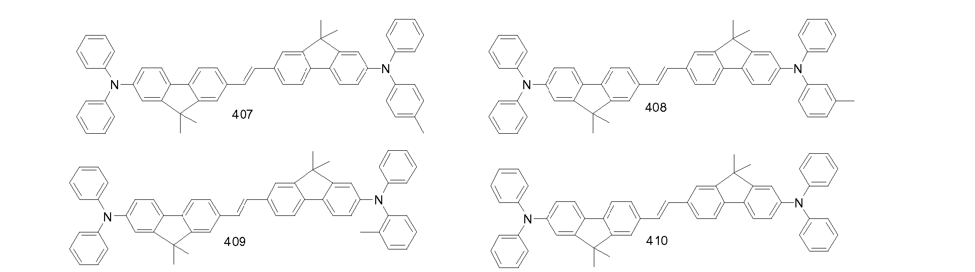

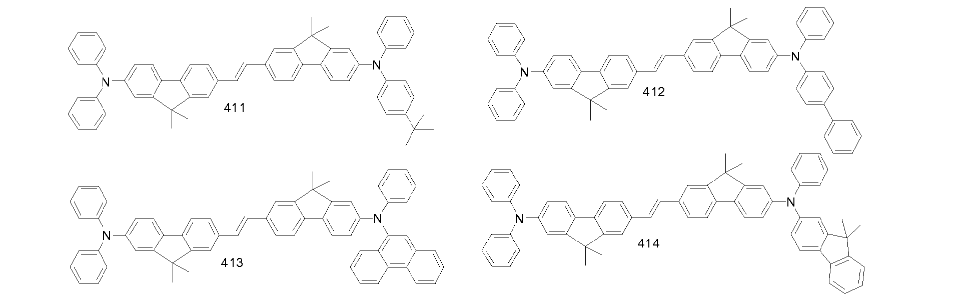

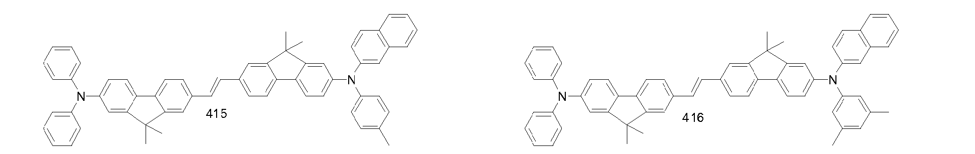

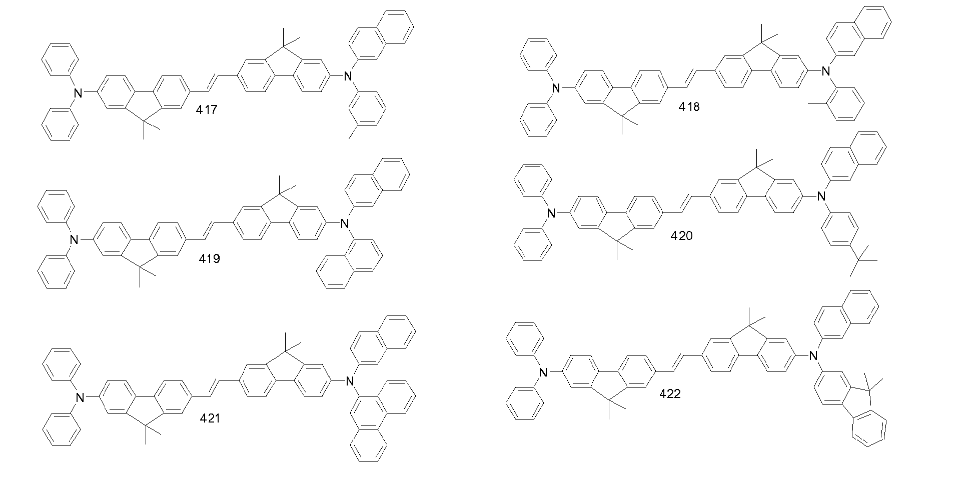

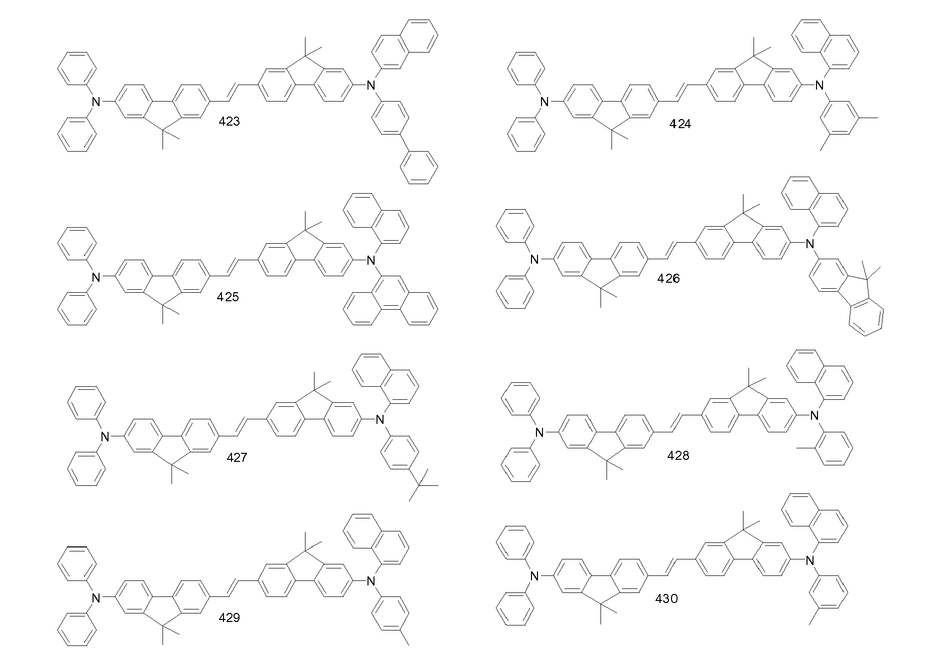

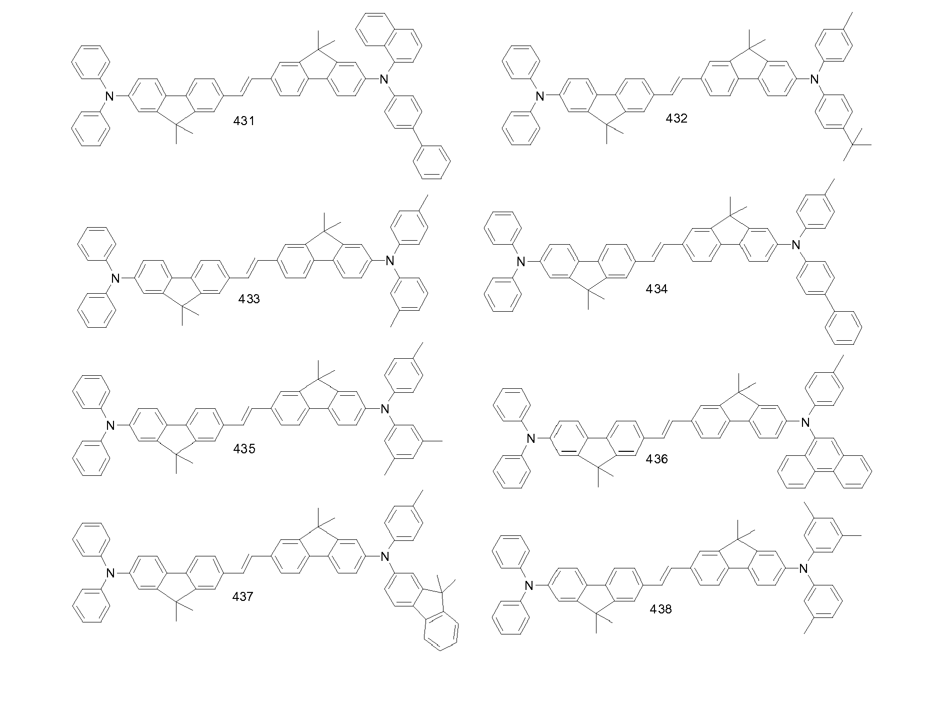

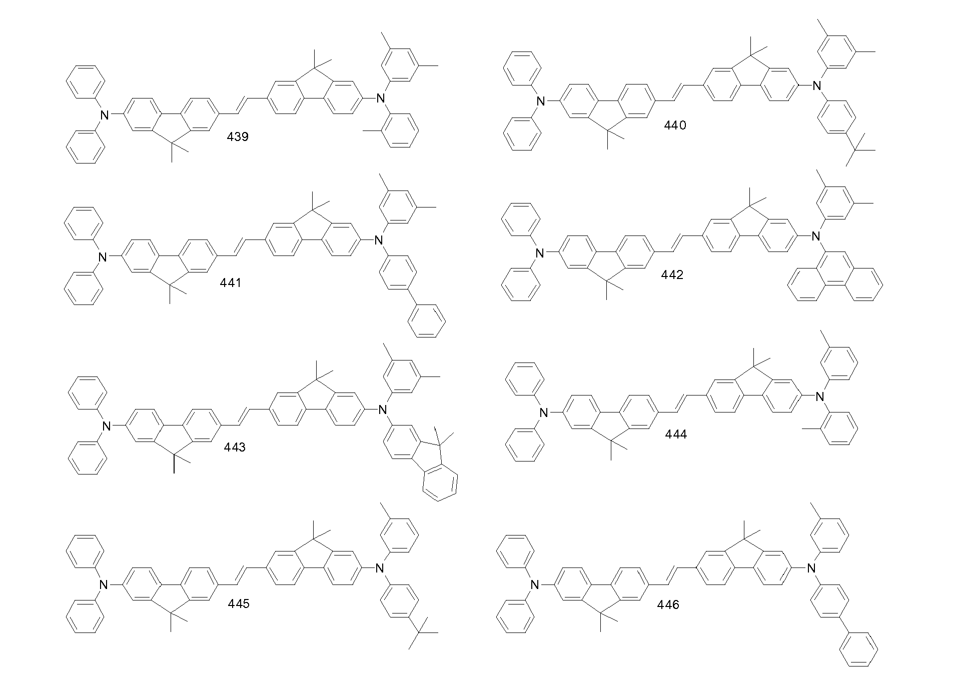

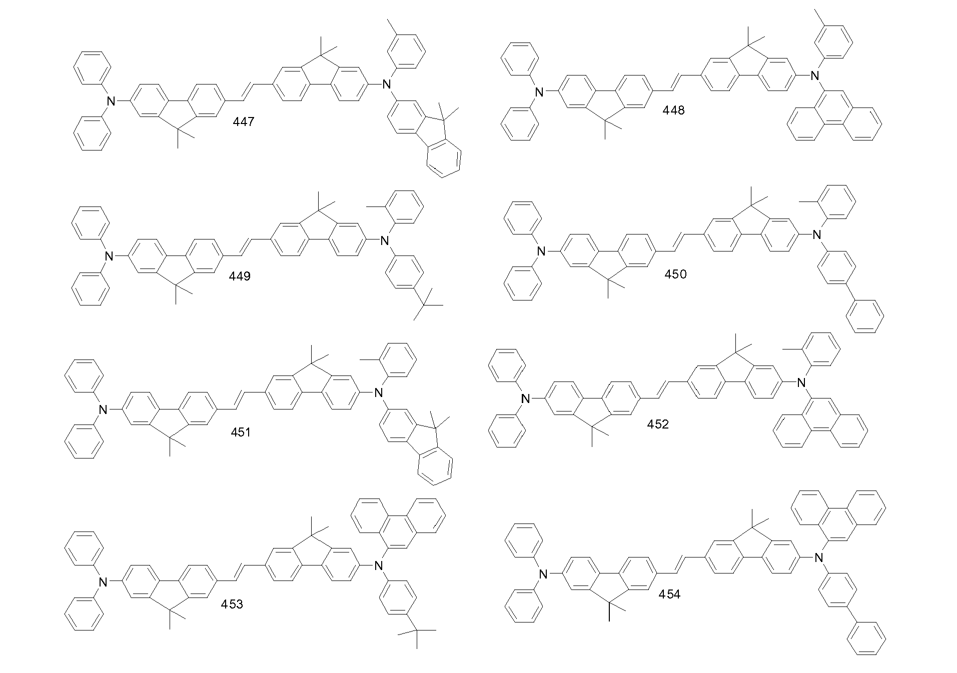

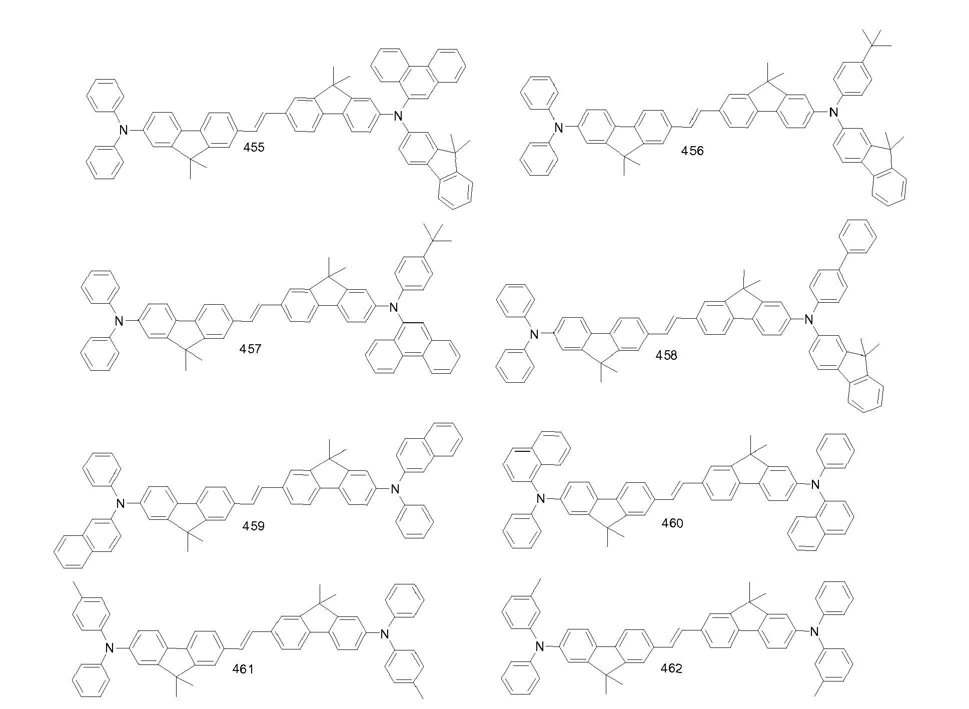

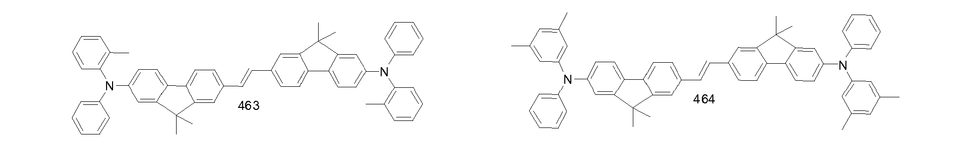

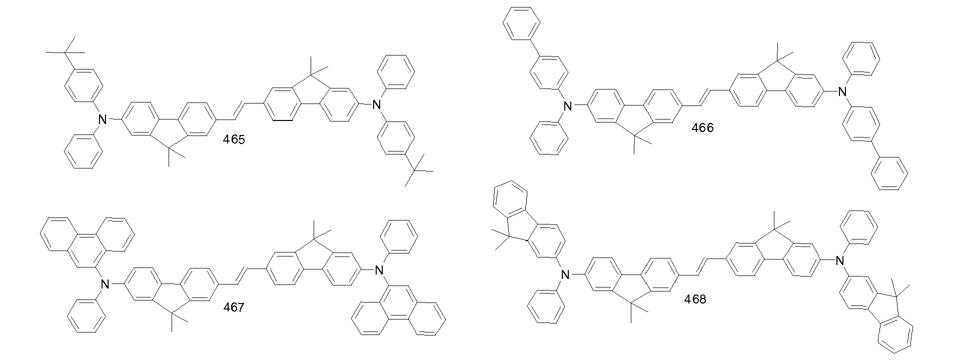

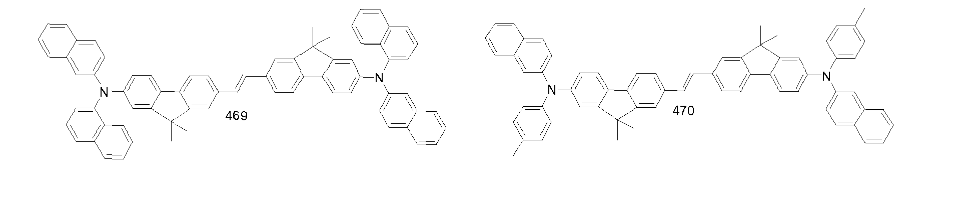

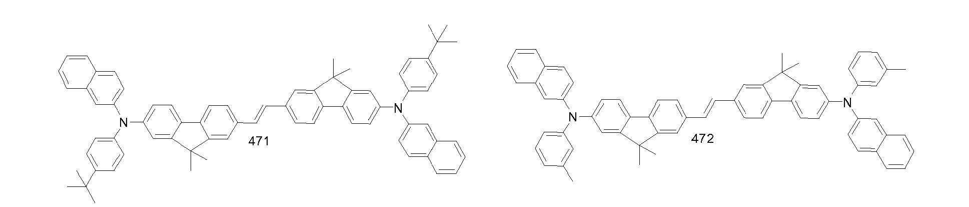

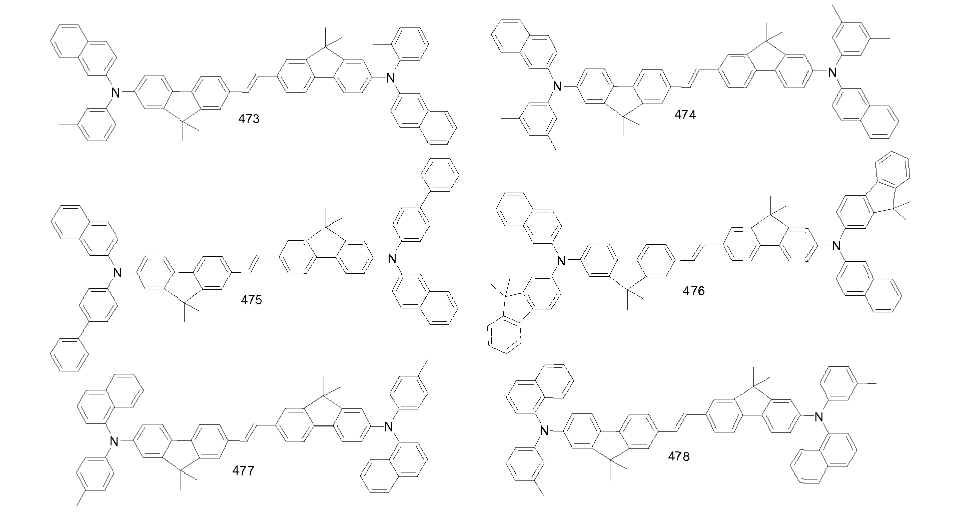

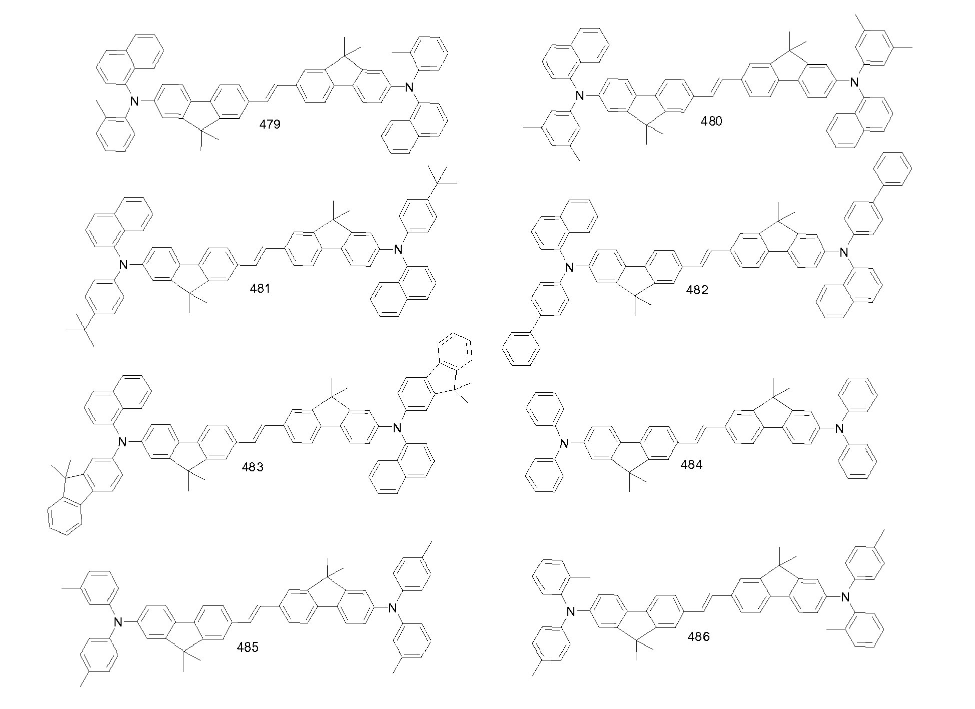

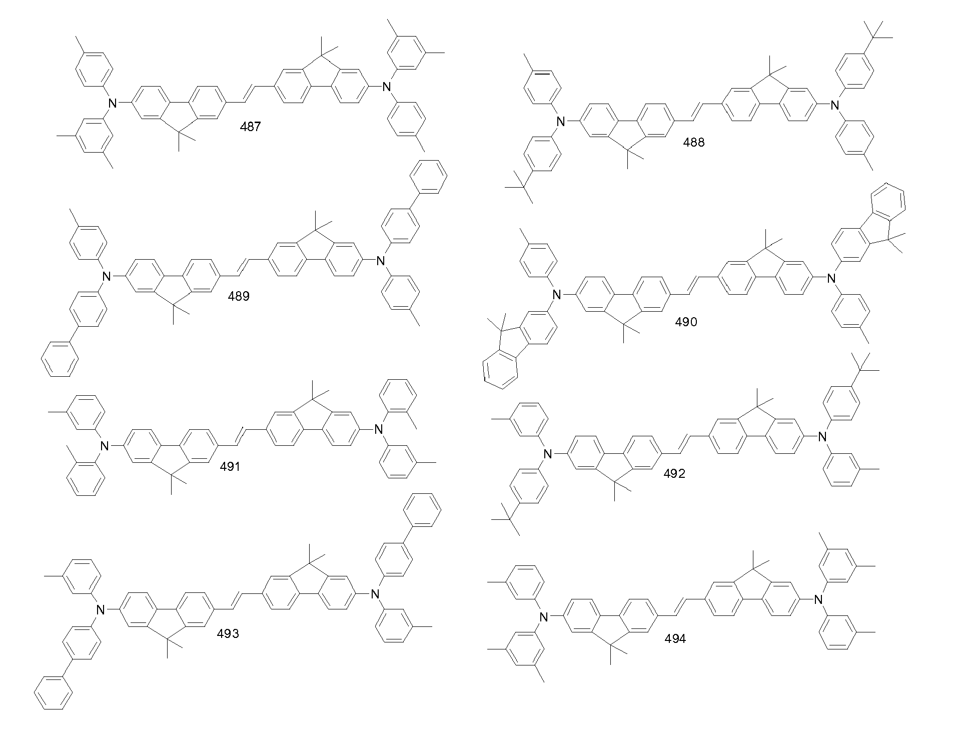

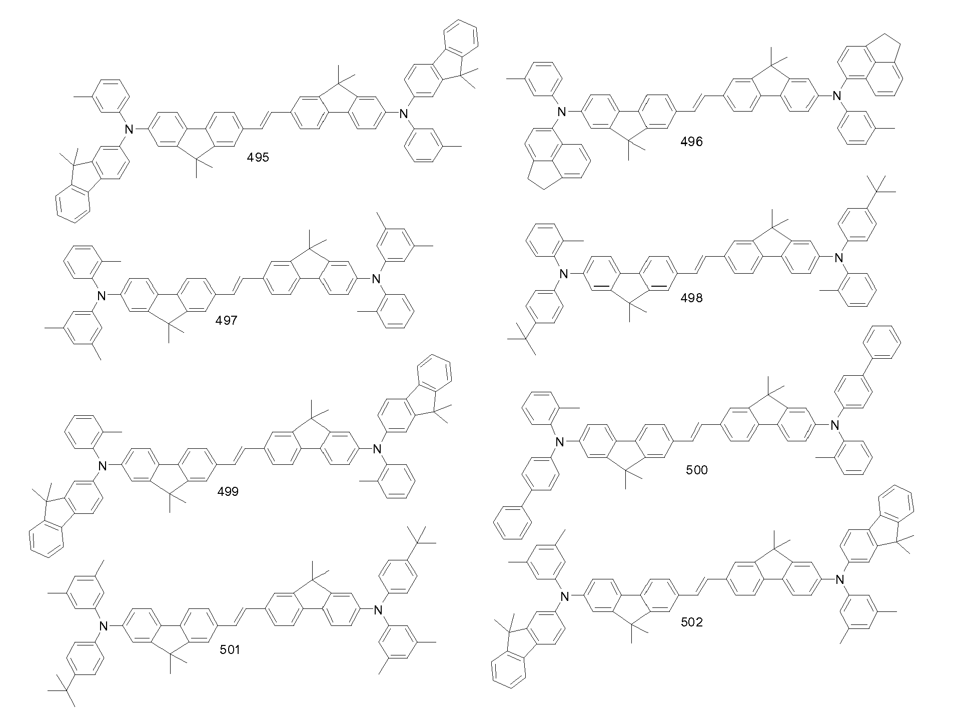

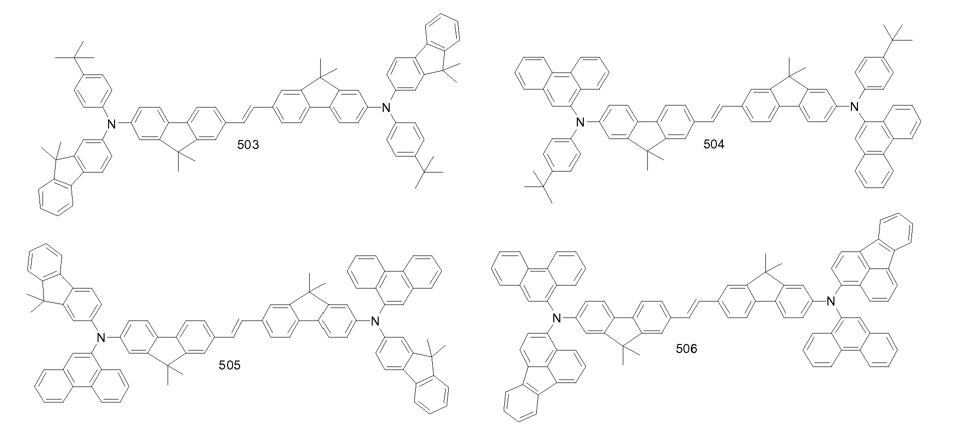

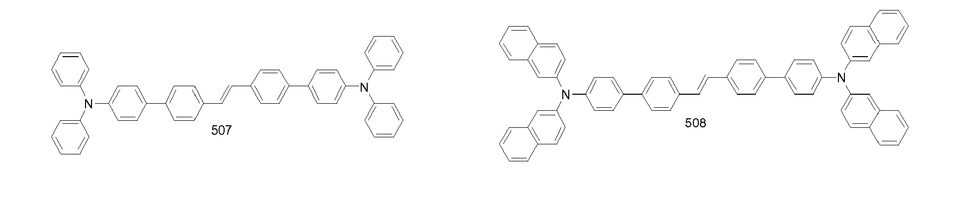

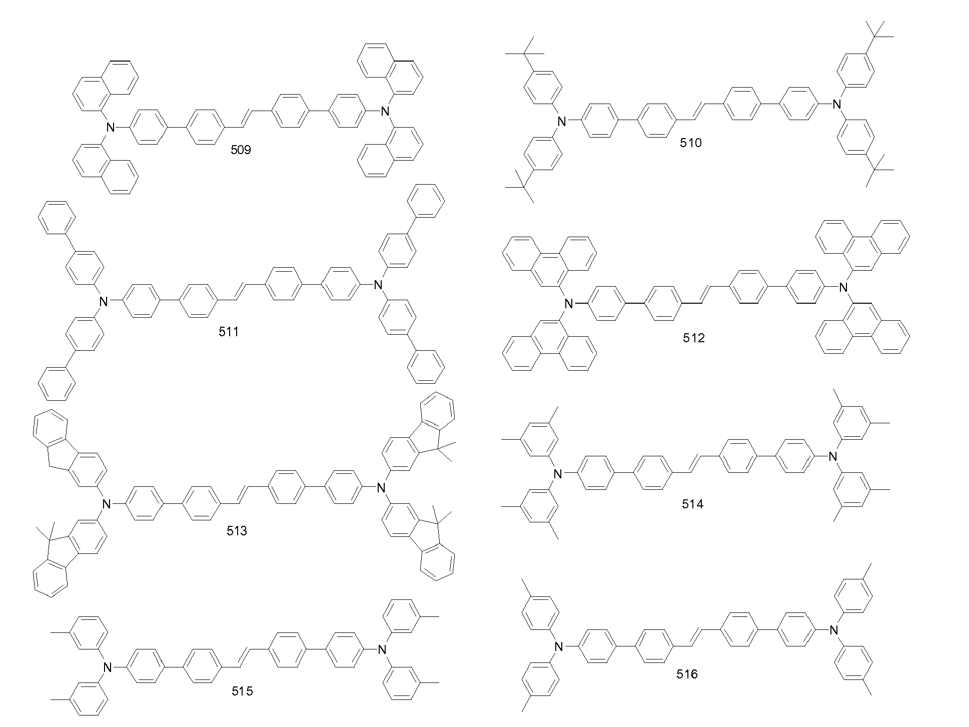

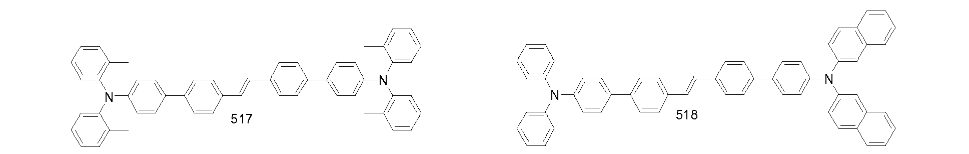

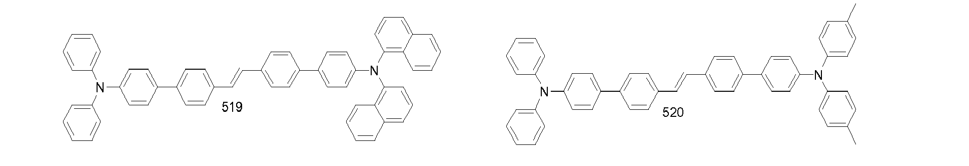

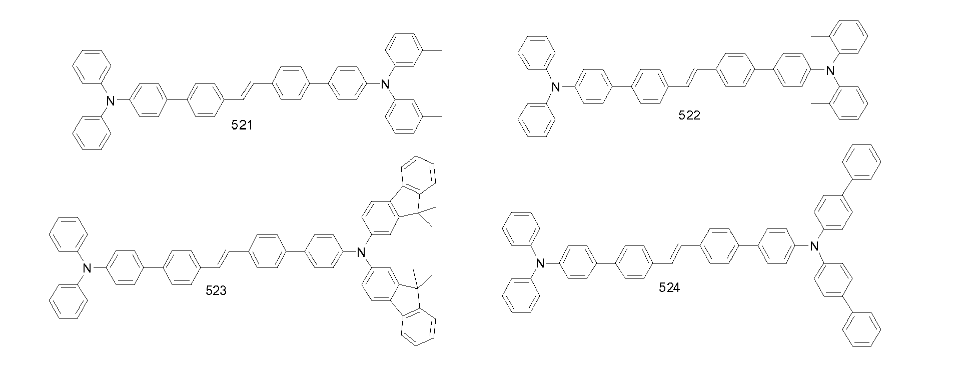

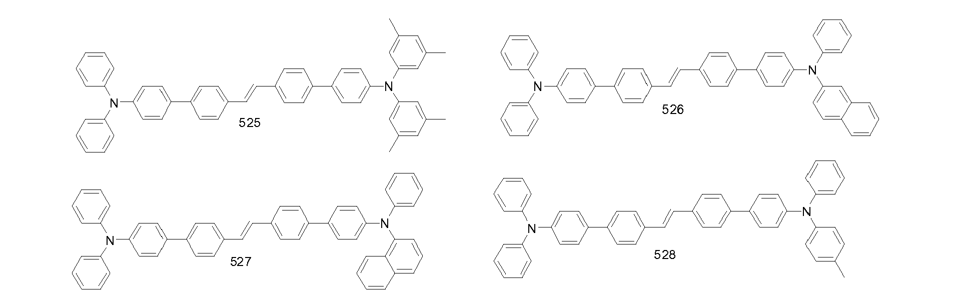

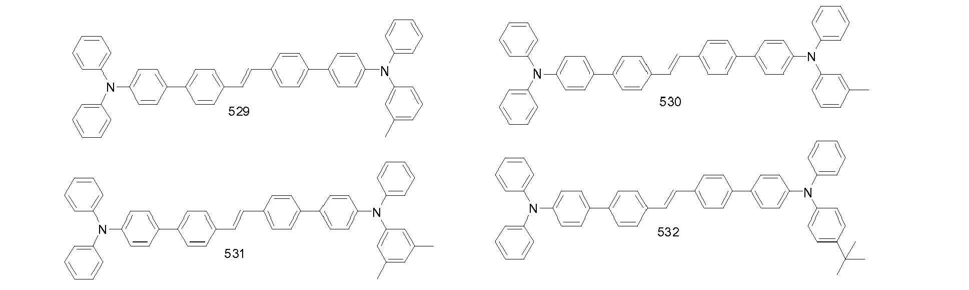

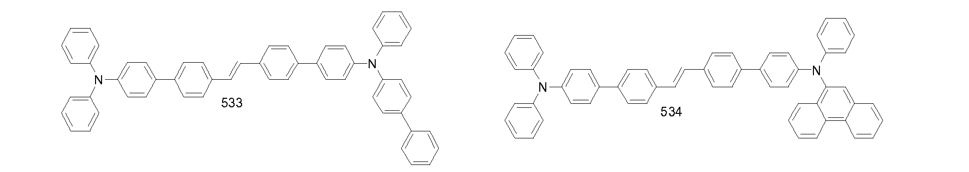

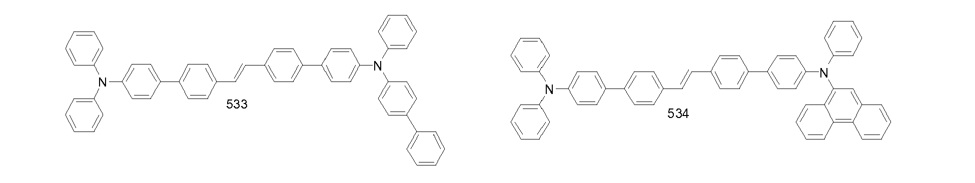

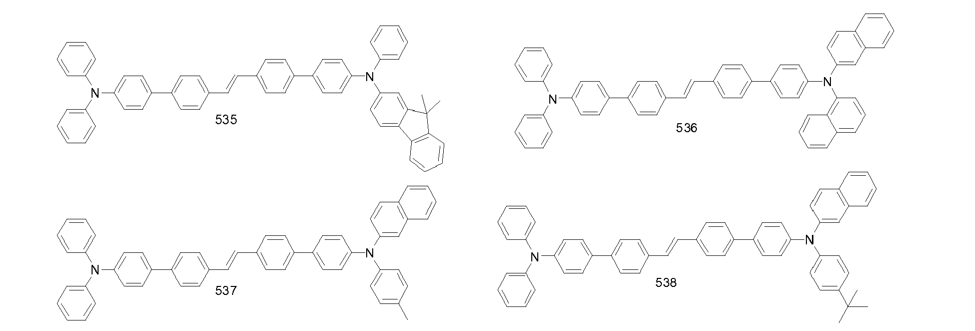

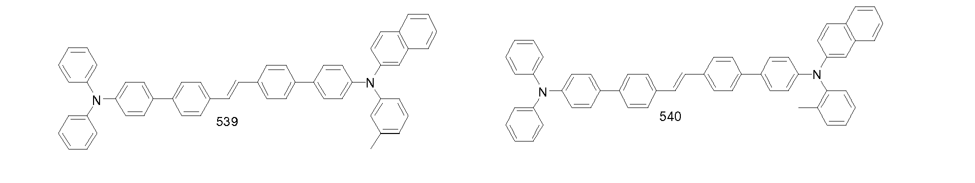

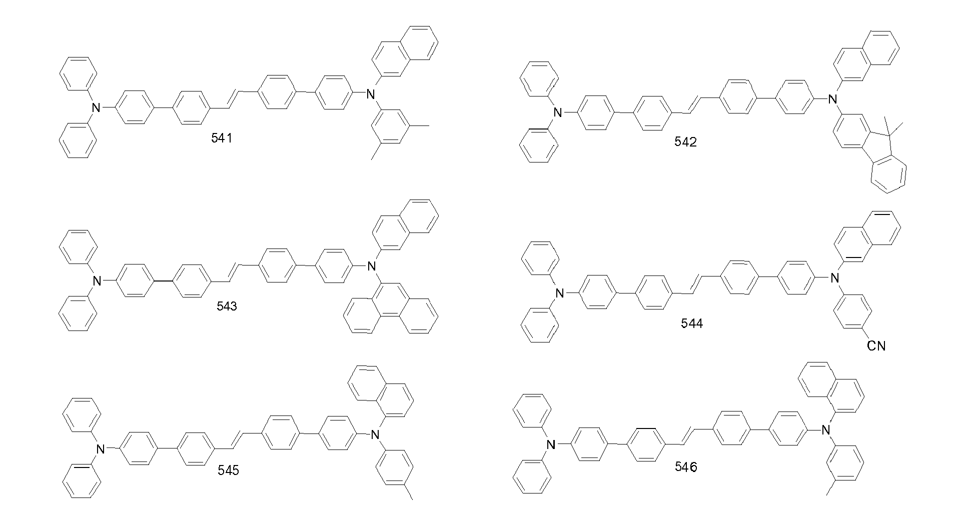

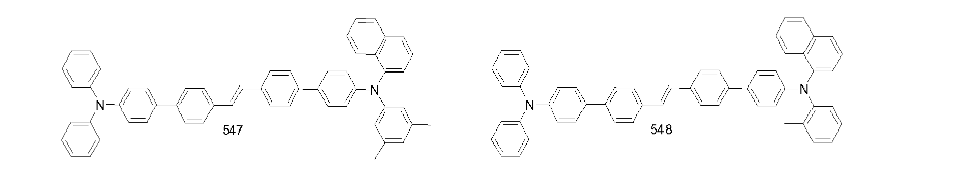

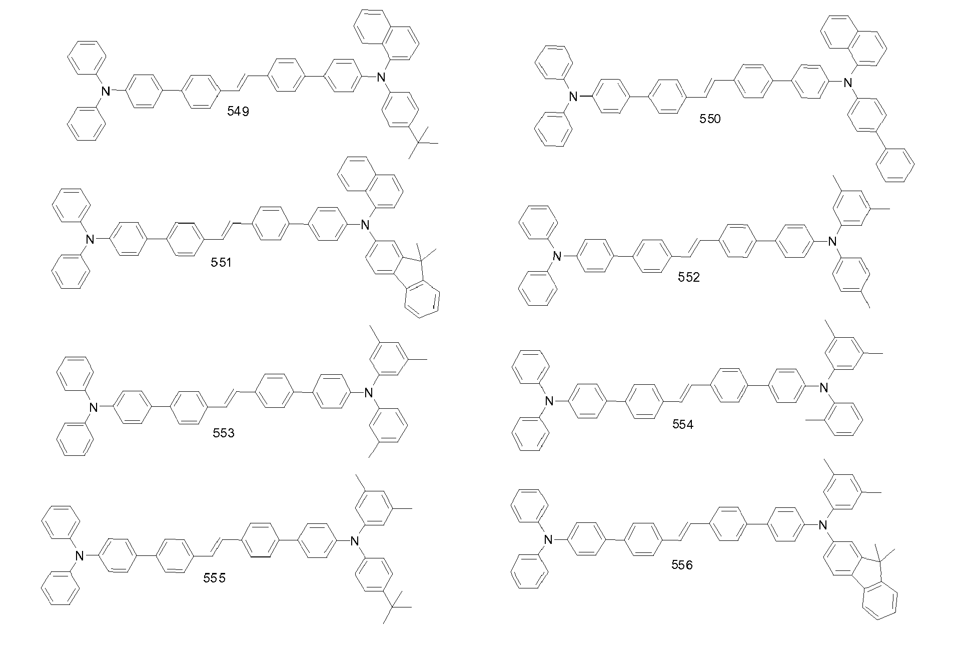

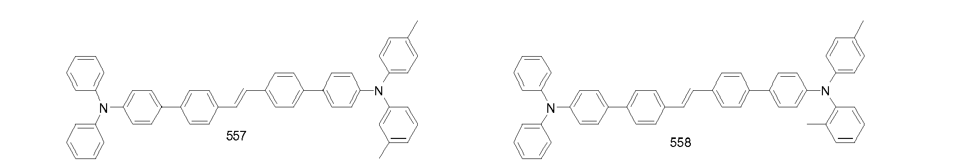

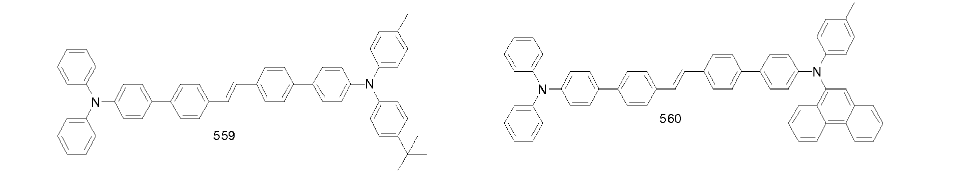

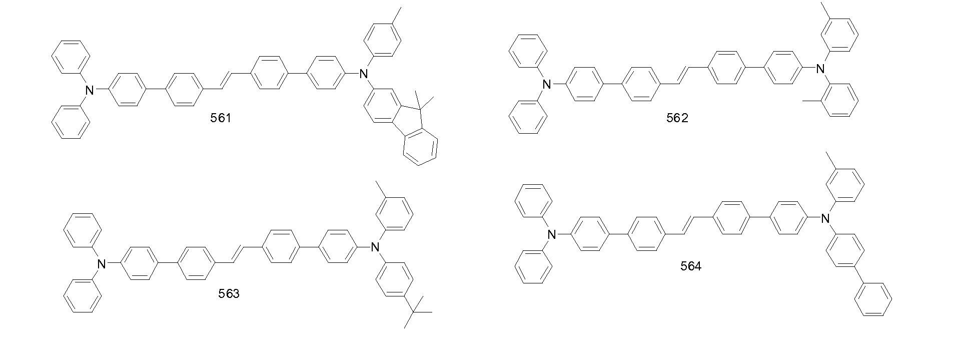

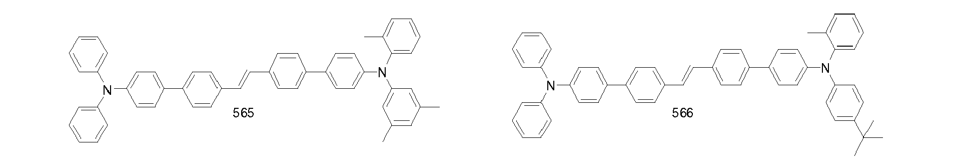

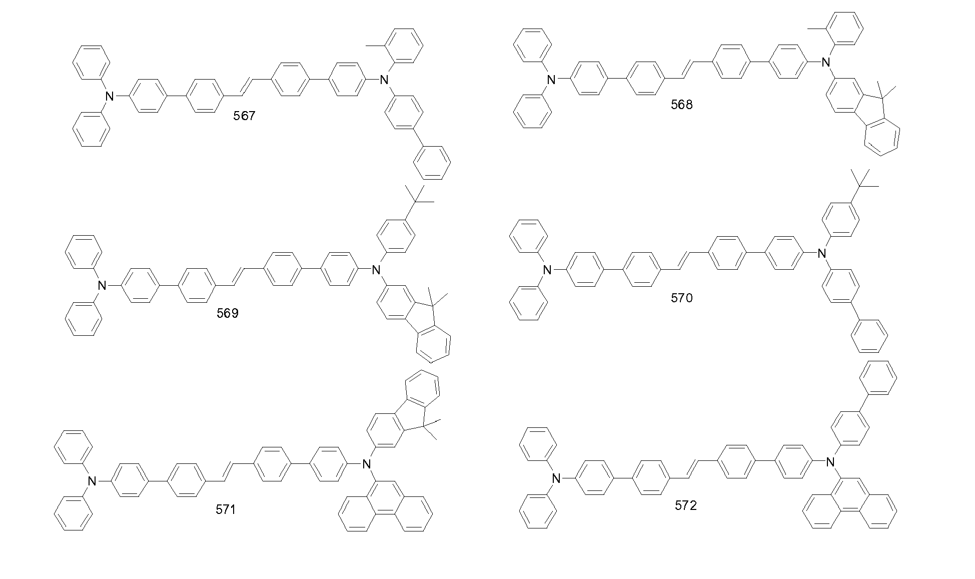

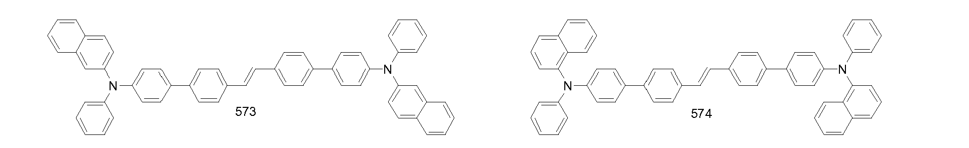

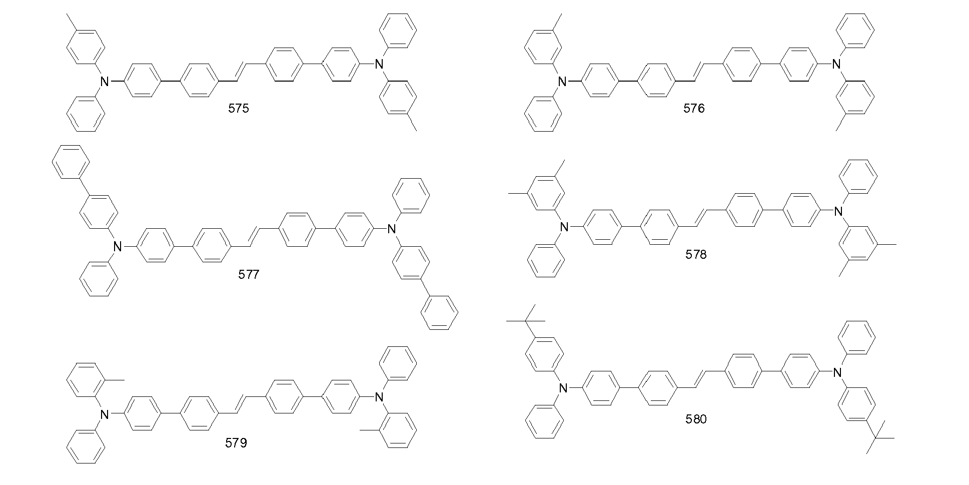

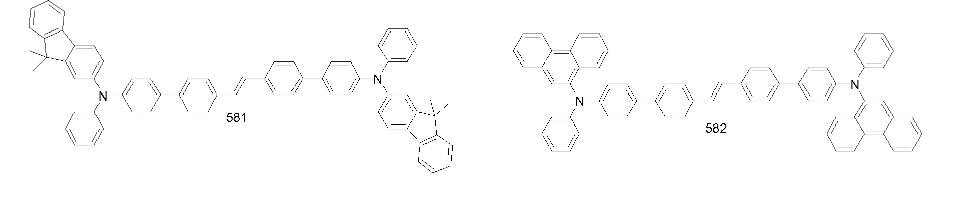

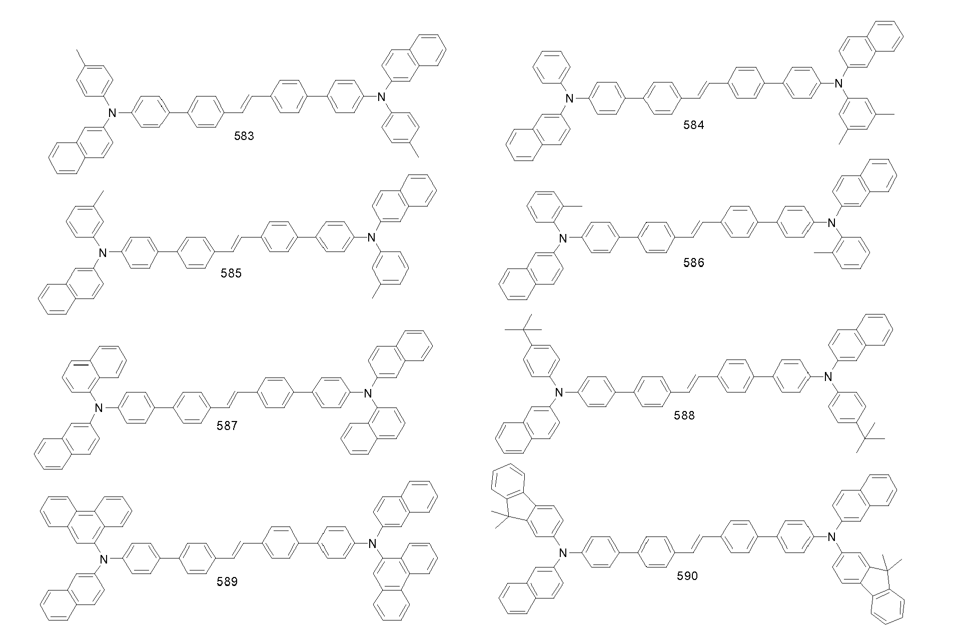

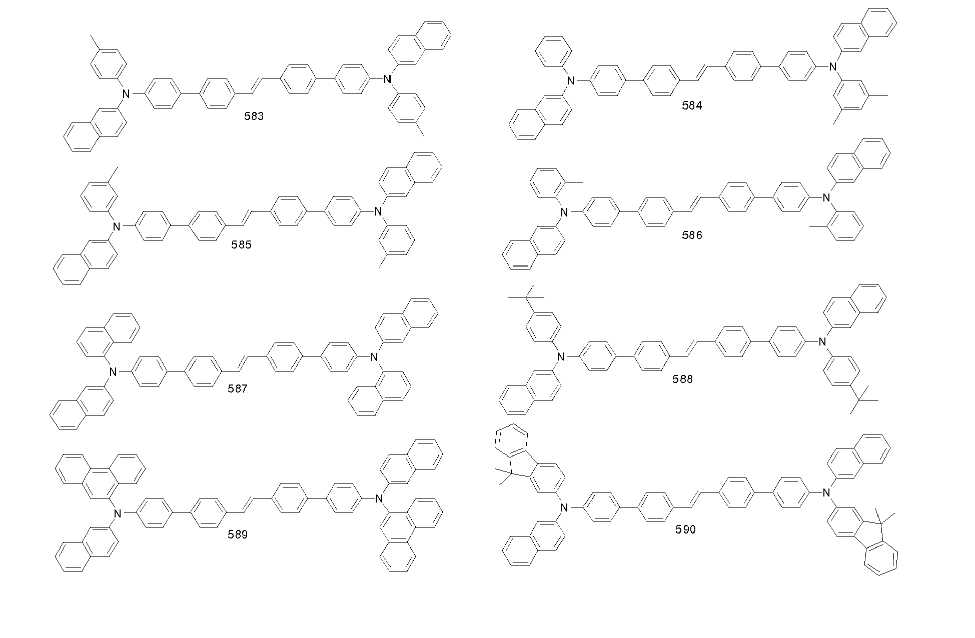

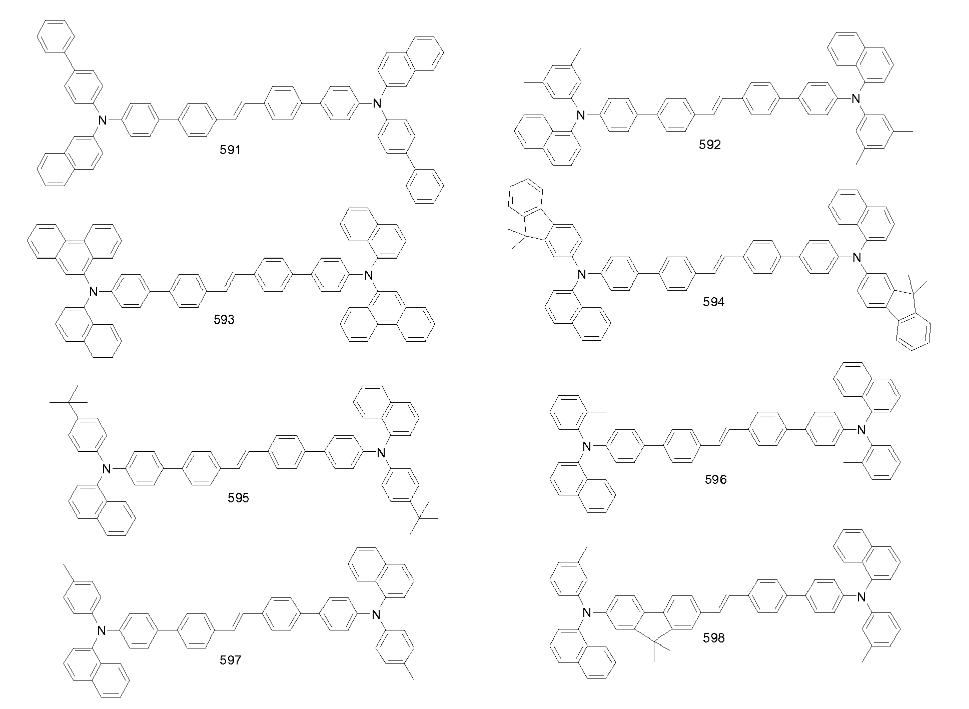

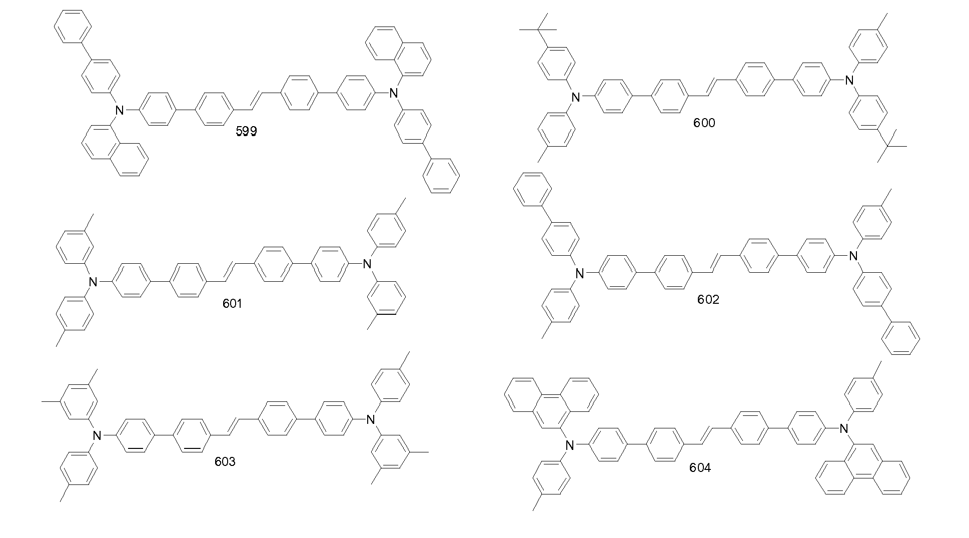

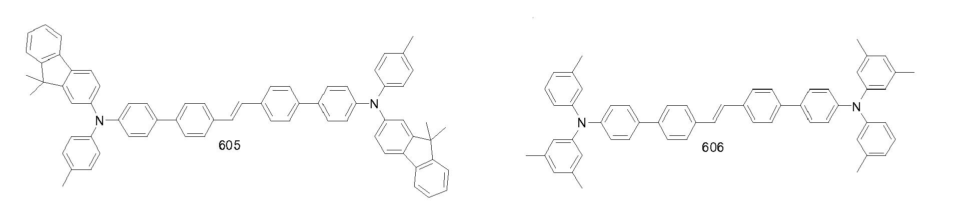

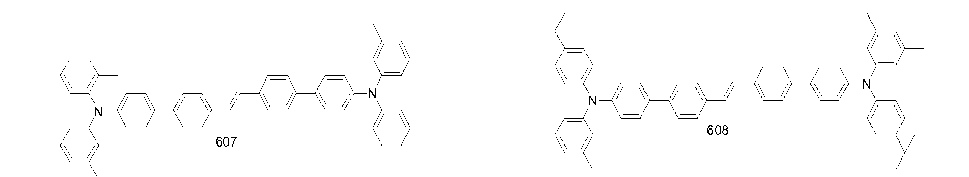

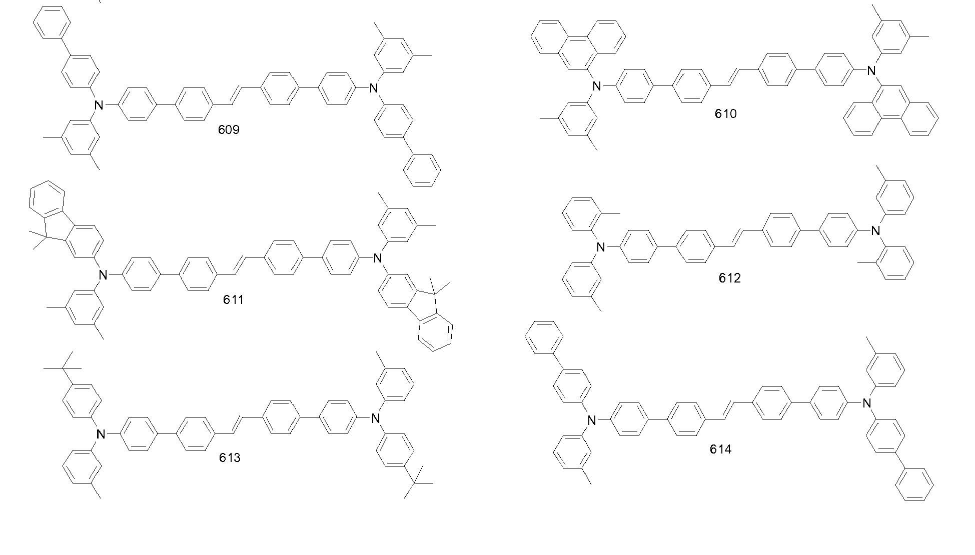

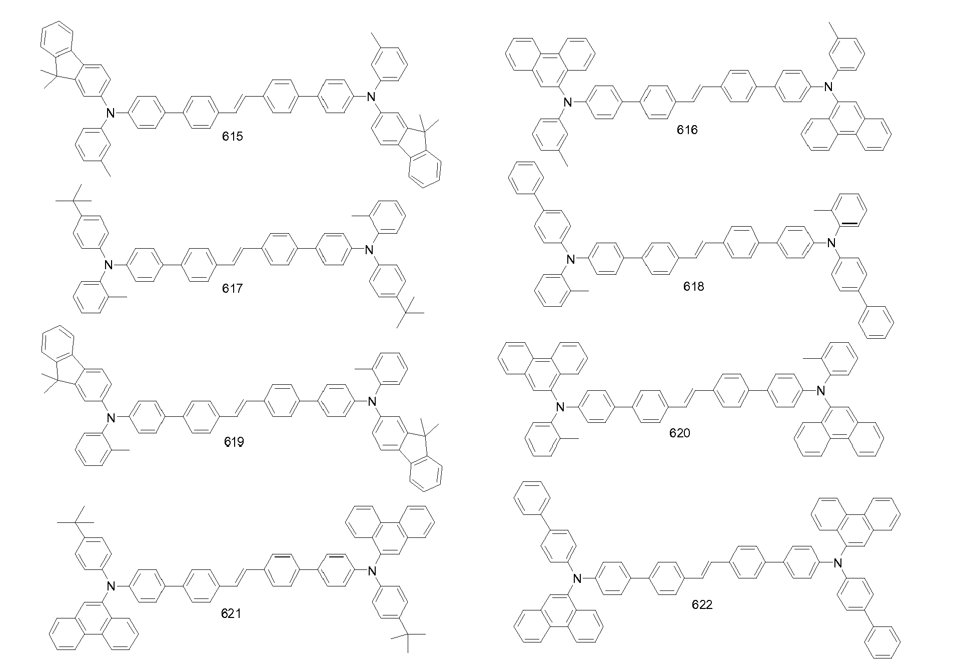

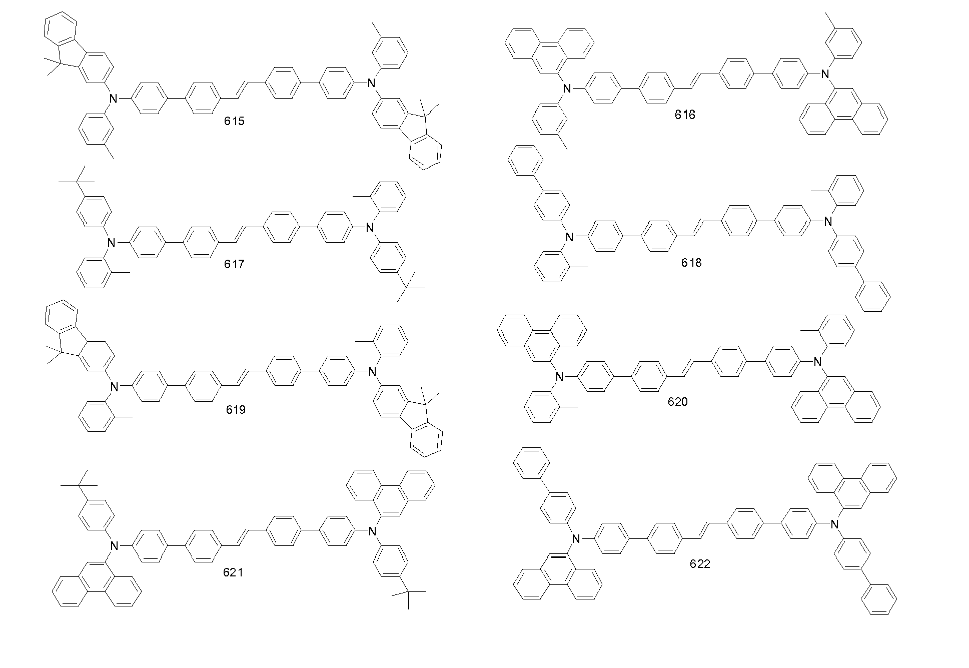

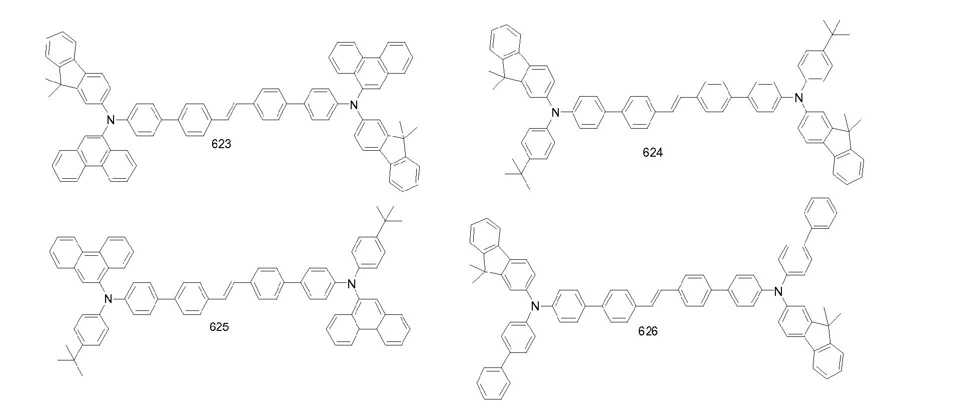

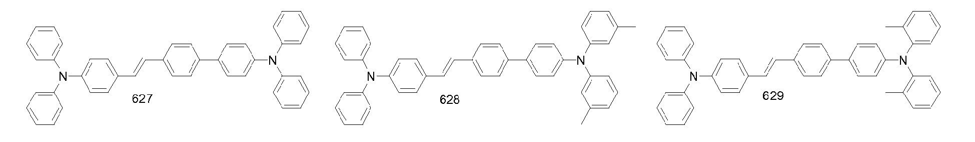

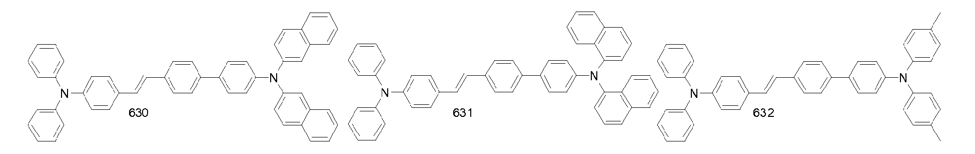

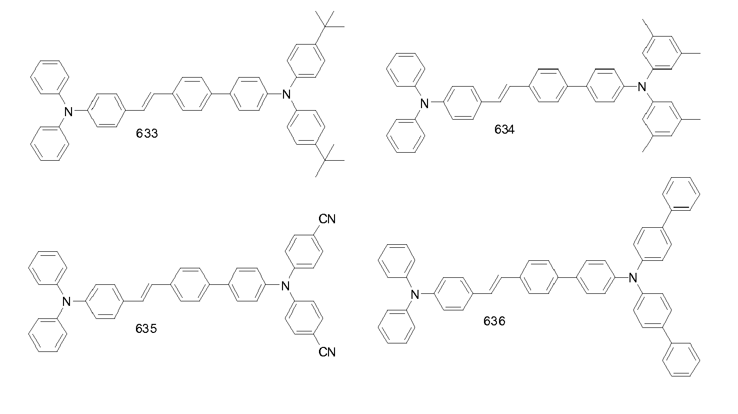

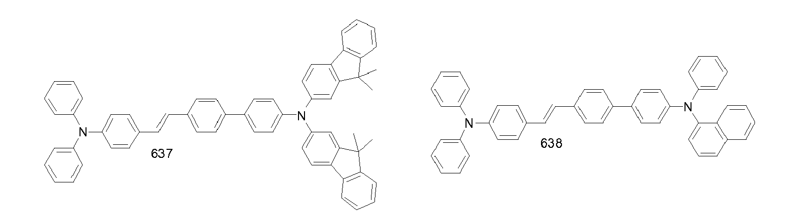

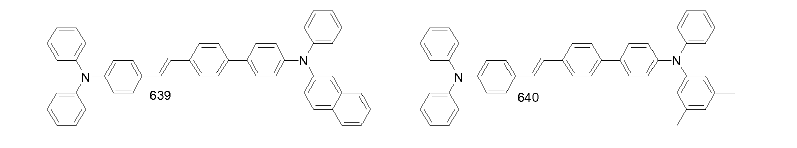

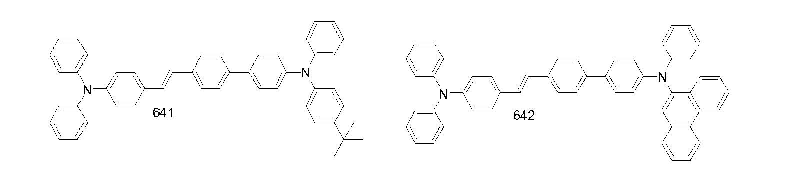

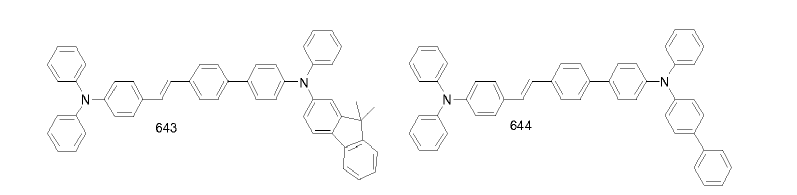

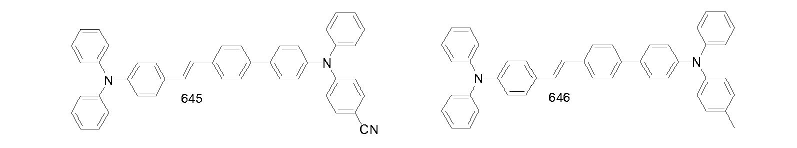

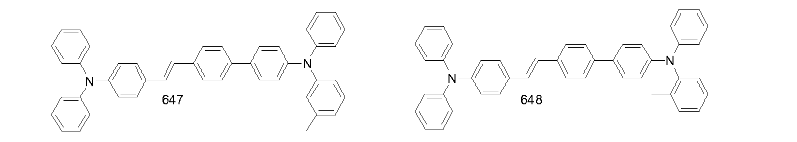

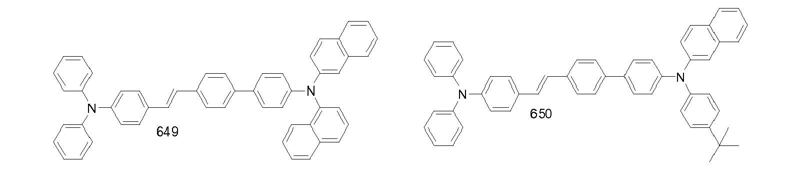

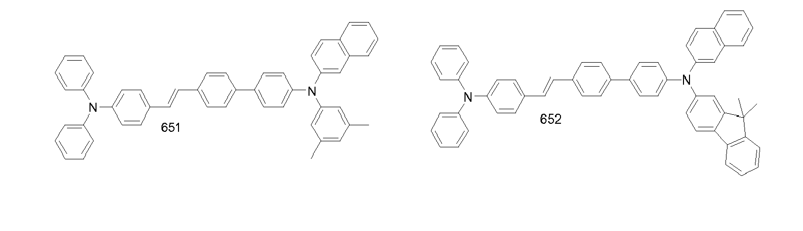

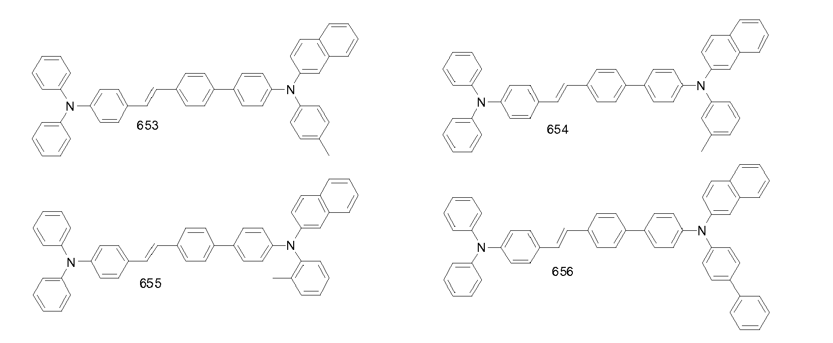

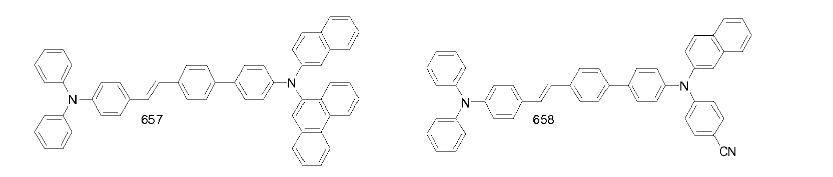

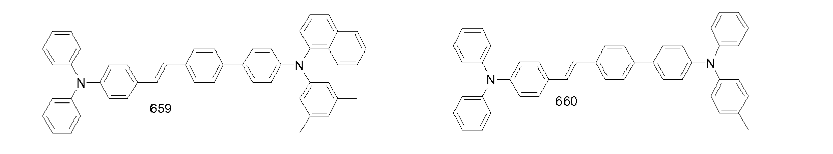

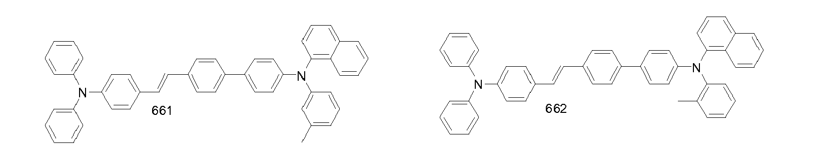

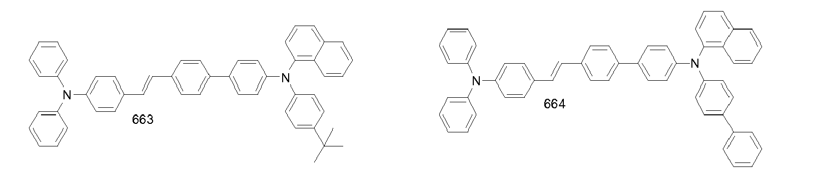

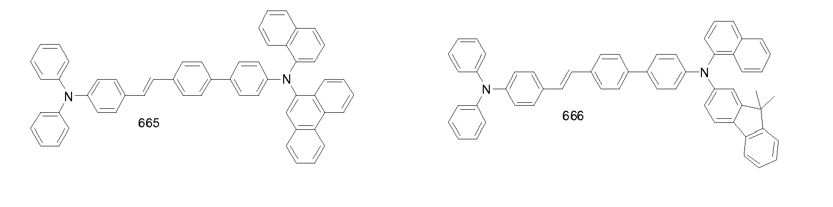

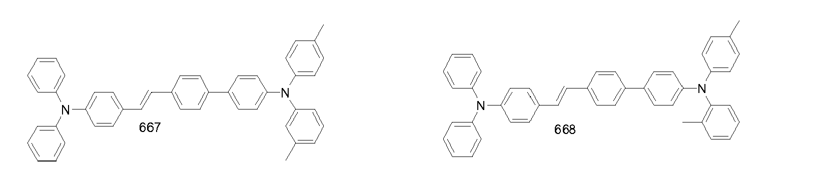

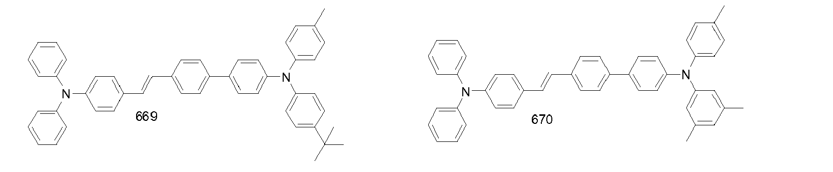

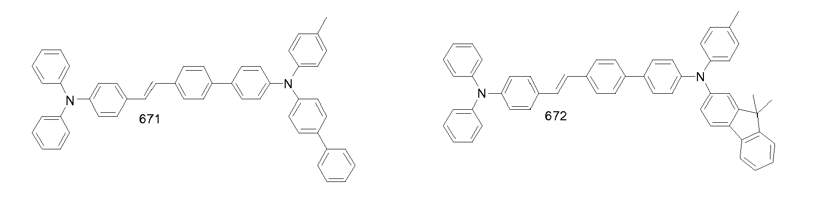

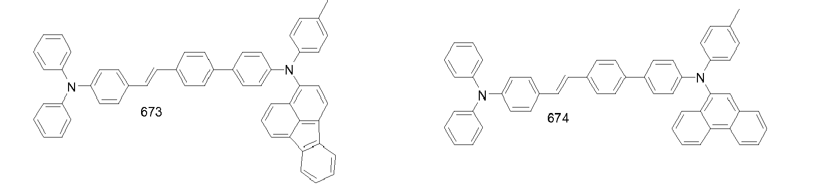

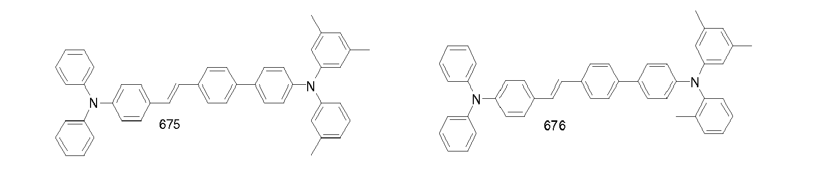

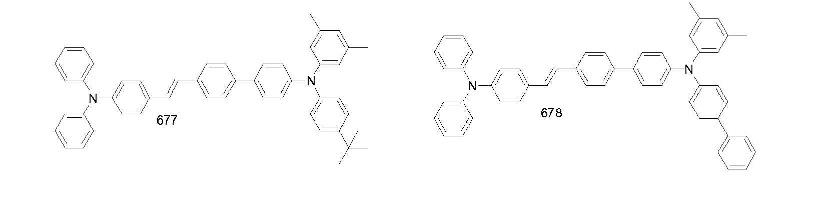

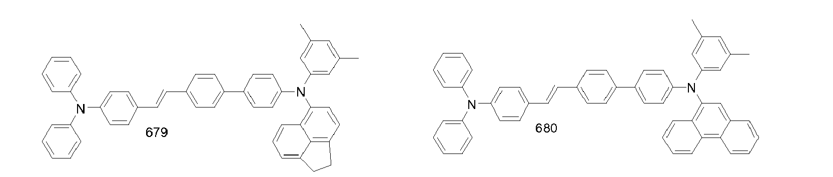

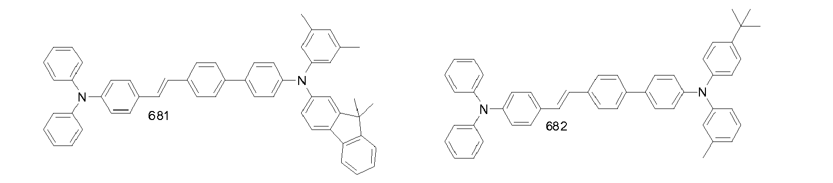

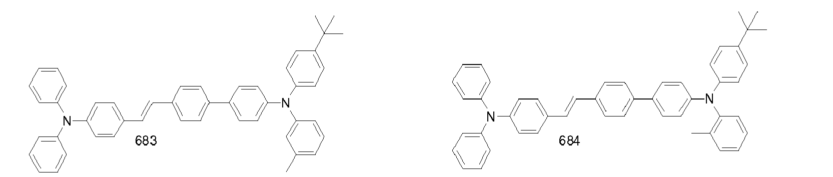

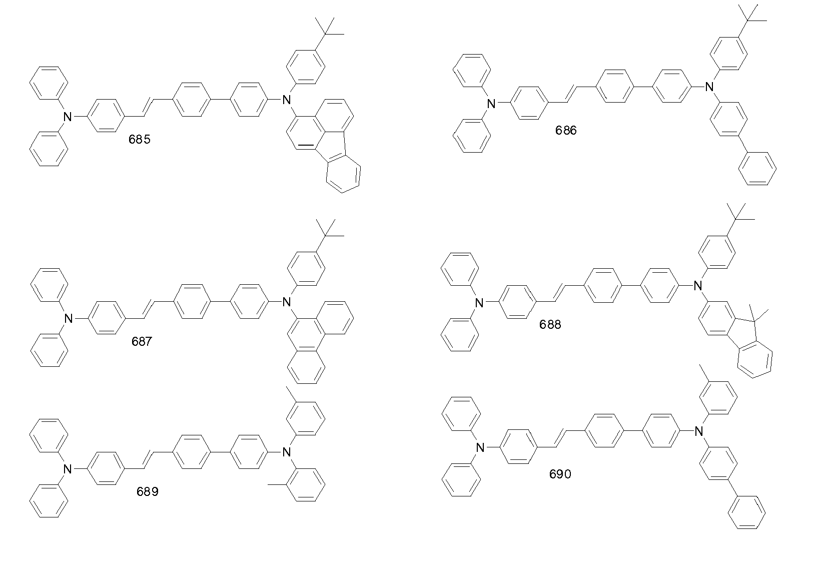

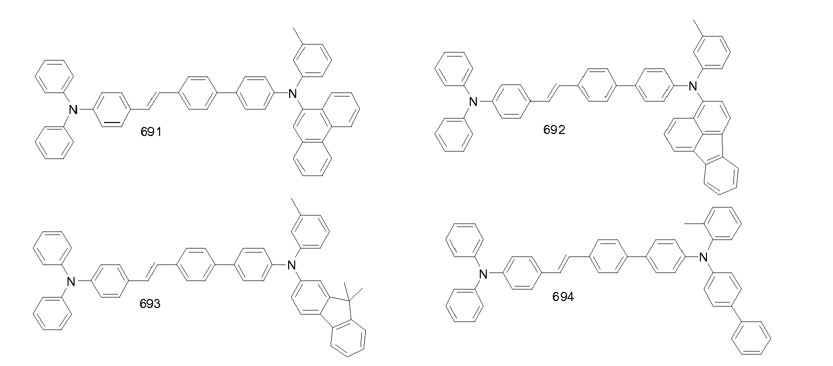

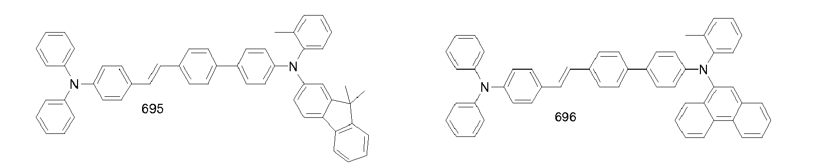

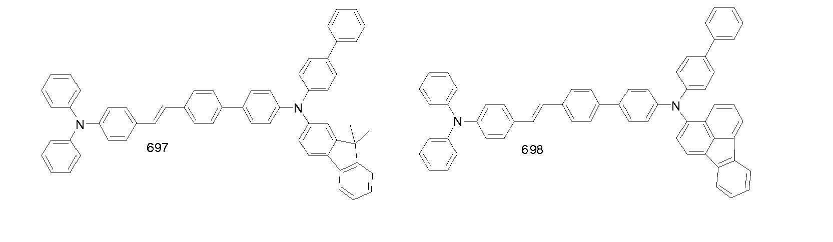

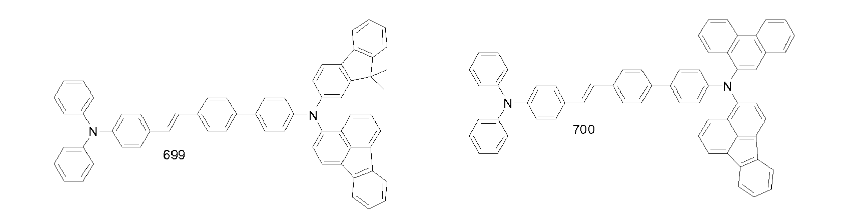

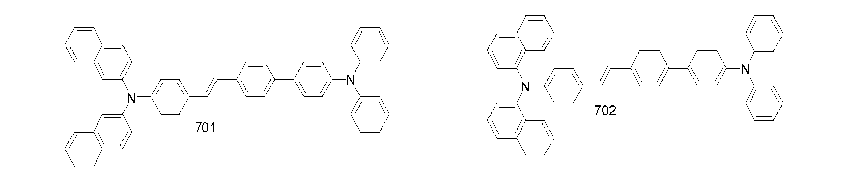

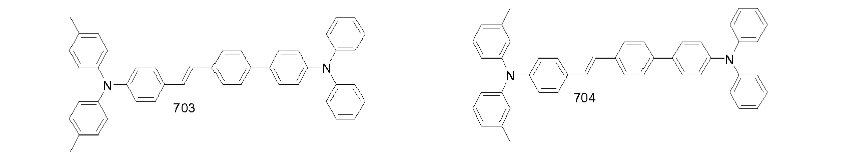

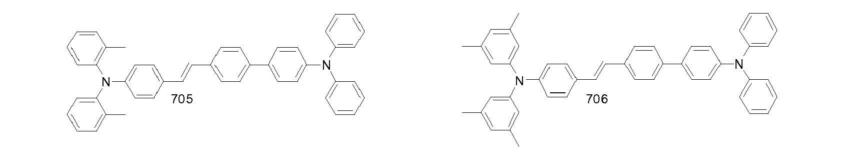

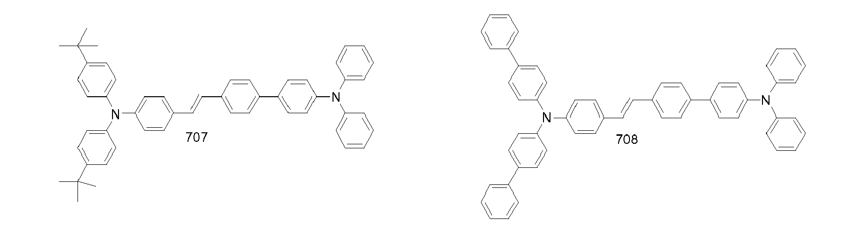

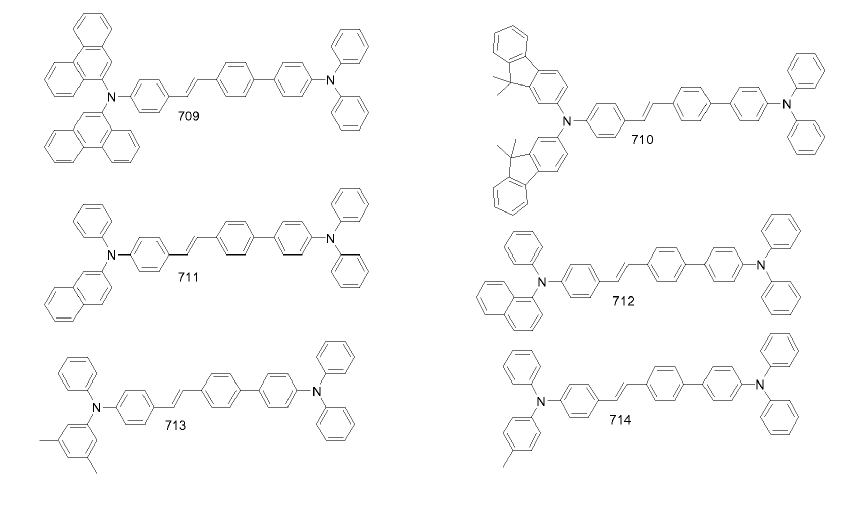

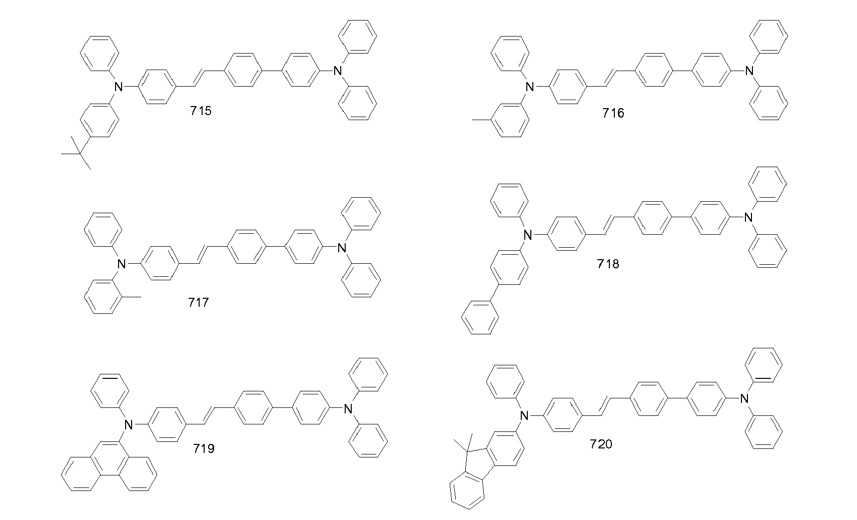

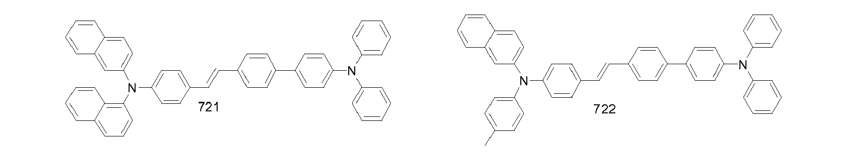

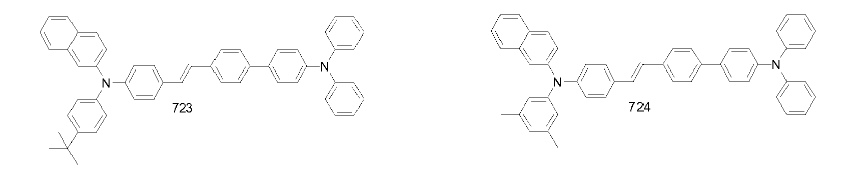

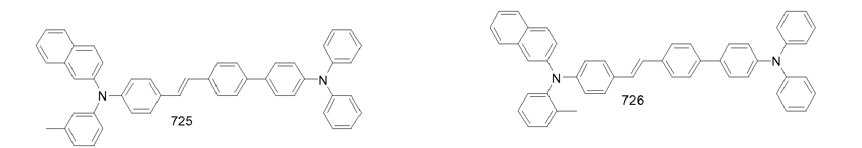

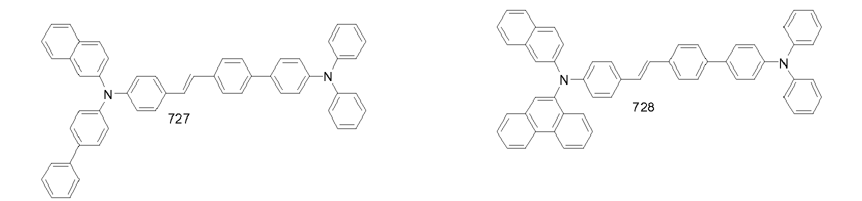

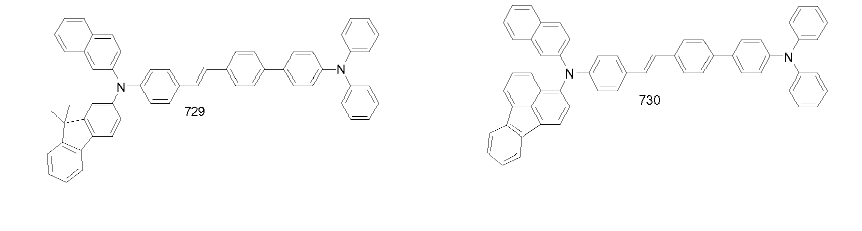

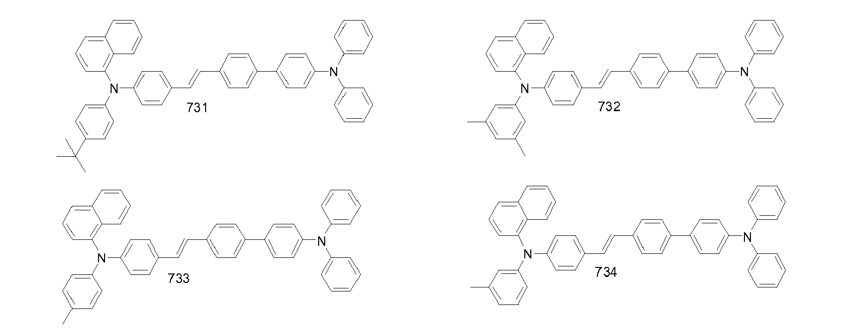

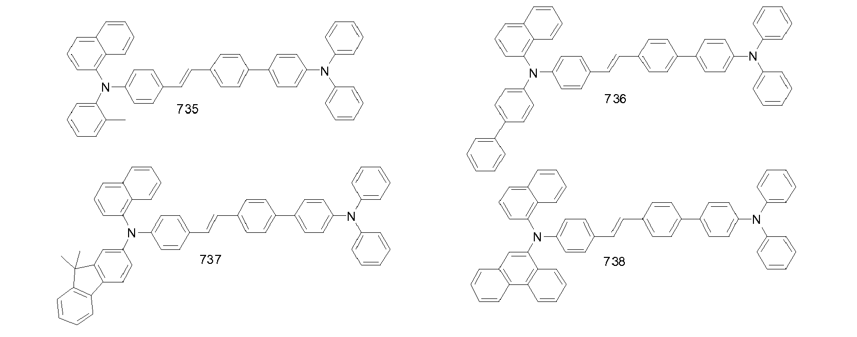

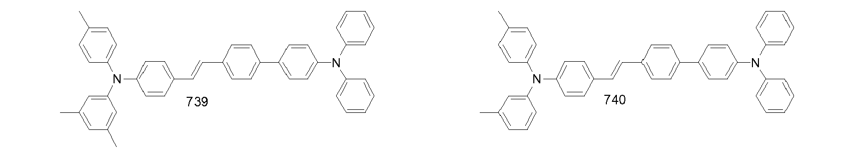

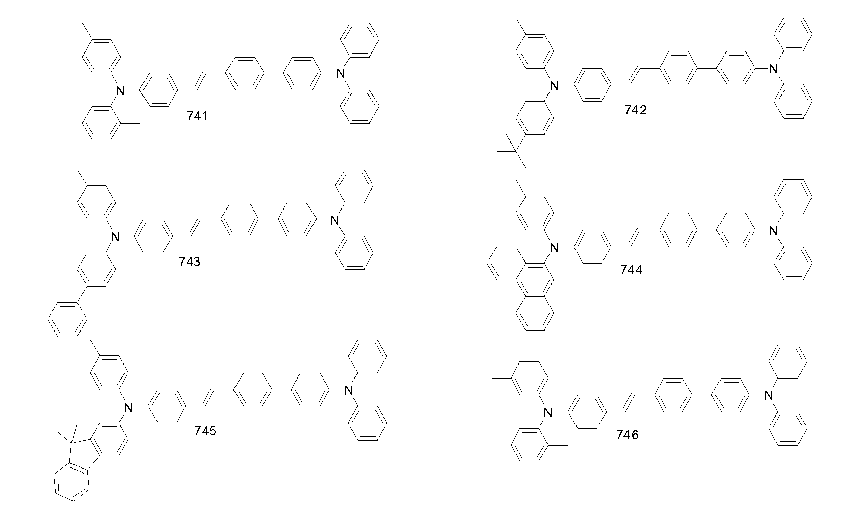

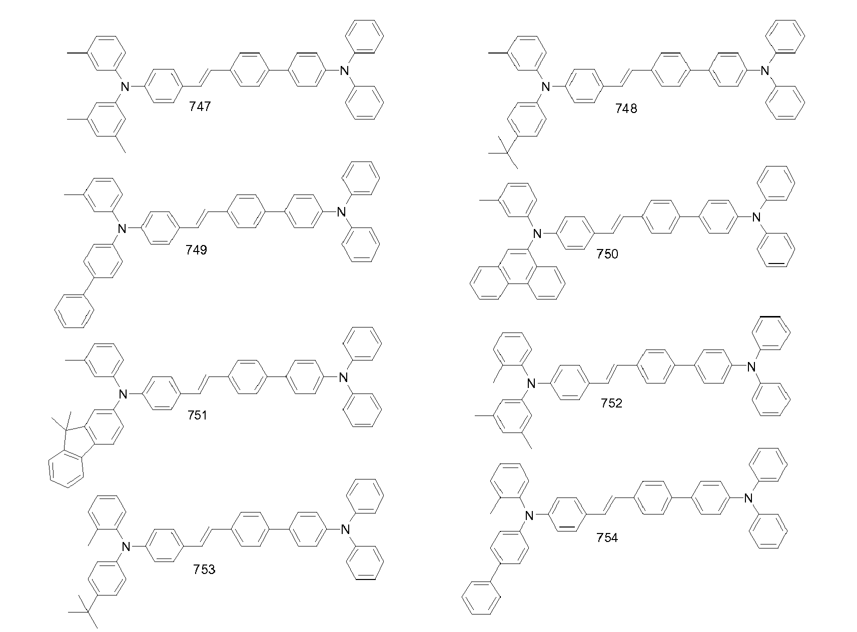

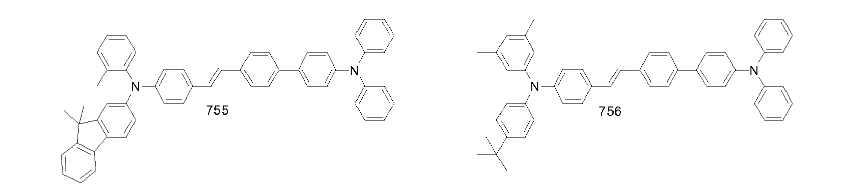

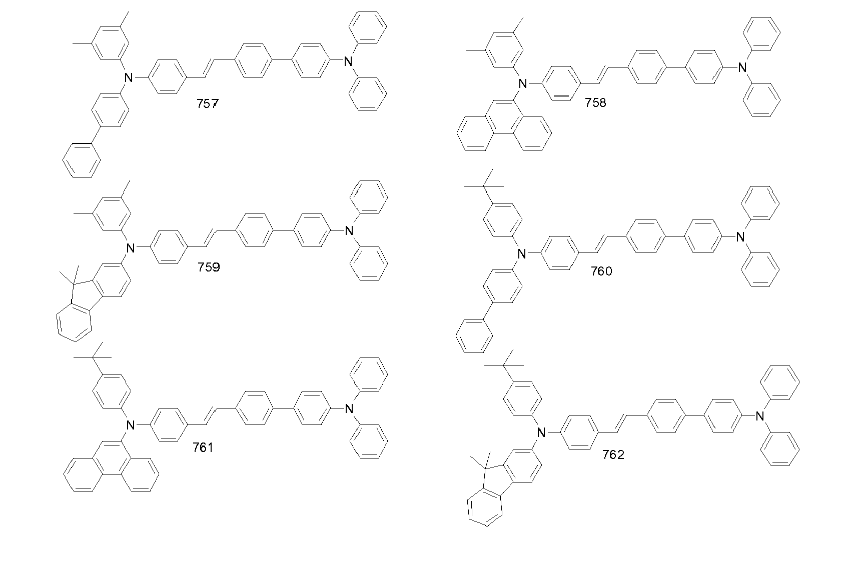

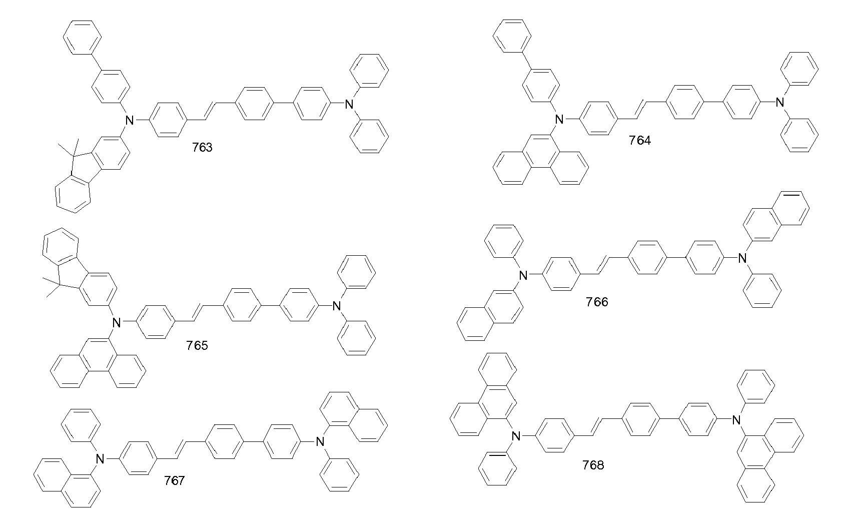

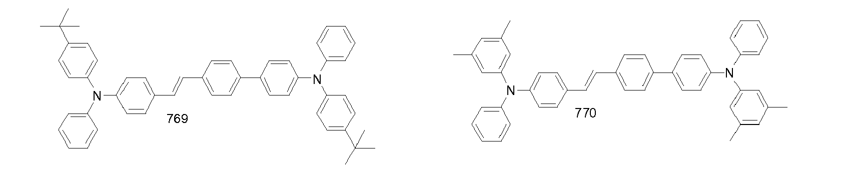

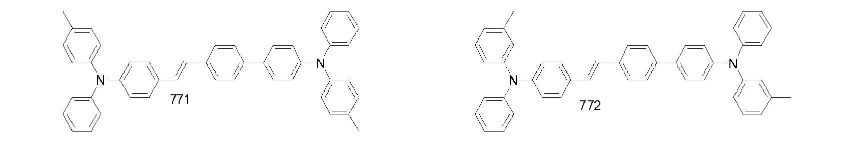

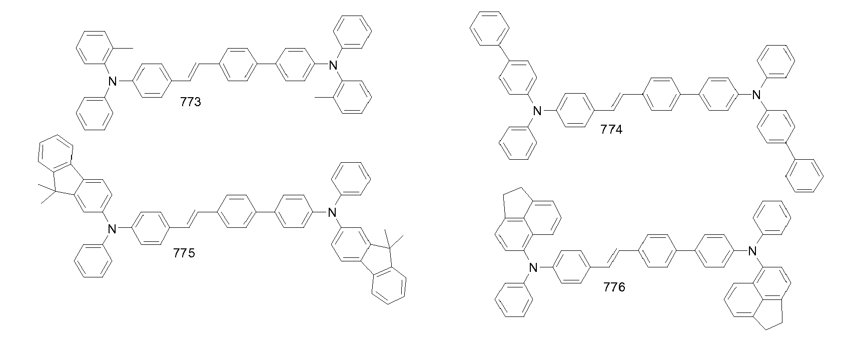

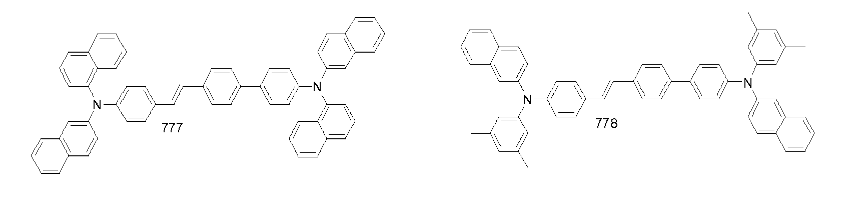

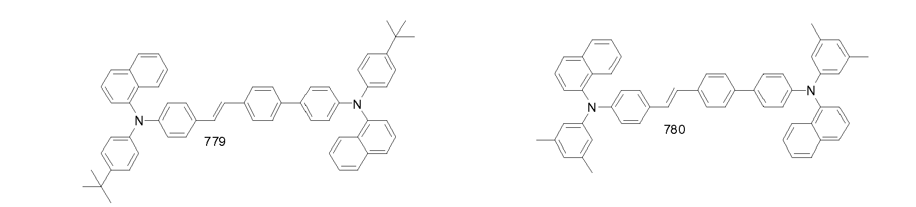

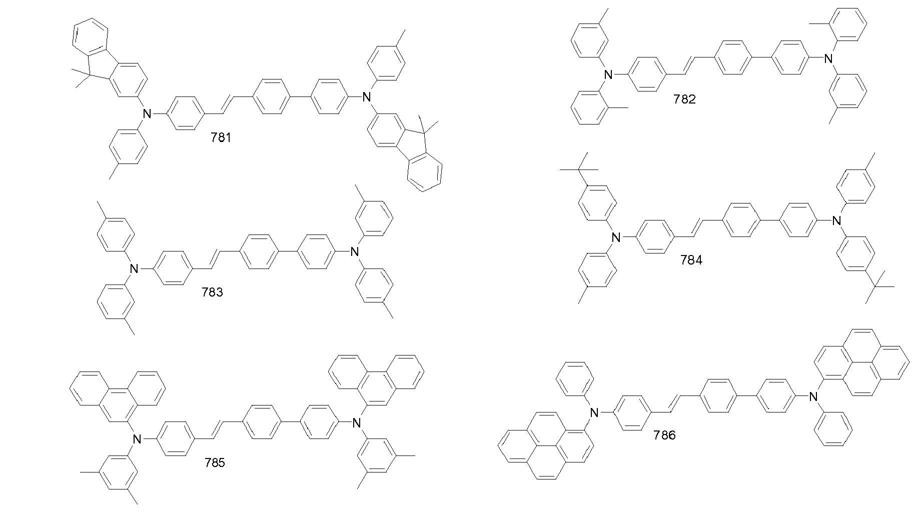

The host compound represented by Chemical Formula 2 or 3 may be exemplified by the compounds represented by Chemical Formulas 4 to 7: 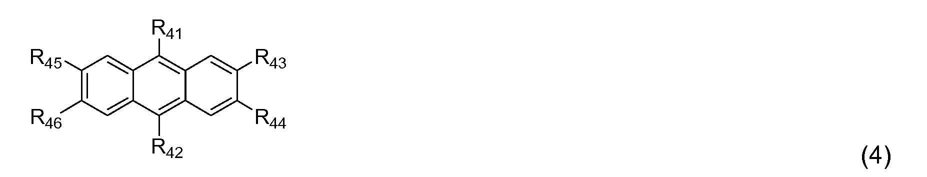 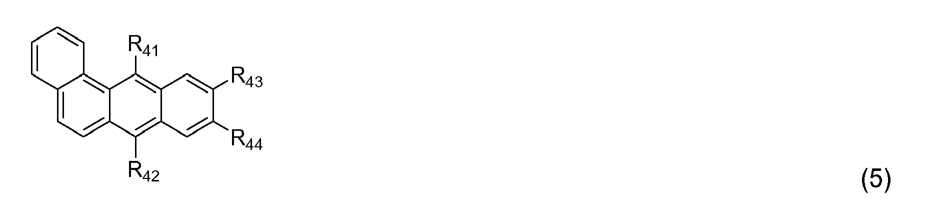 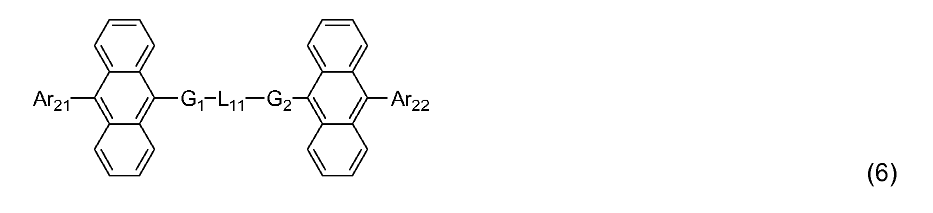 wherein
R₄₁ and R₄₂ independently represent (C6-C60)aryl, (C4-C60)heteroaryl, 5- or 6-membered heterocycloalkyl containing one or more heteroatom(s) selected from N, O and S or (C3-C60)cycloalkyl, and the aryl or heteroaryl of R₄₁ and R₄₂ may be further substituted by one or more substituent(s) selected from a group consisting of (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₄₃ through R₄₆ independently represent hydrogen, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₄₃ through R₄₆ may be further substituted by one or more substituent(s) selected from a group consisting of (C1-C60)alkyl with or without halogen substituent, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₂ₗ and Ar₂₂ independently represent (C4-C60)heteroaryl or aryl selected from the following structures: 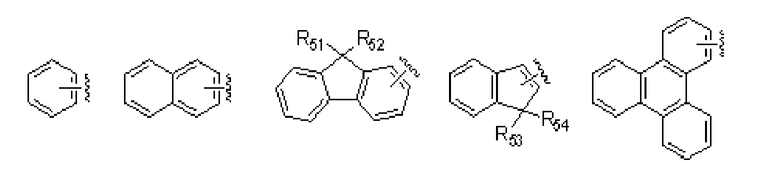 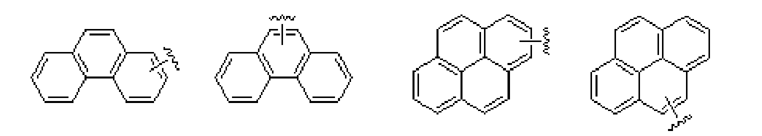 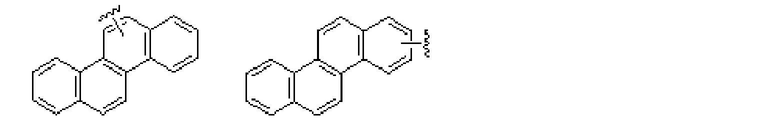 wherein
   the aryl or heteroaryl of Ar₂₁ and Ar₂₂ may be substituted by one or more substituent(s) selected from (C1-C60)alkyl, (C1-C60)alkoxy, (C6-C60)aryl and (C4-C60)heteroaryl;
   L₁₁ represents (C6-C60)arylene, (C4-C60)heteroarylene or a compound represented by the following structural formula: 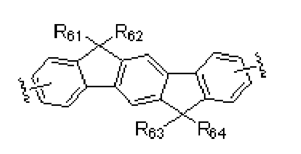
   wherein
   the arylene or heteroarylene of L₁₁ may be substituted by one or more substituent(s) selected from (C1-C60)alkyl, (C1-C60)alkoxy, (C6-C60)aryl, (C4-C60)heteroaryl and halogen;
   R₅₁ through R₅₄ independently represent hydrogen, (C1-C60)alkyl or (C6-C60)aryl, or each of them may be linked to an adjacent substituent via (C3-C60)alkylene or (C3-C60)alkenylene with or without a fused ring to form an alicyclic ring or a monocyclic or polycyclic aromatic ring;
   R₆₁ through R₆₄ independently represent hydrogen, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring or a monocyclic or polycyclic aromatic ring; 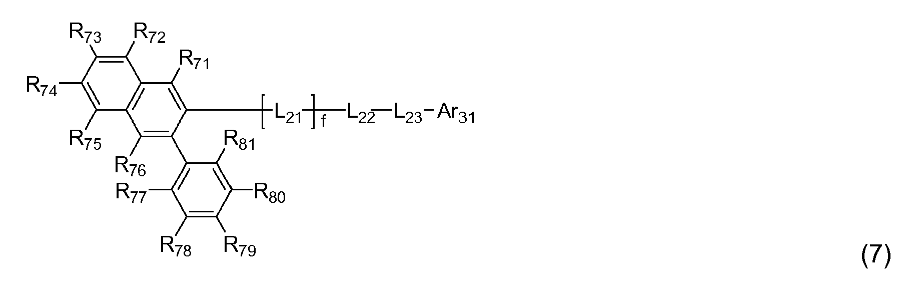 wherein
   L₂₁ represents (C6-C60)arylene, (C3-C60)heteroarylene containing one or more heteroatom(s) selected from N, O and S or a divalent group selected from the following structures:; 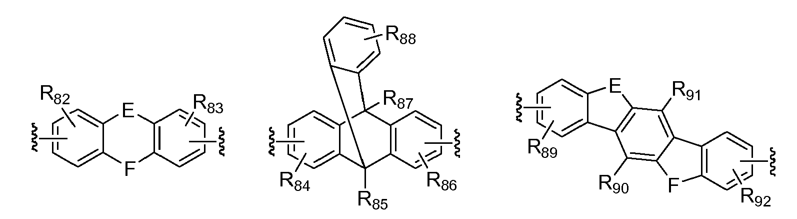 wherein
   L₂₂ and L₂₃ independently represent a chemical bond, (C1-C60)alkyleneoxy, (C1-C60)alkylenethio, (C6-C60)aryleneoxy, (C6-C60)arylenethio, (C6-C60)arylene or (C3-C60)heteroarylene containing one or more heteroatom(s) selected from N, O and S;
   Ar₃₁ represents NR₉₃R₉₄, (C6-C60)aryl, (C3-C60)heteroaryl containing one or more heteroatom(s) selected from N, O and S, 5- or 6-membered heterocycloalkyl containing one or more heteroatom(s) selected from N, O and S, (C3-C60)cycloalkyl, adamantyl, (C7-C60)bicycloalkyl or a substituent selected from the following structures: 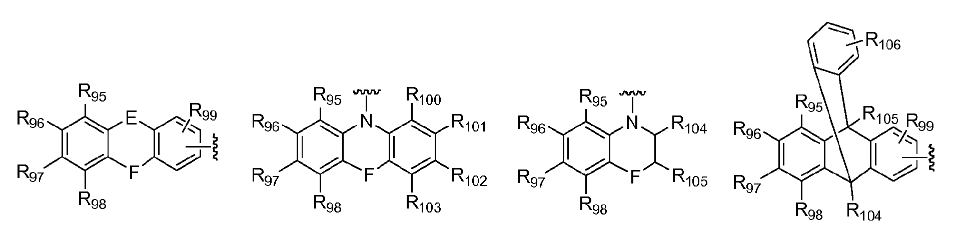 wherein
   R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₇₁ through R₈₁ may be linked to an adjacent substituent via (C3-C60)alkylene or (C3-C60)alkenylene with or without a fused ring to form an alicyclic ring or a monocyclic or polycyclic aromatic ring;
   R₈₂ through R₉₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyhydroxy, or each of R₈₂ through R₉₂ may be linked to an adjacent substituent via (C3-C60)alkylene or (C3-C60)alkenylene with or without a fused ring to form an alicyclic ring or a monocyclic or polycyclic aromatic ring;
   R₉₃ and R₉₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or R₉₃ and R₉₄ may be linked via (C3-C60)alkylene or (C3-C60)alkenylene with or without a fused ring to form an alicyclic ring or a monocyclic or polycyclic aromatic ring;
   R₉₅ through R₁₀₆ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₉₅ through R₁₀₆ may be linked to an adjacent substituent via (C3-C60)alkylene or (C3-C60)alkenylene with or without a fused ring to form an alicyclic ring or a monocyclic or polycyclic aromatic ring;
   E and F independently represent a chemical bond, -(CR₁₀₇R107₁₀₂)_{g}-, -N(R₁₀₃)-, -S-, -O-, -Si(R₁₀₄)(R₁₀₅)-, -P(R₁₀₆)-, -C(=O)-, -B(R₁₀₇)-, -In(R₁₀₈)-, -Se-, -Ge(R₁₀₉)(R₁₁₀)-, -Sn(R₁₁₁)(R₁₁₂)-, -Ga(R₁₁₃)- or -(R₁₁₄)C-C(R₁₁₅)-;
   R₁₀₇ through R₁₁₅ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or R₁₀₁ and R₁₀₂, R₁₀₄ and R₁₀₅, R₁₀₉ and R₁₁₀, R₁₁₁ and R₁₁₂, and R₁₁₄ and R₁₁₅ may be linked via (C3-C60)alkylene or (C3-C60)alkenylene with or without a fused ring to form an alicyclic ring or a monocyclic or polycyclic aromatic ring;
   the arylene or heteroarylene of L₂₁ through L₂₃, the aryl or heteroaryl of Ar₃₁, or the alkyl, aryl, heteroaryl, heterocycloalkyl, cycloalkyl, trialkylsilyl, dialkylarylsilyl, triarylsilyl, alkenyl, alkynyl, alkylamino or arylamino of R₇₁ through R₈₁, R₈₂ through R₉₂, R₉₃, R₉₄, R₉₅ through R₁₀₆ or R₁₀₇ through R₁₁₅ may be independently further substituted by one or more substituent(s) selected from deuterium, halogen, (C1-C60)alkyl, halo(C1-C60)alkyl, (C6-C60)aryl, (C3-C60)heteroaryl containing one or more heteroatom(s) selected from N, O and S with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro, hydroxy, 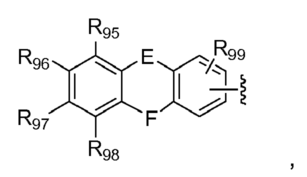 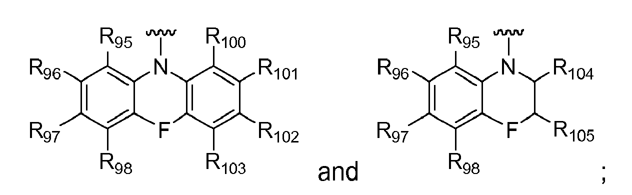
   g represents an integer from 1 to 4; and
   f represents an integer from 1 to 4.

Specifically, the host compounds represented by Chemical Formulas 4 to 7 may be exemplified by the following compounds, but not limited thereto.

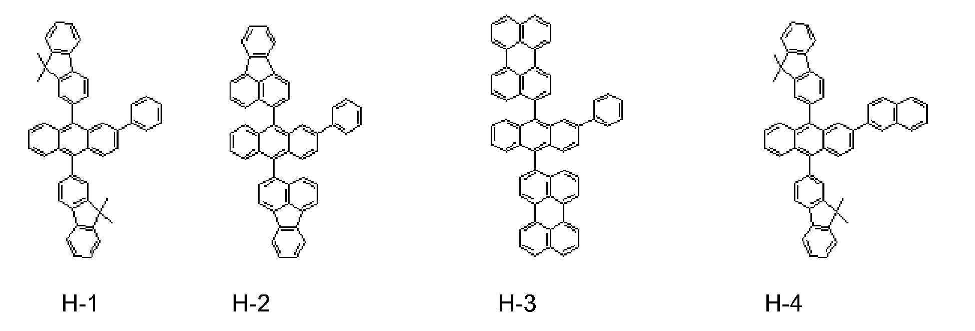

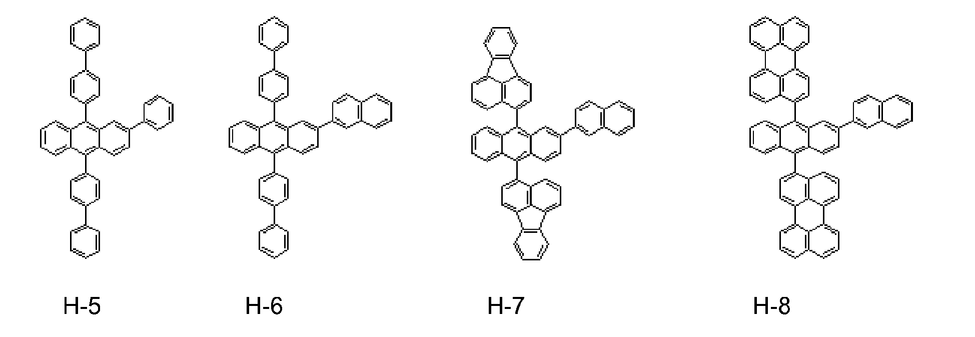

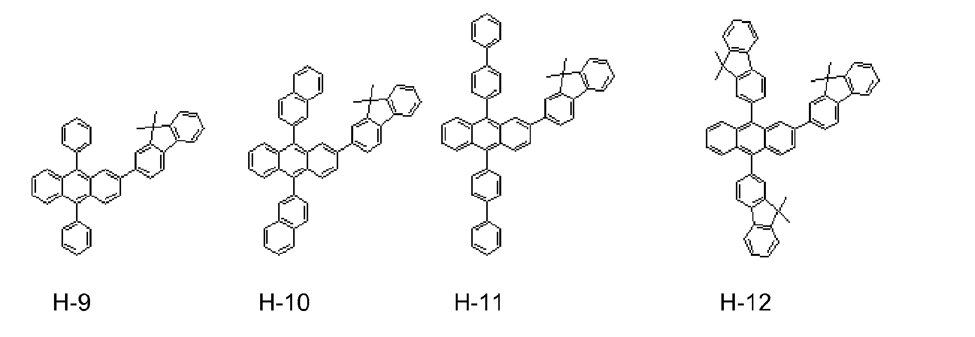

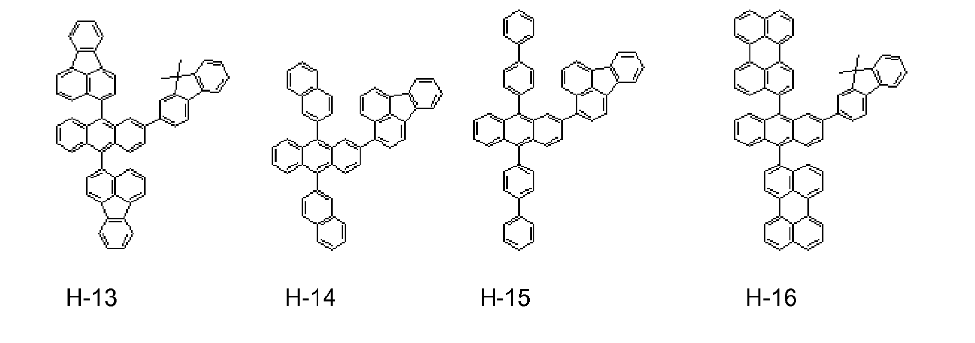

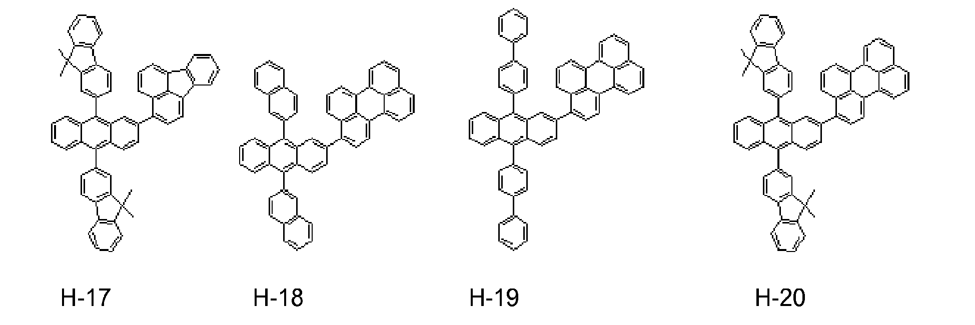

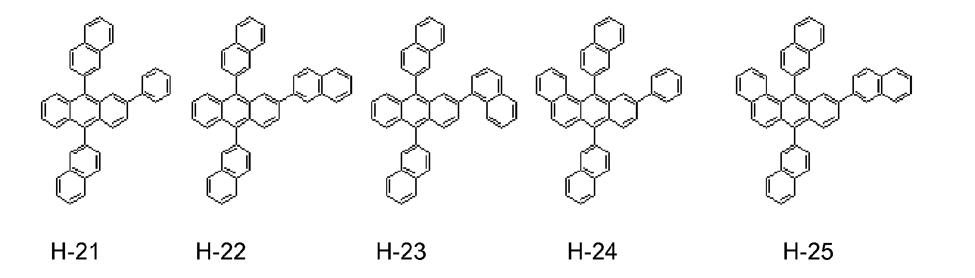

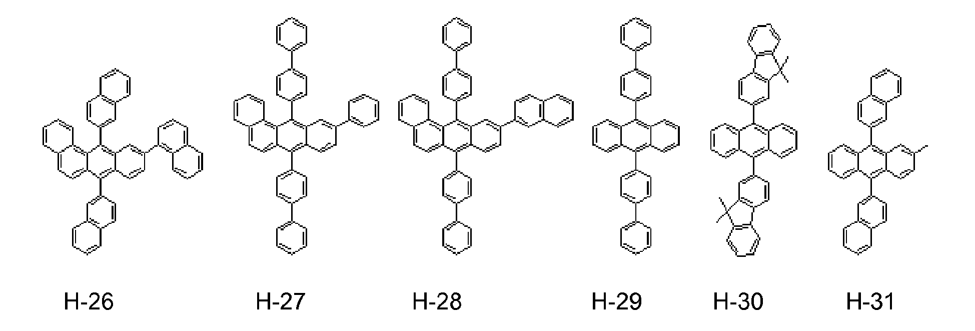

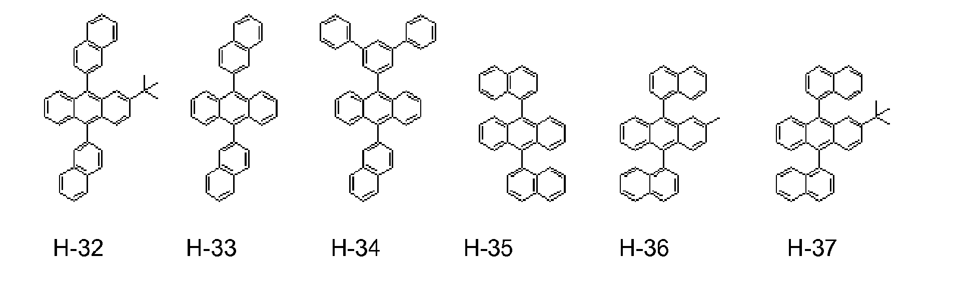

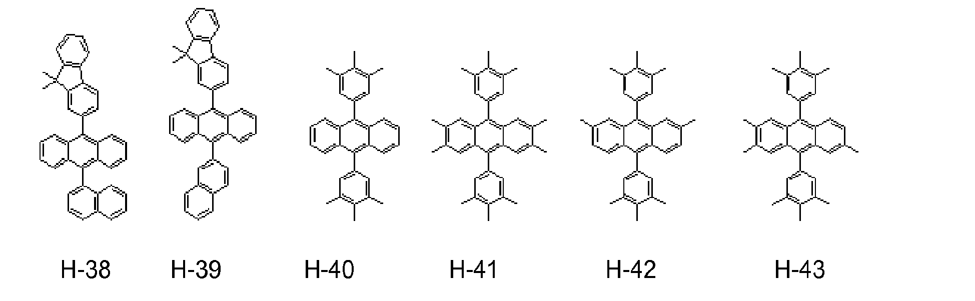

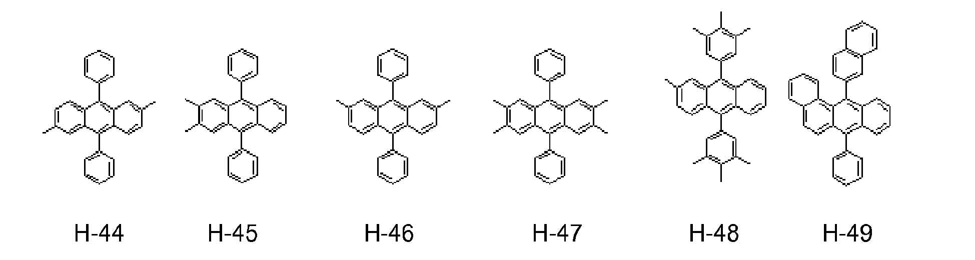

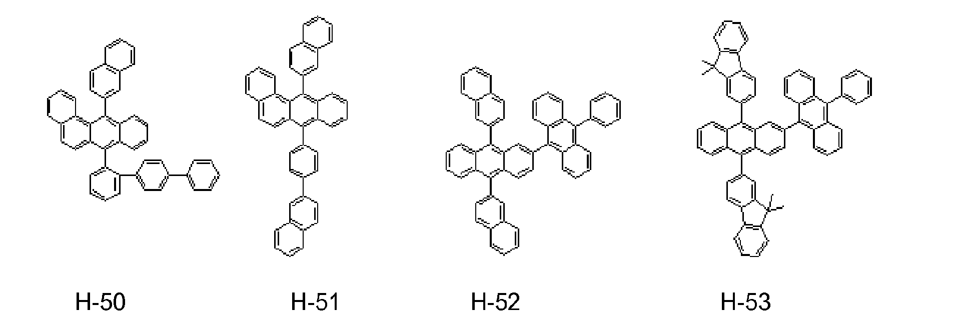

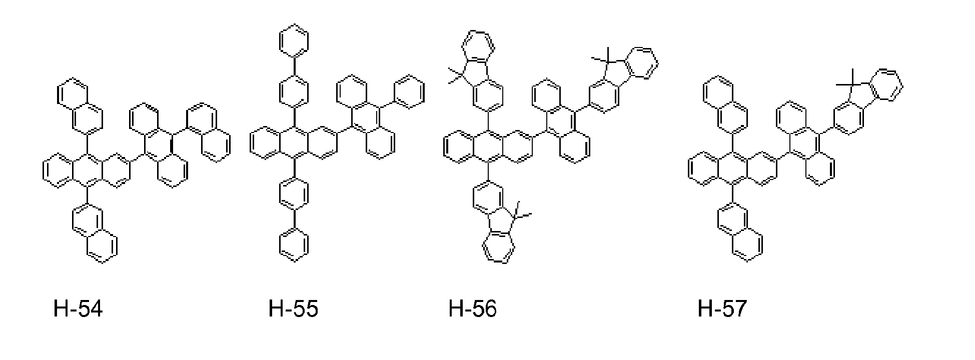

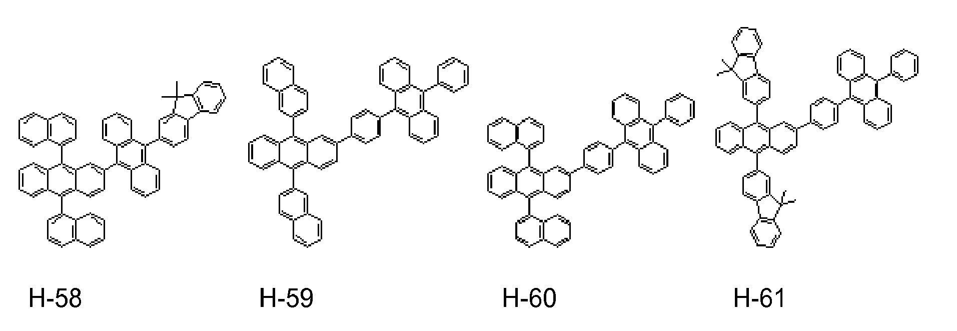

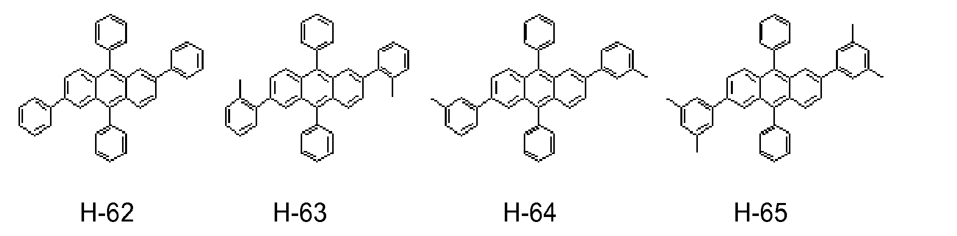

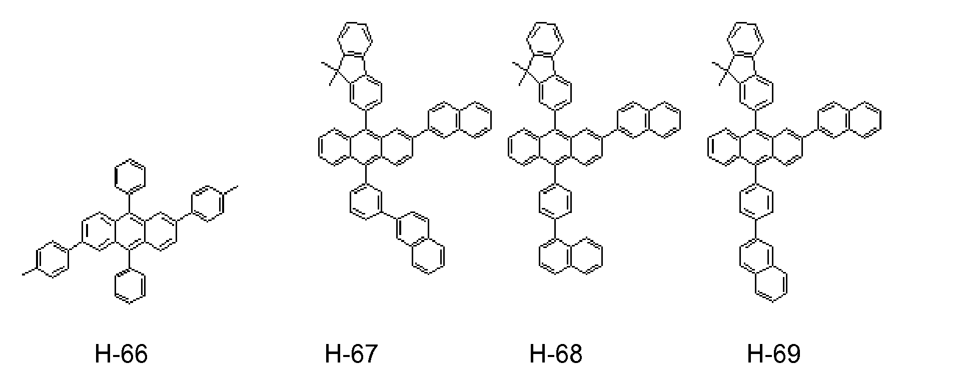

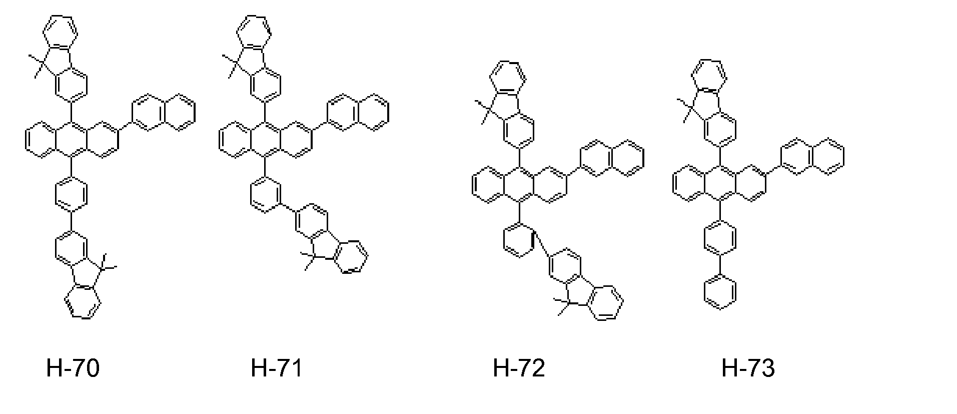

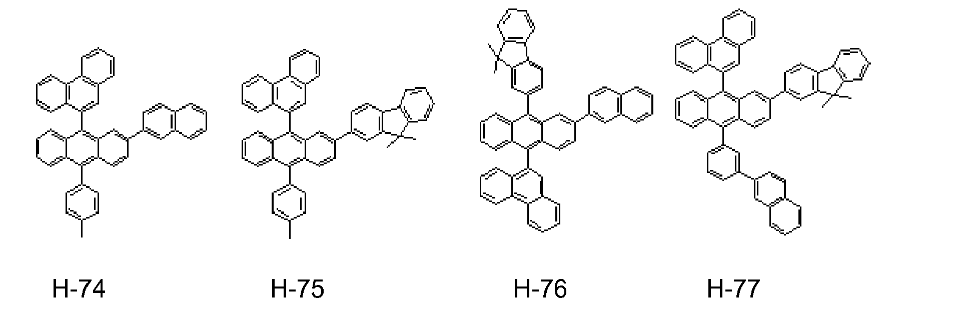

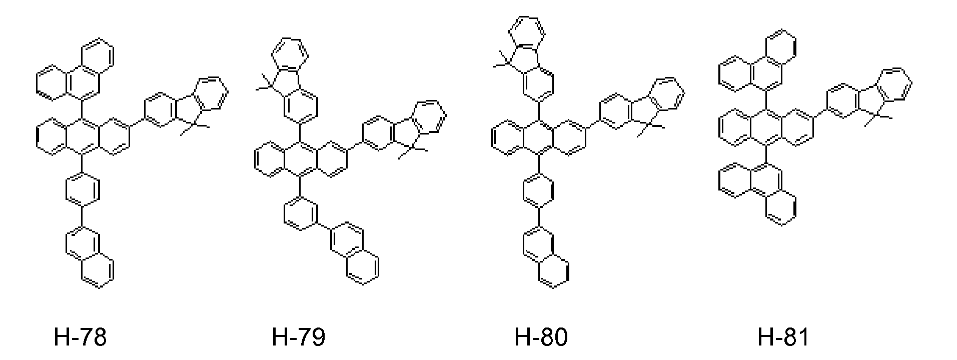

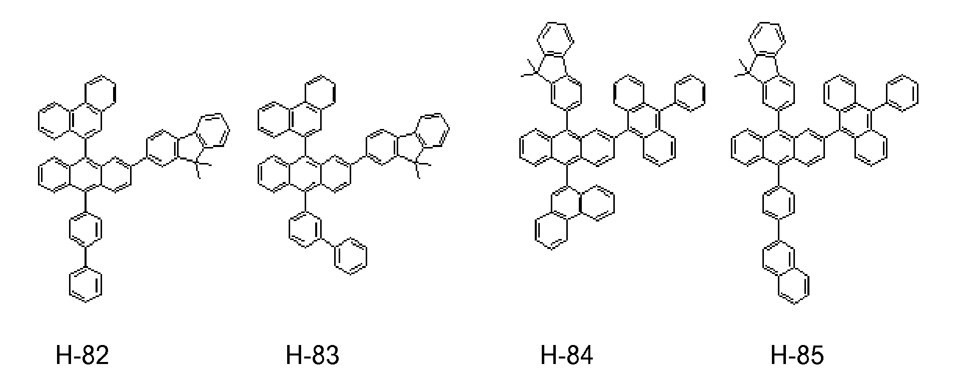

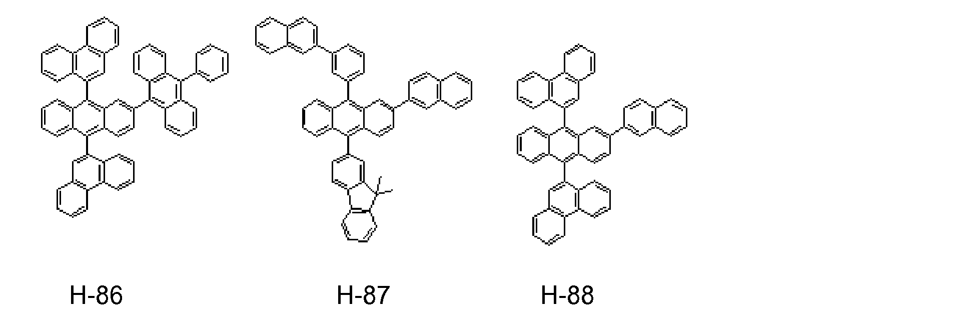

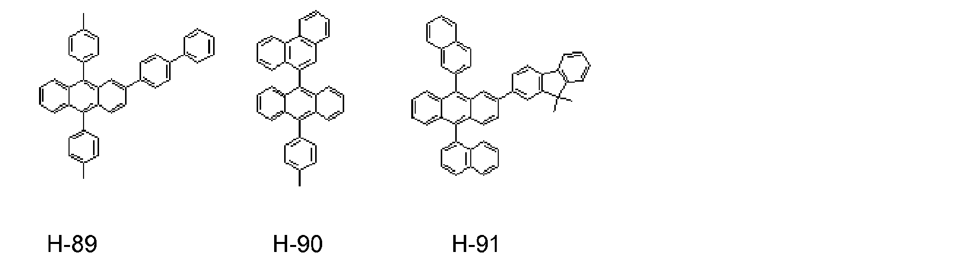

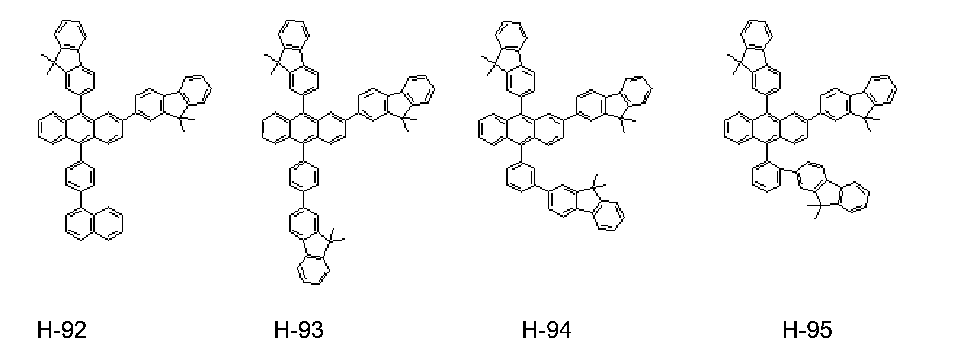

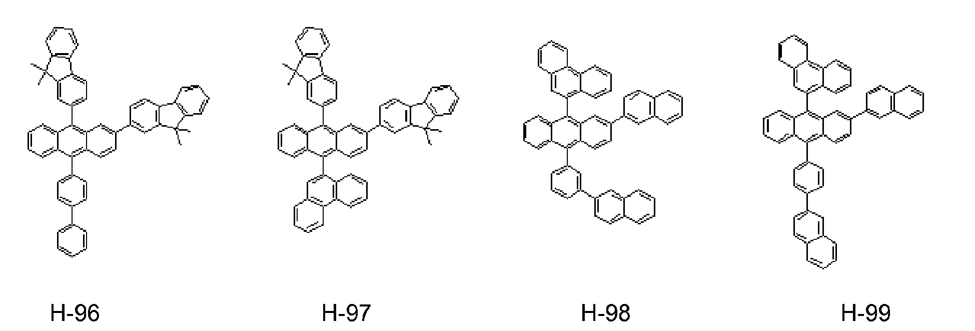

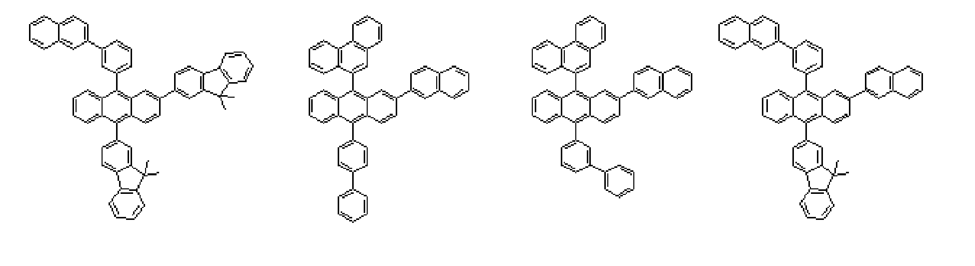

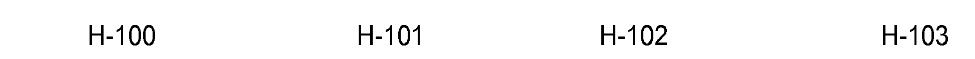

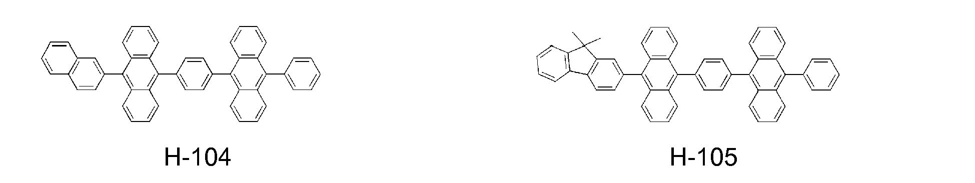

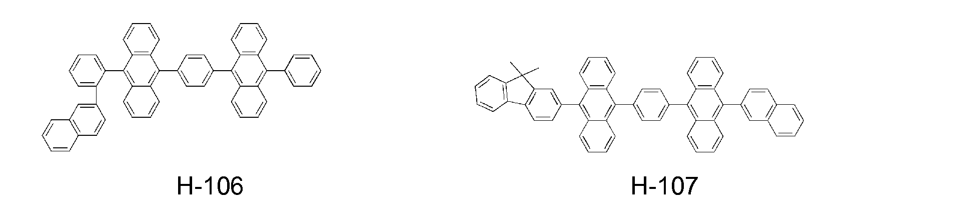

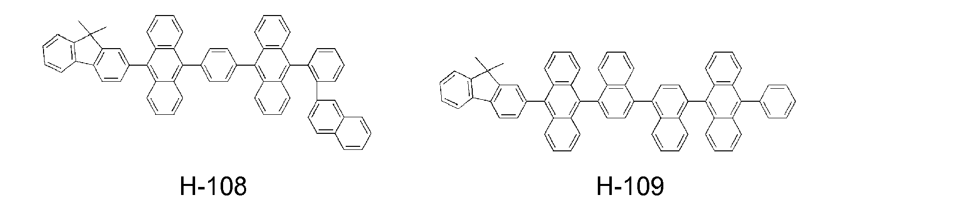

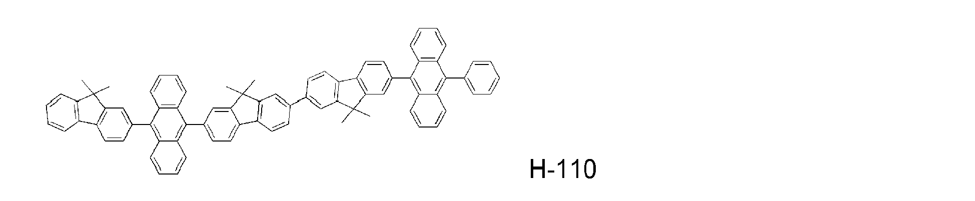

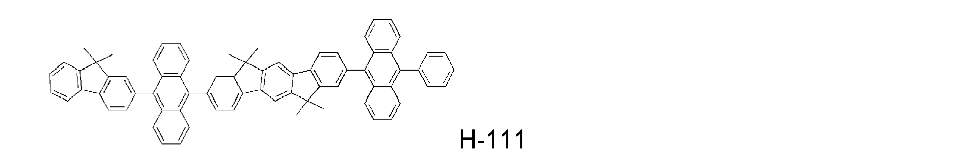

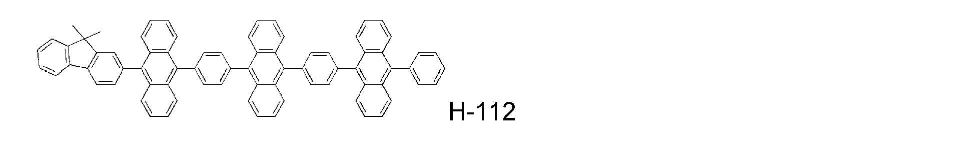

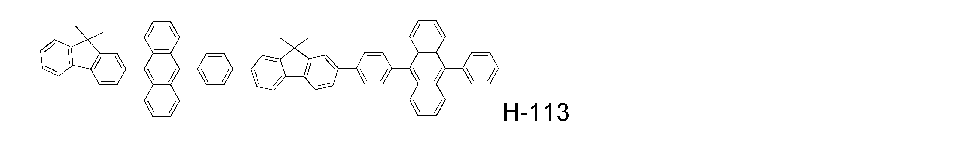

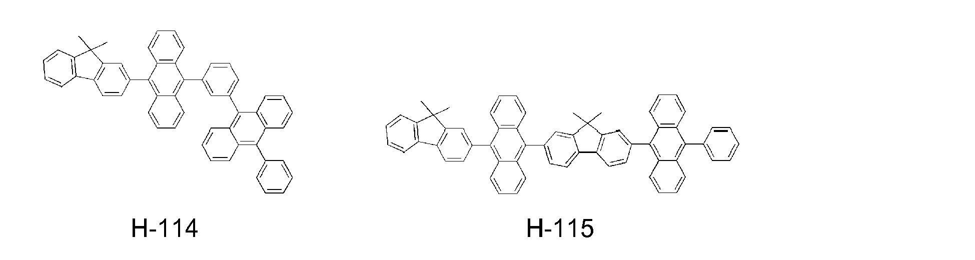

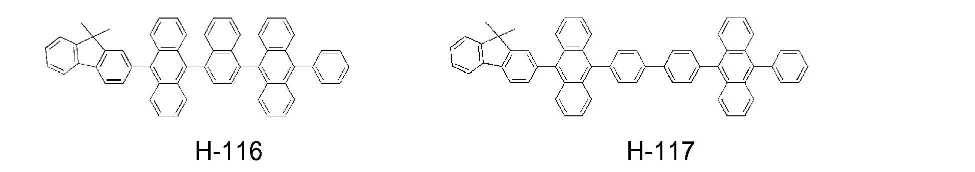

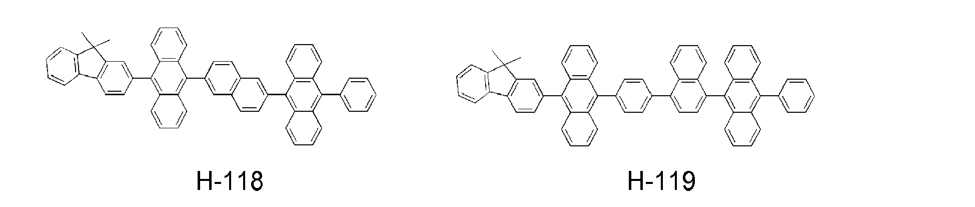

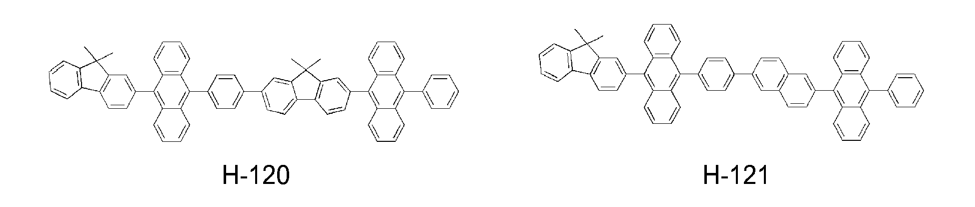

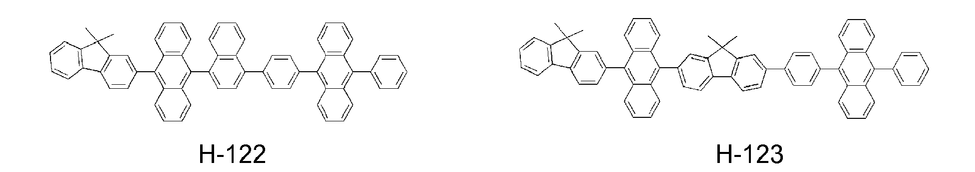

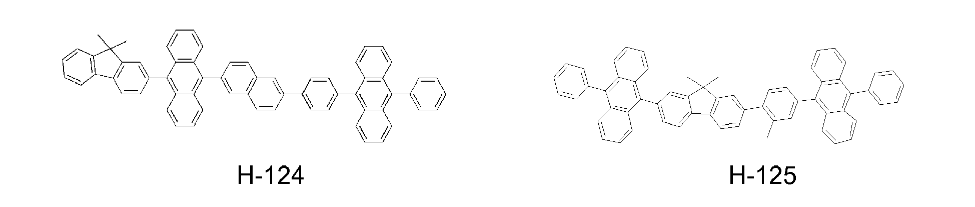

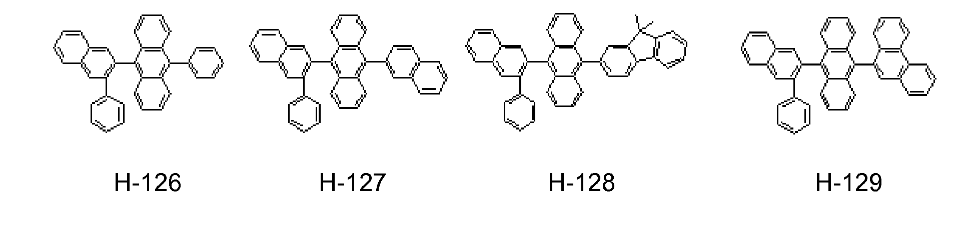

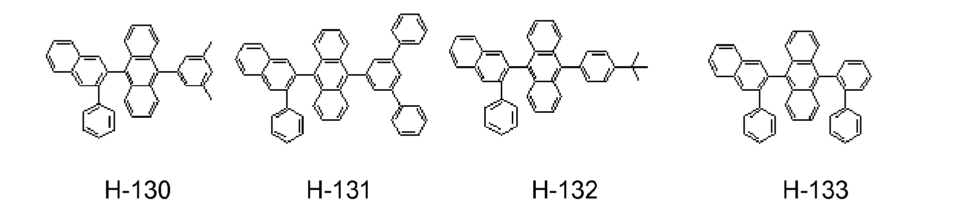

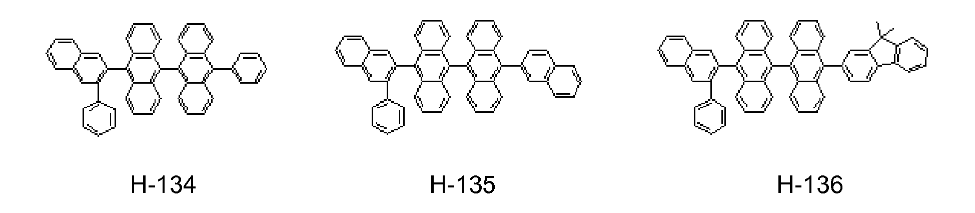

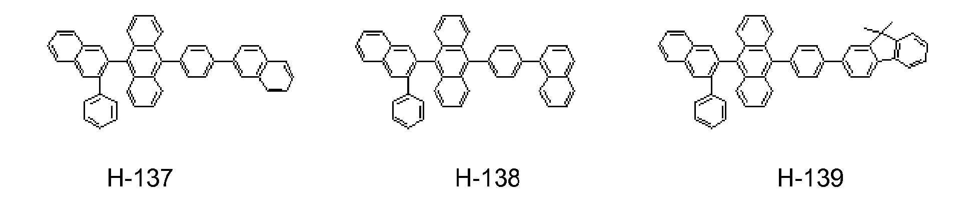

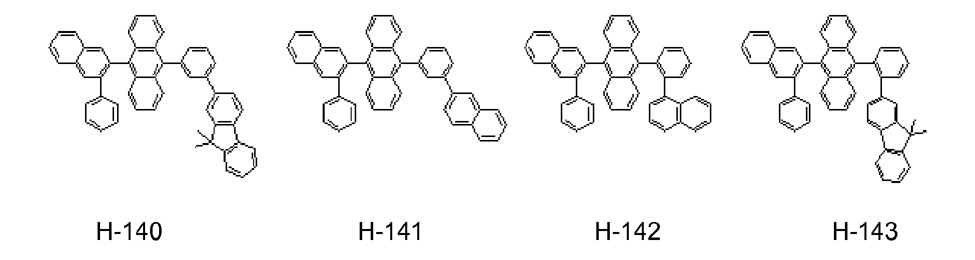

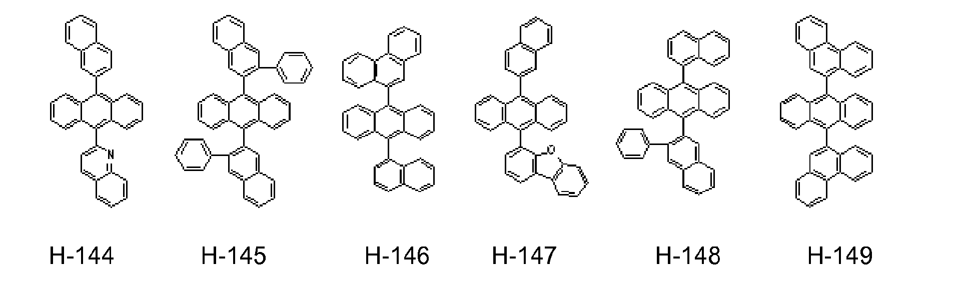

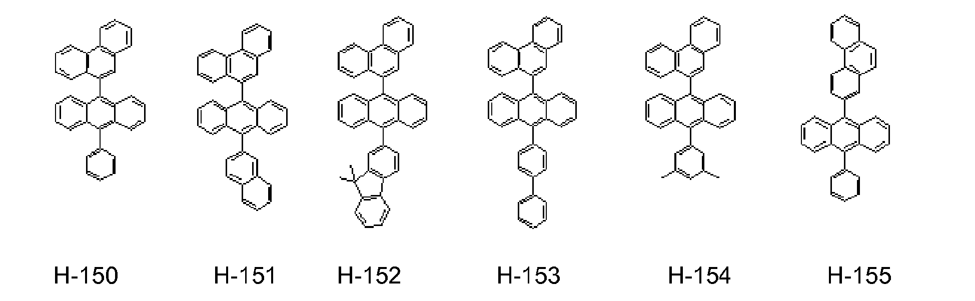

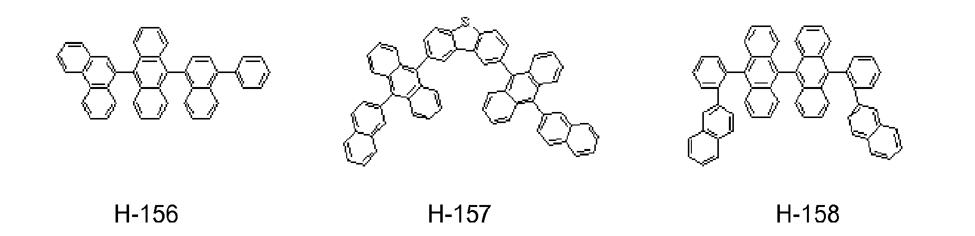

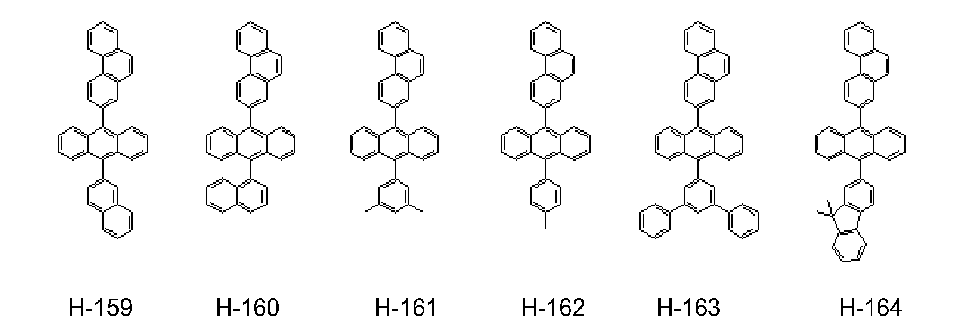

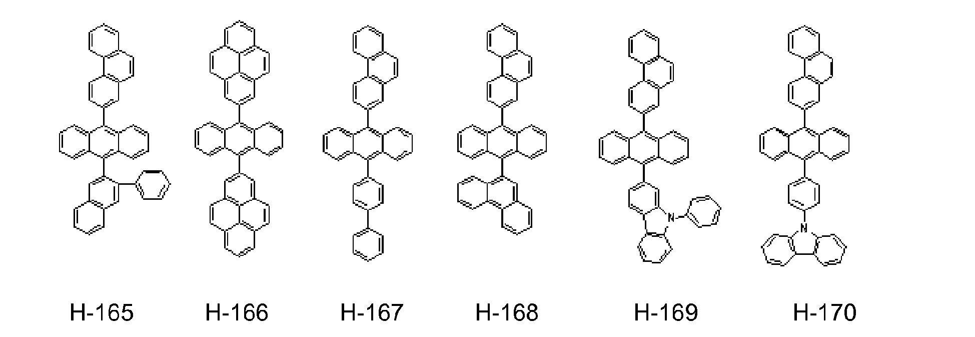

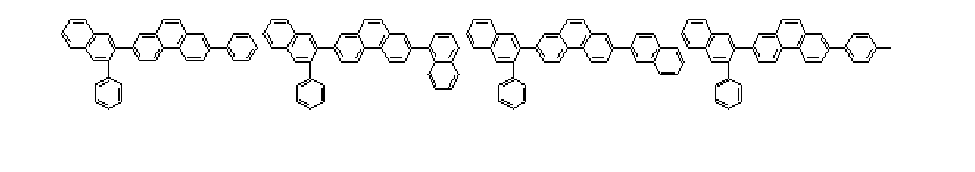

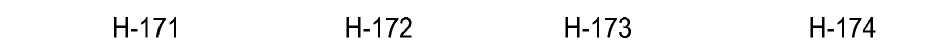

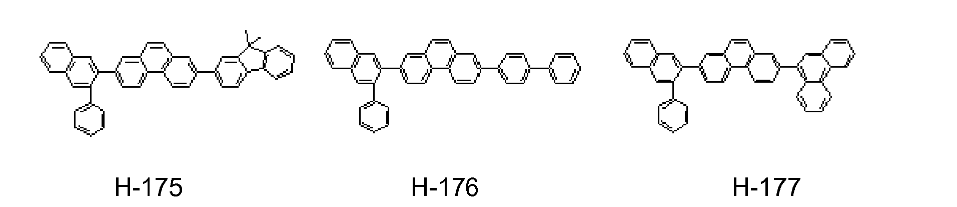

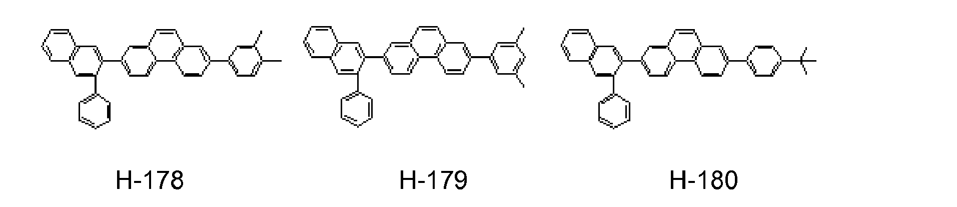

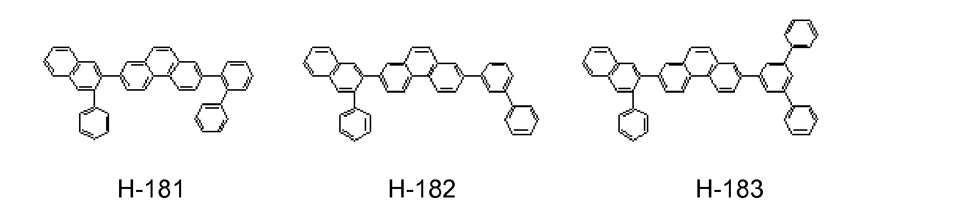

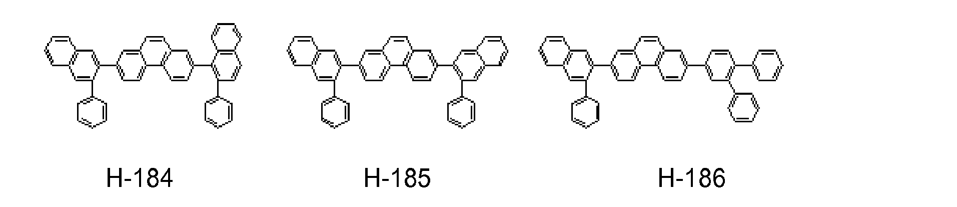

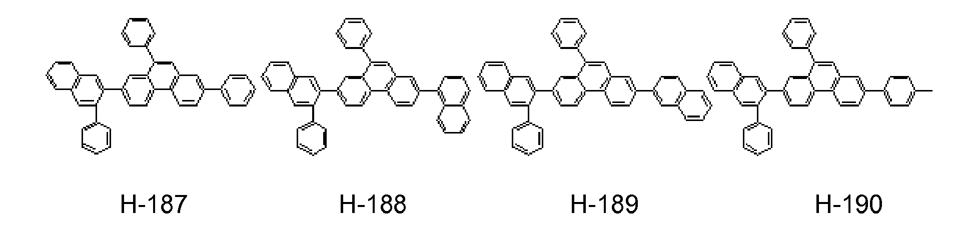

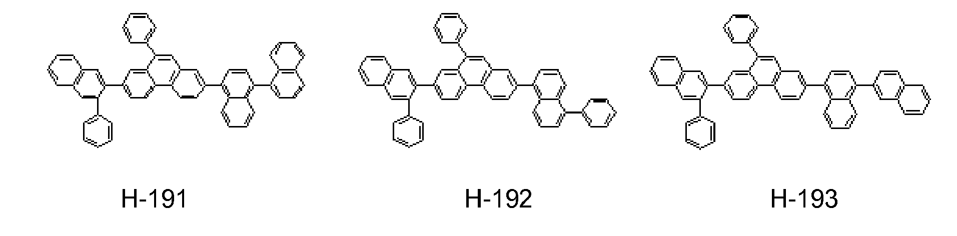

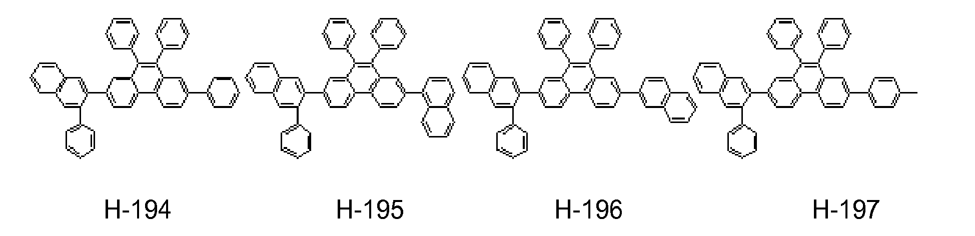

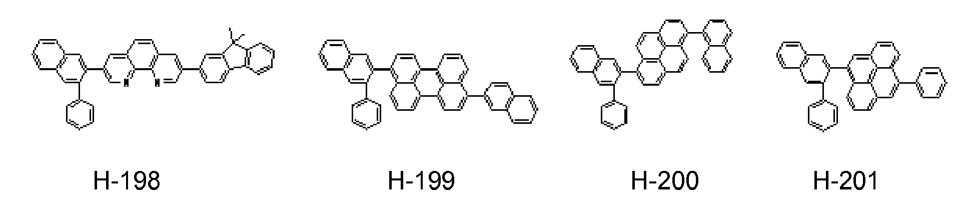

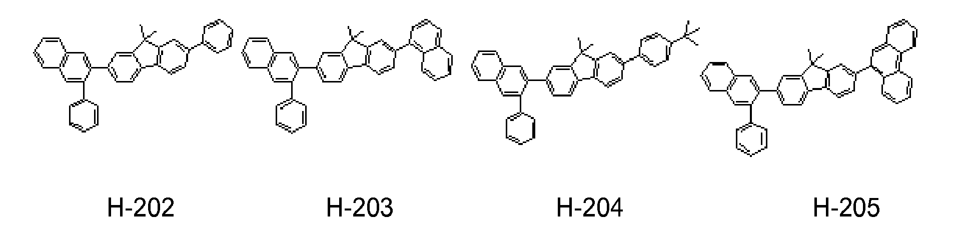

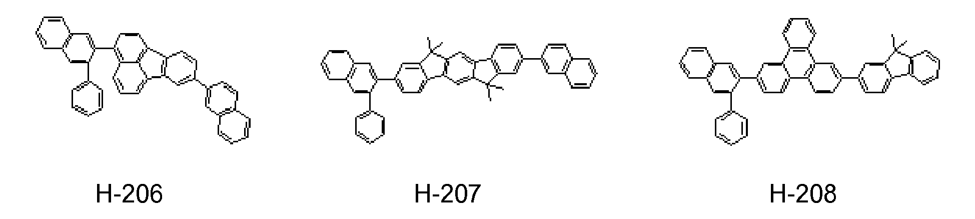

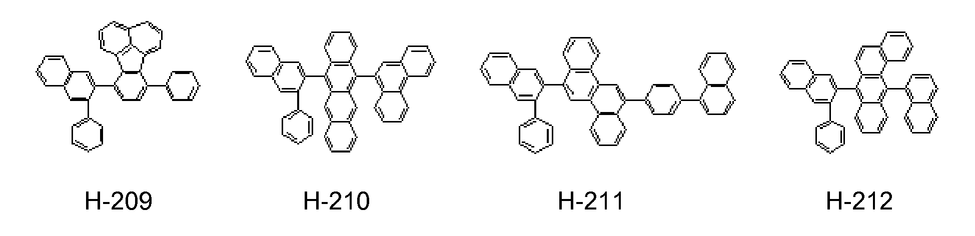

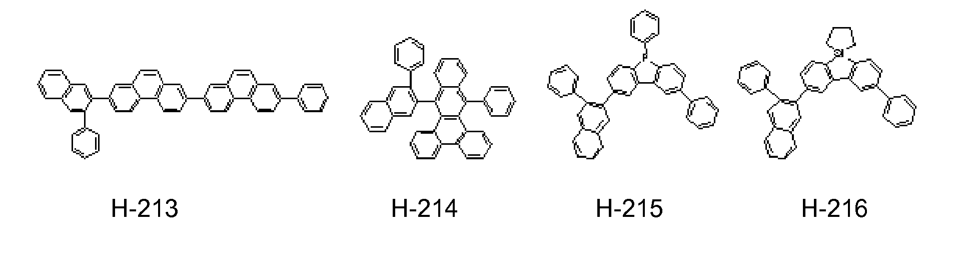

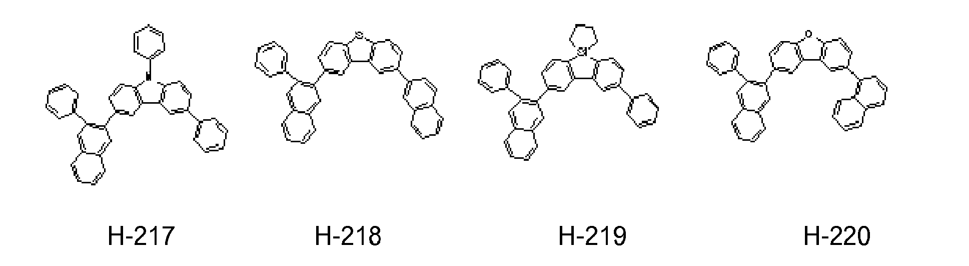

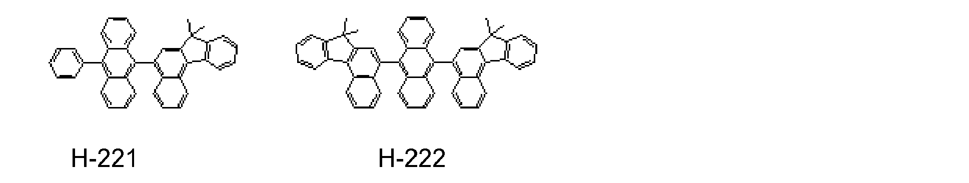

The electroluminescent layer means a layer where electroluminescence occurs. It may be either a single layer or may comprise two or more layers. In case a dopant and a host are used together in accordance with the present invention, remarkable improvement in luminous efficiency may be attained by adjusting the proportion of the cis-form and the trans-form of the dopant represented by Chemical Formula 1.

The electroluminescent device according to the present invention comprises the electroluminescent compound represented by Chemical Formula 1 and may further comprise one or more compound(s) selected from a group consisting of arylamine compounds and styrylamine compounds at the same time. For example, the arylamine compound or the styrylarylamine compound may be a compound represented by Chemical Formula 8, but not limited thereto: 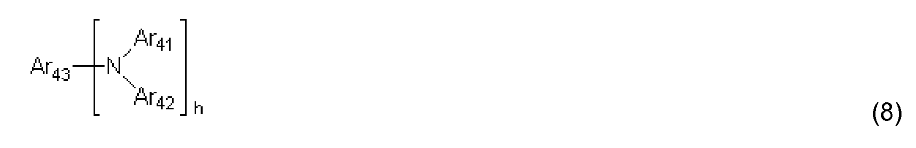 wherein
Ar₄₁ and Ar₄₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S or (C3-C60)cycloalkyl, and Ar₄₁ and Ar₄₂ may be linked via (C3-C60)alkylene or (C3-C60)alkenylene with or without a fused ring to form an alicyclic ring or a monocyclic or polycyclic aromatic ring;
Ar₄₃ represents (C6-C60)aryl, (C4-C60)heteroaryl or a substituent selected from the following structures, when h is 1: 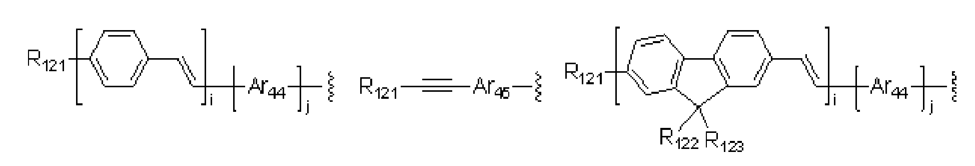
Ar₄₃ represents (C6-C60)arylene, (C4-C60)heteroarylene or a substituent selected from the following structures, when h is 2: 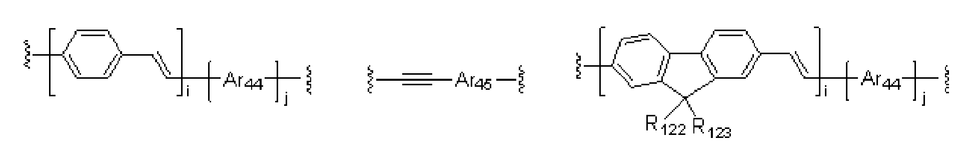
Ar₄₄ and Ar₄₅ independently represent (C6-C60)arylene or (C4-C60)heteroarylene;
R₁₂₁ through R₁₂₃ independently represent hydrogen, deuterium, (C1-C60)alkyl or (C6-C60)aryl;
i represents an integer from 1 to 4;
j represents an integer 0 or 1; and
the alkyl, aryl, heteroaryl, arylamino, alkylamino, cycloalkyl or heterocycloalkyl of Ar₄₁ and Ar₄₂, the aryl, heteroaryl, arylene or heteroarylene of Ar₄₃, the arylene or heteroarylene of Ar₄₄ and Ar₄₅, or the alkyl or aryl of R₁₂₁ through R₁₂₃ may be further substituted by one or more substituent(s) selected from a group consisting of deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxy.

More specifically, the arylamine compound or the styrylarylamine compound may be exemplified by the following compounds, but not limited thereto:

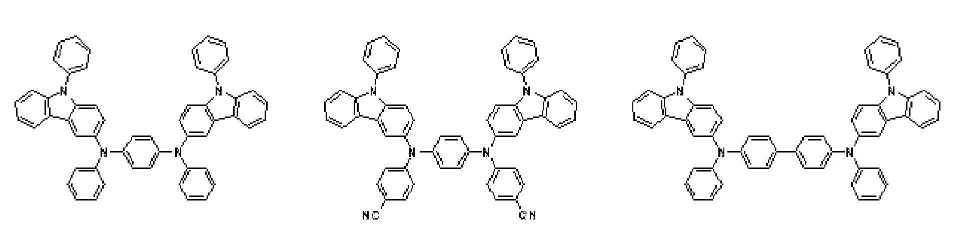

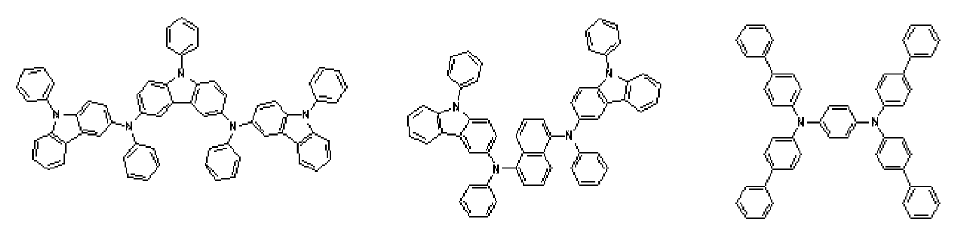

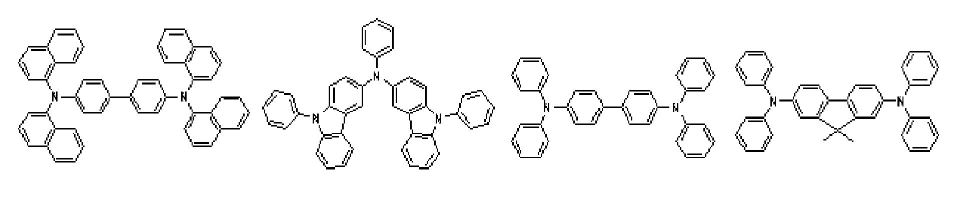

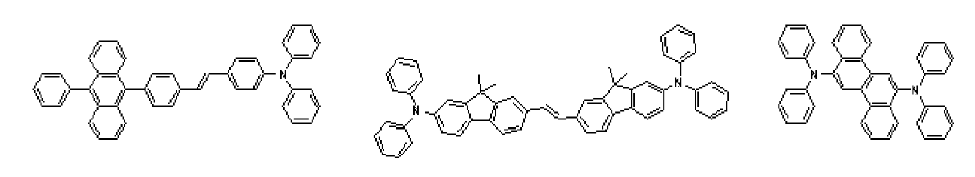

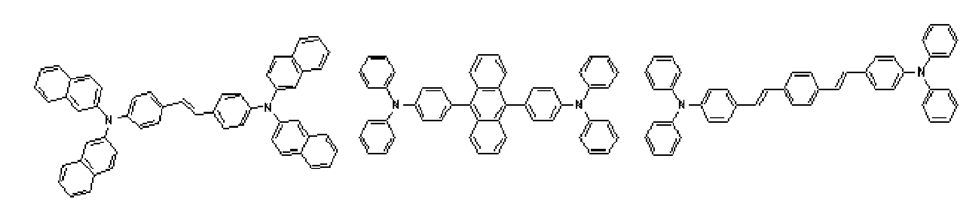

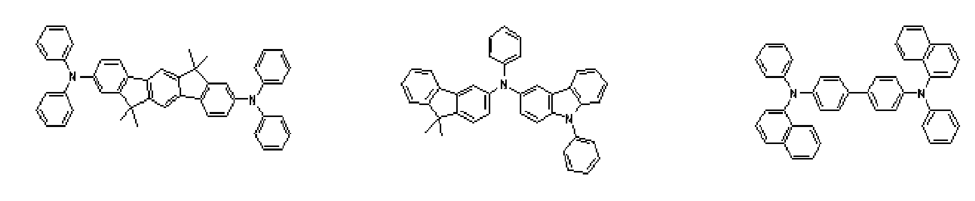

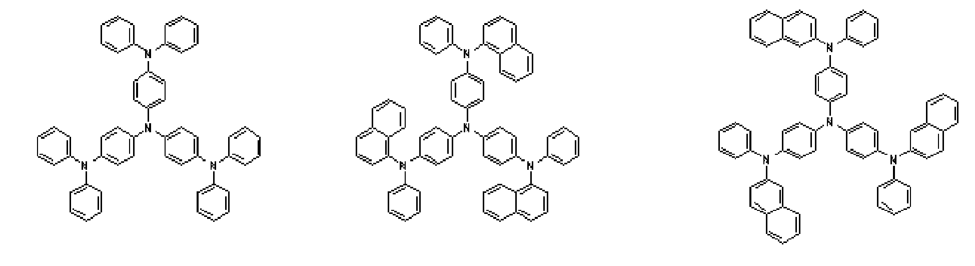

In the electroluminescent device according to the present invention, the organic layer may further comprise, in addition to the electroluminescent compound represented by Chemical Formula 1, one or more metal(s) selected from a group consisting of organic metals of Group 1, Group 2, 4th period and 5th period transition metals, lanthanide metals and d-transition elements. Also, the organic layer may comprise an electroluminescent layer and a charge generating layer at the same time.

An independent electroluminescence type electroluminescent device having a pixel structure in which the electroluminescent device according to the present invention comprising the electroluminescent compound represented by Chemical Formula 1 is used as a subpixel and one or more subpixel(s) comprising one or more metal compound(s) selected from a group consisting of lr, Pt, Pd, Rh, Re, Os, TI, Pb, Bi, In, Sn, Sb, Te, Au and Ag is patterned in parallel may be manufactured.

The organic layer may further comprise, in addition to the electroluminescent compound, one or more compound(s) selected from a compound having an electroluminescence peak with wavelength of 500 to 560 nm and a compound having an electroluminescence peak with wavelength of not less than 560 nm to form a white electroluminescent device. The compound having an electroluminescence peak with wavelength of 500 to 560 nm or the compound having an electroluminescence peak with wavelength of not less than 560 nm may be exemplified by the compounds represented by Chemical Formulas 9 to 15, but not limited thereto:

**M¹L¹⁰¹L¹⁰²L¹⁰³** (9)

wherein
M¹ is a metal selected from a group consisting of Group 7, Group 8, Group 9, Group 10, Group 11, Group 13, Group 14, Group 15 and Group 16 metals;
ligands L¹⁰¹, L¹⁰² and L¹⁰³ are independently selected from the following structures: 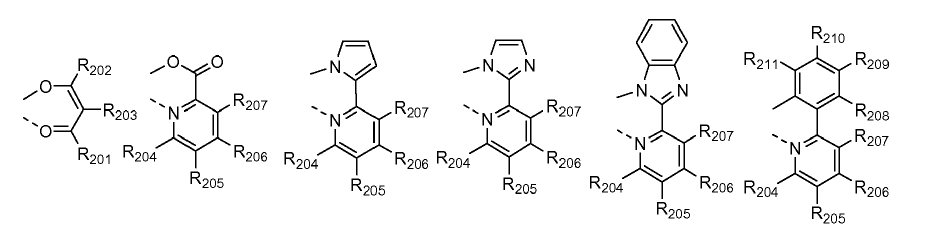 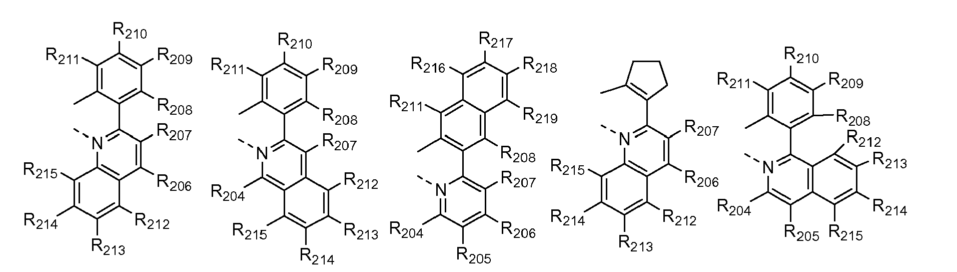 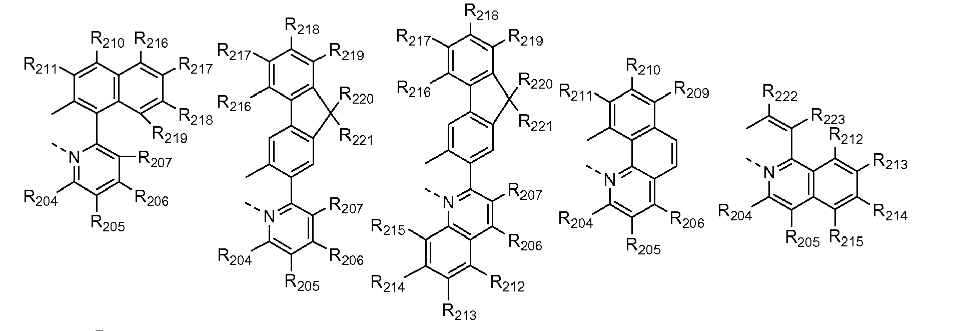 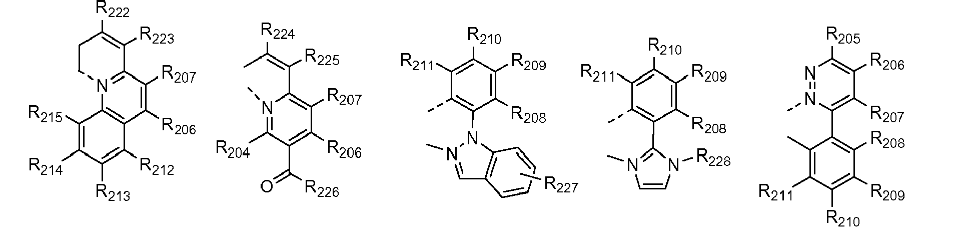 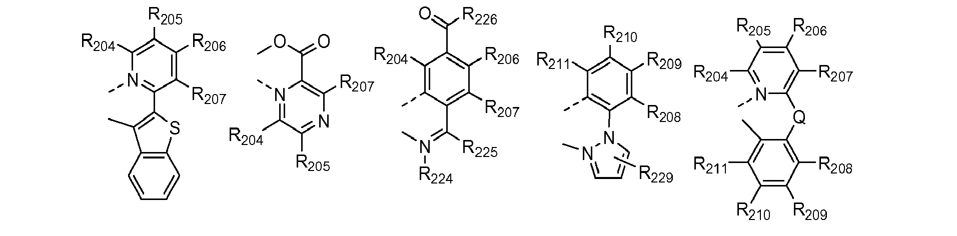 wherein
R₂₀₁ through R₂₀₃ independently represent hydrogen, deuterium, (C1-C60)alkyl with or without halogen substituent, (C6-C60)aryl with or without (C1-C60)alkyl substituent or halogen;
R₂₀₄ through R₂₁₉ independently represent hydrogen, deuterium, (C1-C60)alkyl, (C1-C30)alkoxy, (C3-C60)cycloalkyl, (C2-C30)alkenyl, (C6-C60)aryl, mono- or di(C1-C30)alkylamino, mono- or di(C6-C30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₂₀₄ through R₂₁₉ may be further substituted by one or more substituent(s) selected from deuterium, (C1-C60)alkyl, (C6-C60)aryl and halogen;
R₂₂₀ through R₂₂₃ independently represent hydrogen, deuterium, (C1-C60)alkyl with or without halogen substituent or (C6-C60)aryl with or without (C1-C60)alkyl substituent;
R₂₂₄ and R₂₂₅ independently represent hydrogen, deuterium, (C1-C60)alkyl, (C6-C60)aryl or halogen, or R₂₂₄ and R₂₂₅ may be linked via (C3-C12)alkylene or (C3-C12)alkenylene with or without a fused ring to form an alicyclic ring or a monocyclic or polycyclic aromatic ring, and the alkyl or aryl of R₂₂₄ and R₂₂₅ or the alicyclic ring or the monocyclic or polycyclic aromatic ring formed as they are linked via (C3-C12)alkylene or (C3-C12)alkenylene with or without a fused ring may be further substituted by one or more substituent(s) selected from deuterium, (C1-C60)alkyl with or without halogen substituent, (C1-C30)alkoxy, halogen, tri(C1-C30)alkylsilyl, tri(C6-C30)arylsilyl and (C6-C60)aryl;
R₂₂₆ represents (C1-C60)alkyl, (C6-C60)aryl, (C5-C60)heteroaryl containing one or more heteroatom(s) selected from N, O and S or halogen;
R₂₂₇ through R₂₂₉ independently represent hydrogen, deuterium, (C1-C60)alkyl, (C6-C60)aryl or halogen, and the alkyl or aryl of R₂₂₆ through R₂₂₉ may be further substituted by halogen or (C1-C60)alkyl;
Q represents 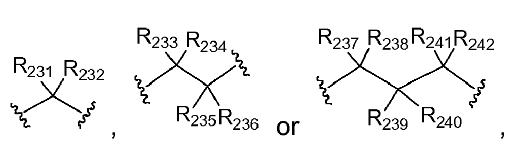 wherein R₂₃₁ through R₂₄₂ independently represent hydrogen, deuterium, (C1-C60)alkyl with or without halogen substituent, (C1-C30)alkoxy, halogen, (C6-C60)aryl, cyano or (C5-C60)cycloalkyl, or each of R₂₃₁ through R₂₄₂ may be linked to an adjacent substituent via alkylene or alkenylene to form a (C5-C7)spiro ring or a (C5-C9)fused ring, or linked to R₂₀₇ or R₂₀₈ via alkylene or alkenylene to form a (C5-C7)fused ring; 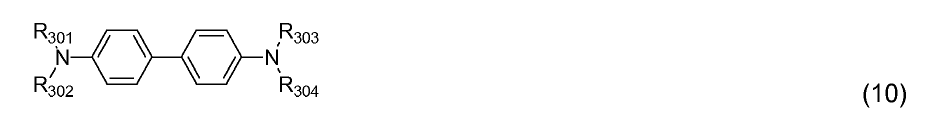 wherein
   R₃₀₁ through R₃₀₄ independently represent (C1-C60)alkyl or (C6-C60)aryl, or each of them may be linked to an adjacent substituent via (C3-C60)alkylene or (C3-C60)alkenylene with or without a fused ring to form an alicyclic ring or a monocyclic or polycyclic aromatic ring;
   the alkyl or aryl of R₃₀₁ through R₃₀₄ or the alicyclic ring or the monocyclic or polycyclic aromatic ring formed as they are linked via (C3-C60)alkylene or (C3-C60)alkenylene with or without a fused ring may be further substituted by one or more substituent(s) selected from (C1-C60)alkyl with or without halogen substituent, (C1-C60)alkoxy, halogen, tri(C1-C60)alkylsilyl, tri(C6-C60)arylsilyl and (C6-C60)aryl; 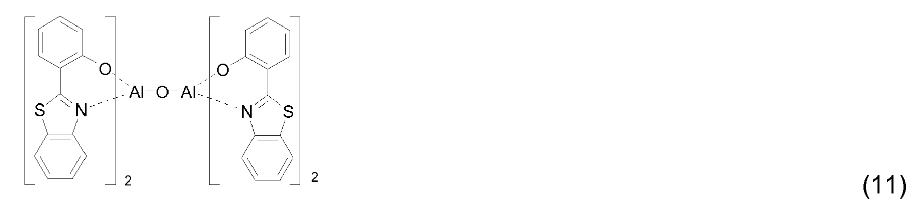 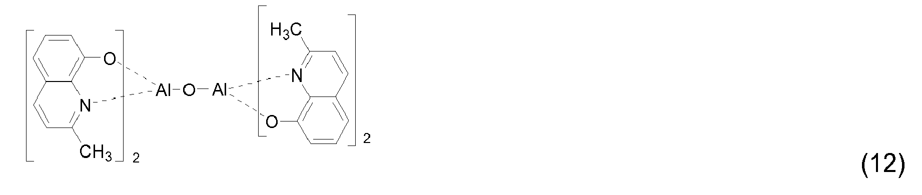 **L²⁰¹L²⁰²M²(T)ₖ** (13)

      wherein
   ligands L²⁰¹ and L²⁰² are independently selected from the following structures: 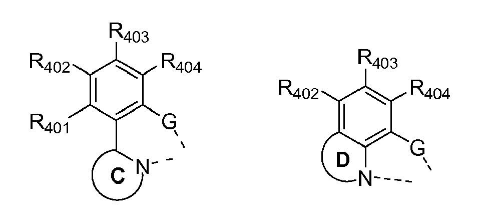 wherein
   M² represents a divalent or trivalent metal;
   k is 0 when M² is a divalent metal, and k is 1 when M² is a trivalent metal;
   T represents (C6-C60)aryloxy or tri(C6-C60)arylsilyl, and the aryloxy or triarylsilyl of T may be further substituted by (C1-C60)alkyl or (C6-C60)aryl;
   G represents O, S or Se;
   ring C represents oxazole, thiazole, imidazole, oxadiazole, thiadiazole, benzoxazole, benzothiazole, benzoimidazole, pyridine or quinoline;
   ring D represents pyridine or quinoline, and the ring D may be further substituted by (C1-C60)alkyl, phenyl with or without (C1-C60)alkyl substituent or naphthyl;
   R₄₀₁ through R₄₀₄ independently represent hydrogen, deuterium, (C1-C60)alkyl, halogen, tri(C1-C60)alkylsilyl, tri(C6-C60)arylsilyl or (C6-C60)aryl, or each of them may be linked to an adjacent substituent via (C3-C60)alkylene or (C3-C60)alkenylene to form a fused ring, and the pyridine or quinoline may be linked to R₅₀₁ via a chemical bond to form a fused ring;
   the aryl of ring C and R₄₀₁ through R₄₀₄ may be further substituted by (C1-C60)alkyl, halogen, (C1-C60)alkyl with halogen substituent, phenyl, naphthyl, tri(C1-C60)alkylsilyl, tri(C6-C60)arylsilyl or amino; 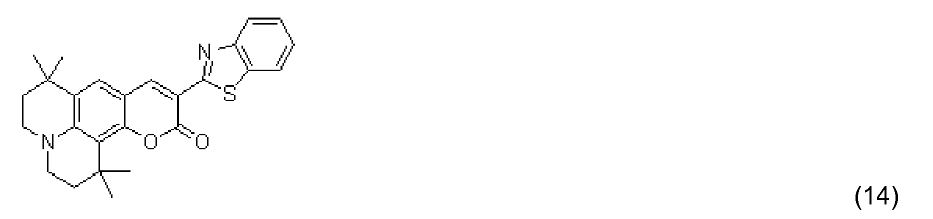 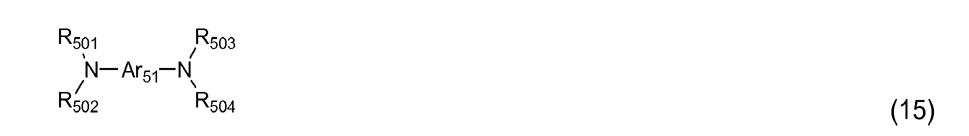 wherein
   Ar₅₁ represents (C6-C60)arylene with or without one or more substituent(s) selected from a group consisting of halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxy, and the alkyl, cycloalkyl, heterocycloalkyl, aryl, heteroaryl, arylsilyl, alkylsilyl, alkylamino or arylamino substituent of the arylene may be further substituted by one or more substituent(s) selected from halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxy;
   R₅₀₁ through R₅₀₄ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S or (C3-C60)cycloalkyl, or each of R₅₀₁ through R₅₀₄ may be linked to an adjacent substituent via (C3-C60)alkylene or (C3-C60)alkenylene with or without a fused ring to form an alicyclic ring or a monocyclic or polycyclic aromatic ring; and
   the alkyl, aryl, heteroaryl, arylamino, alkylamino, cycloalkyl or heterocycloalkyl of R₅₀₁ through R₅₀₄ may be further substituted by one or more substituent(s) selected from halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxy.

The compound having an electroluminescence peak with wavelength of 500 to 560 nm or the compound having an electroluminescence peak with wavelength of not less than 560 nm may be exemplified by the compounds represented by the following compounds, but not limited thereto:

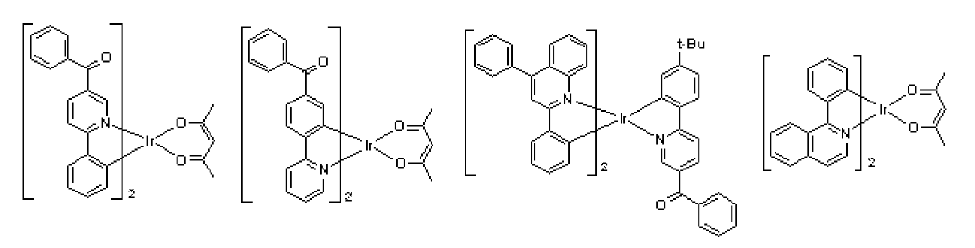

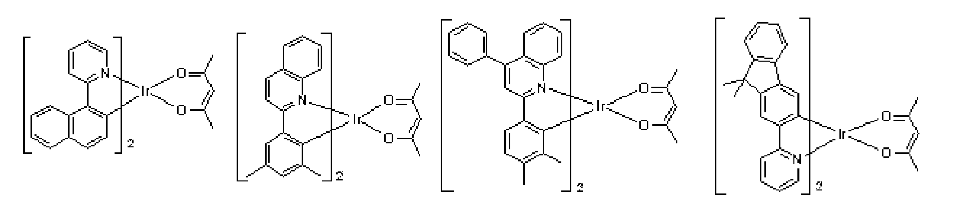

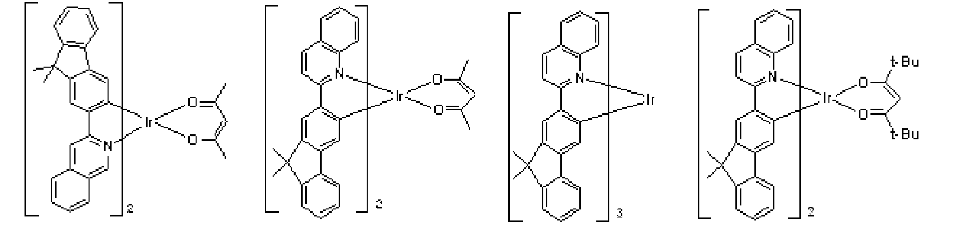

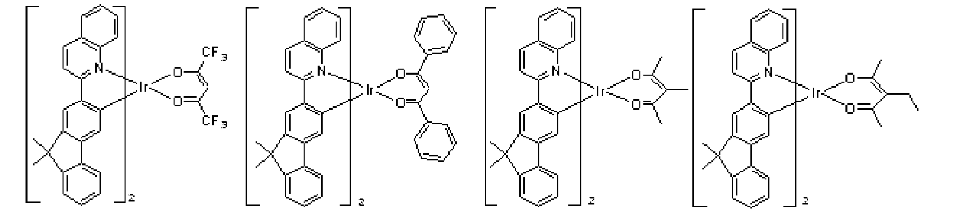

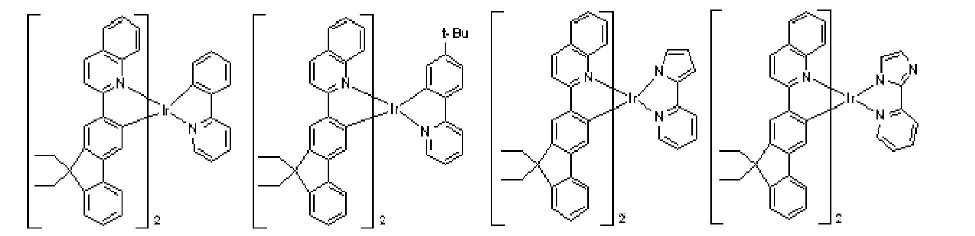

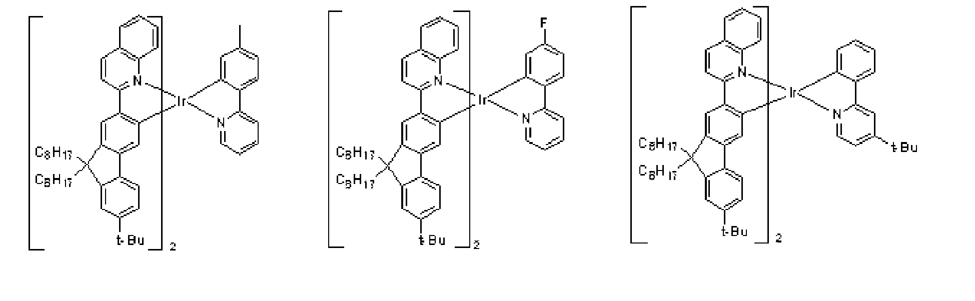

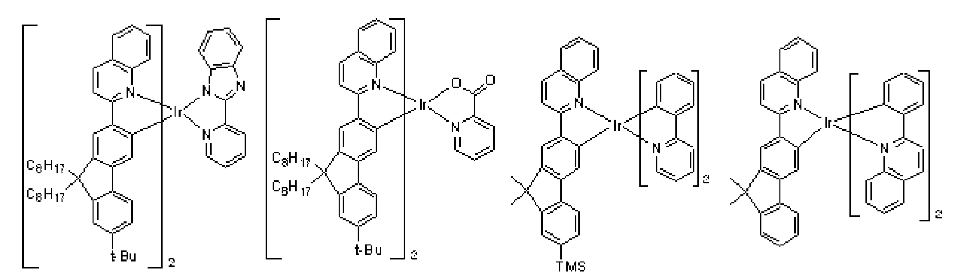

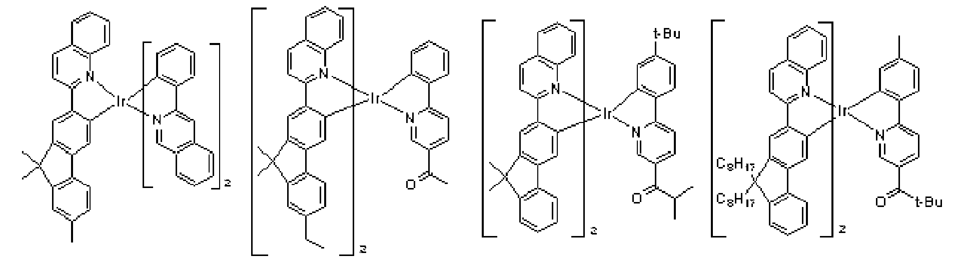

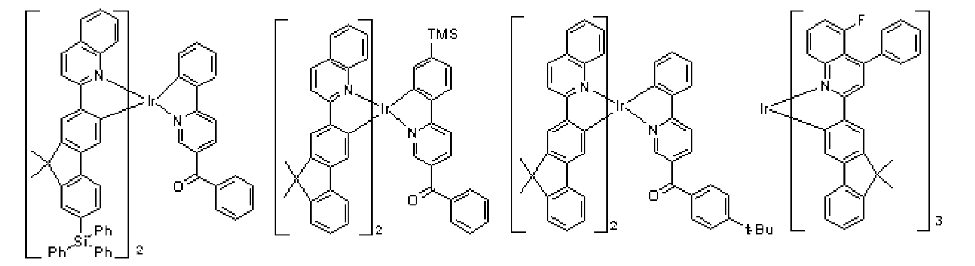

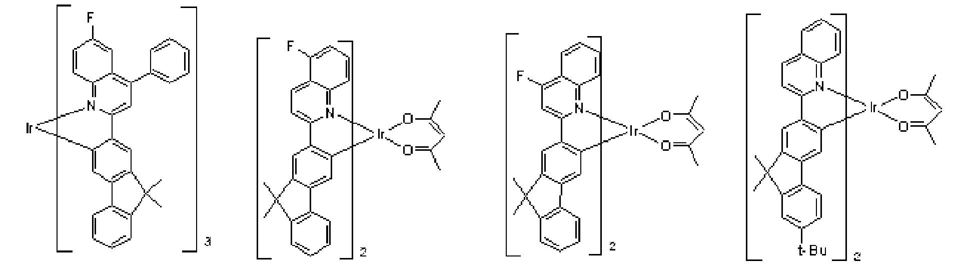

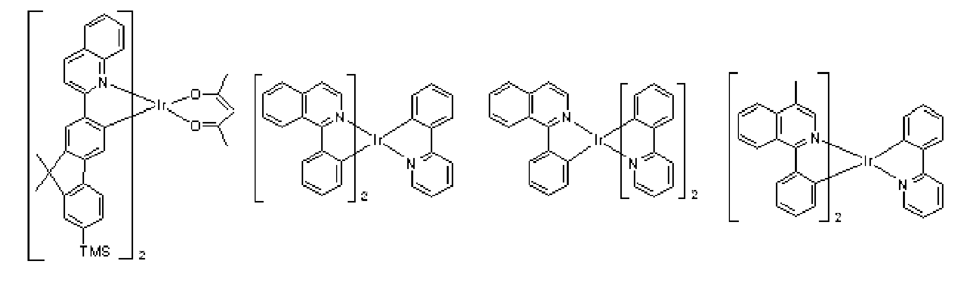

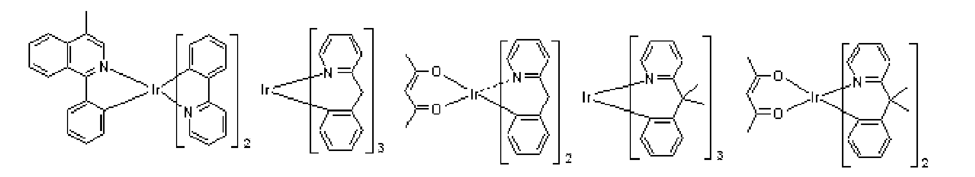

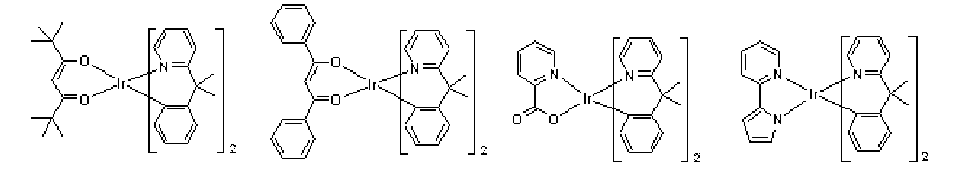

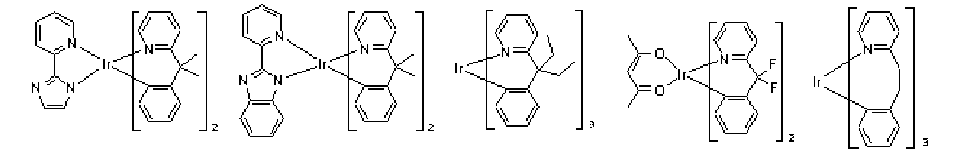

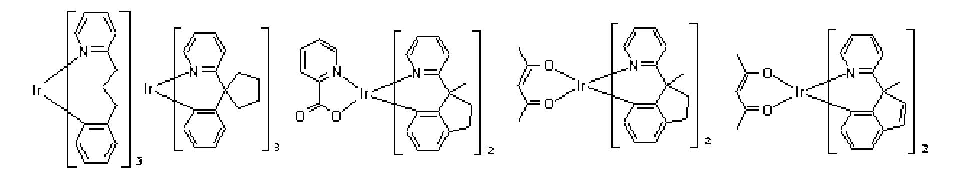

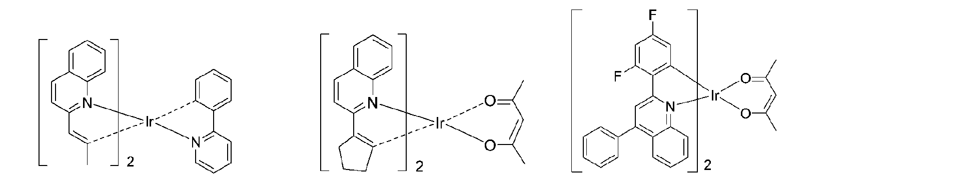

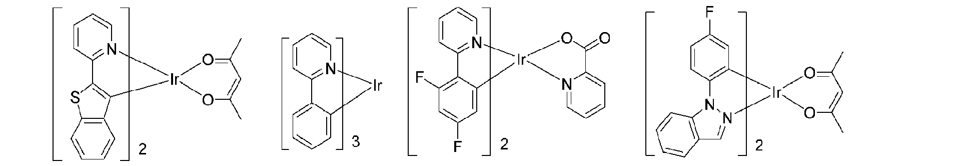

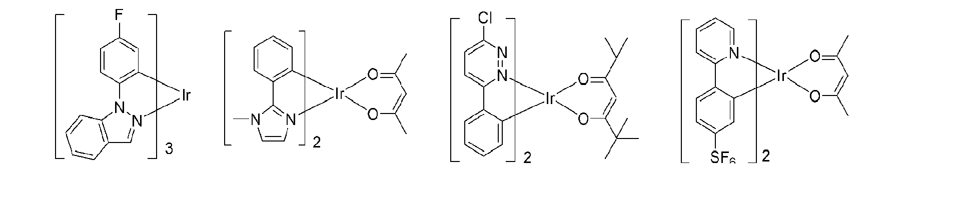

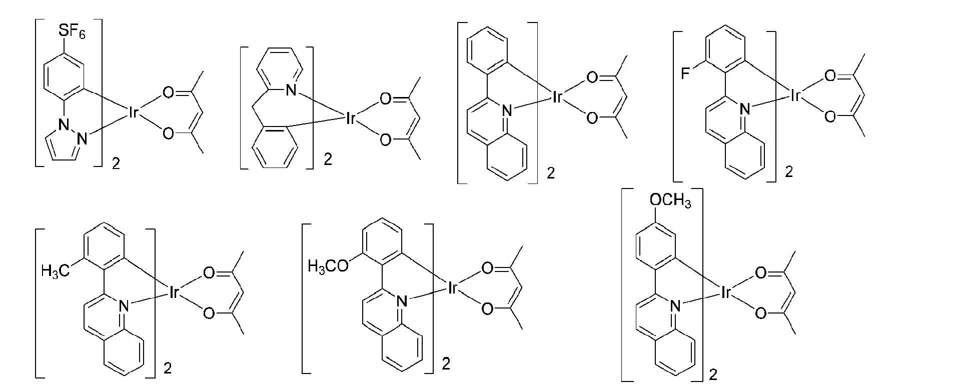

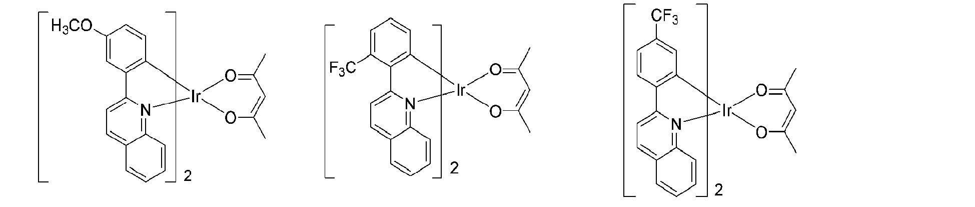

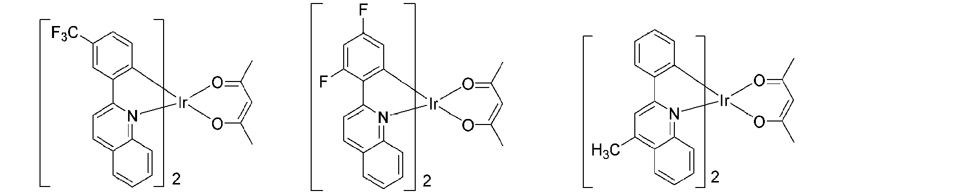

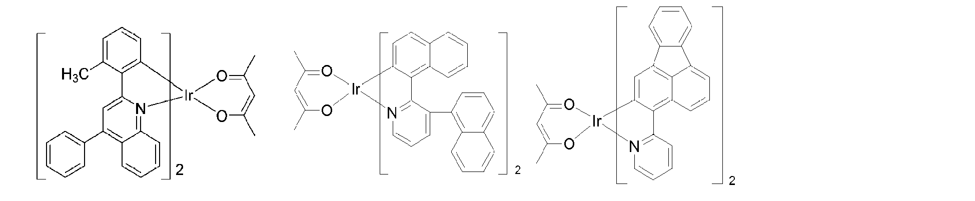

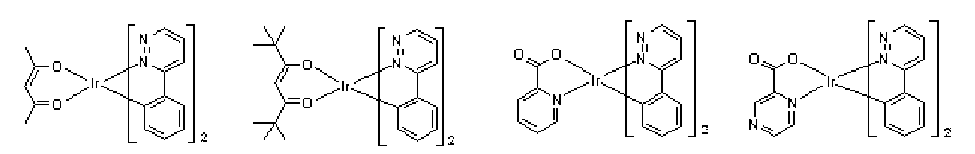

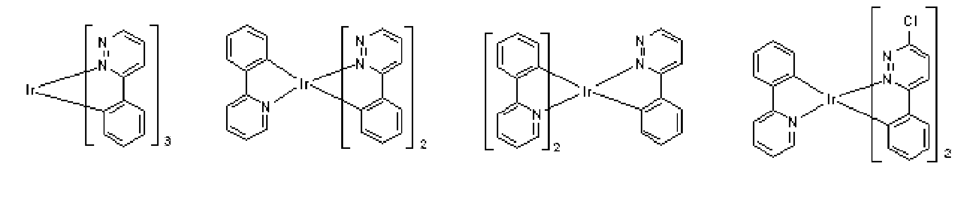

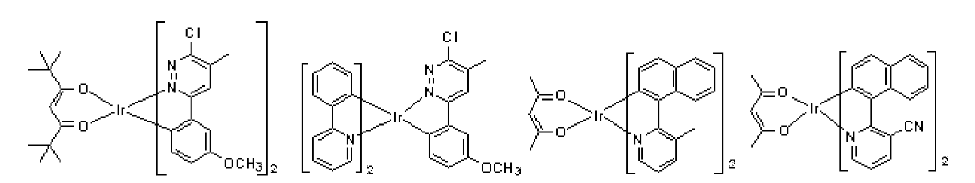

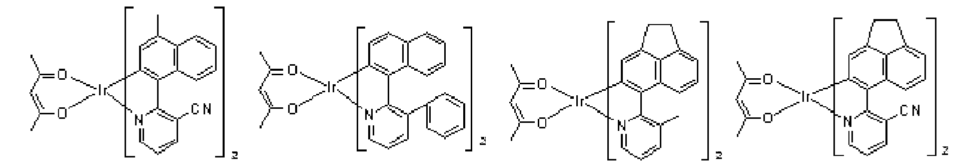

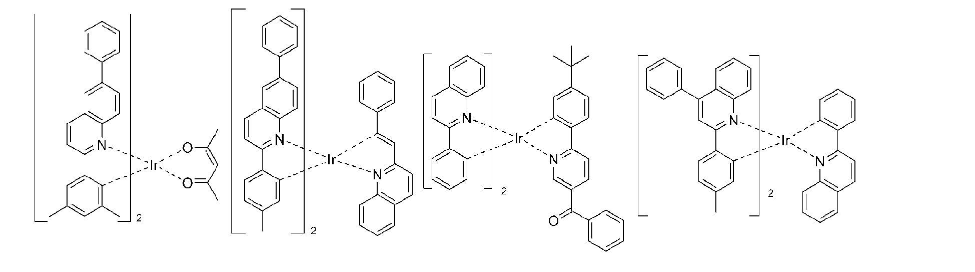

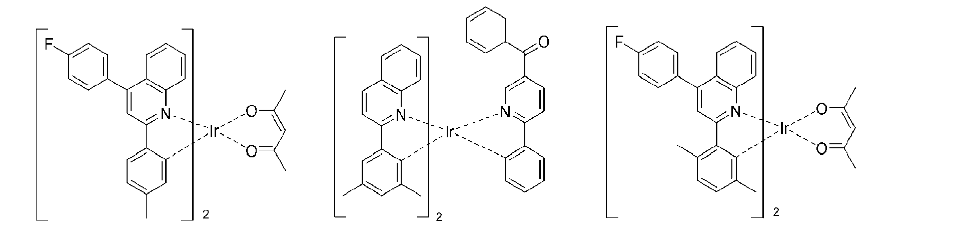

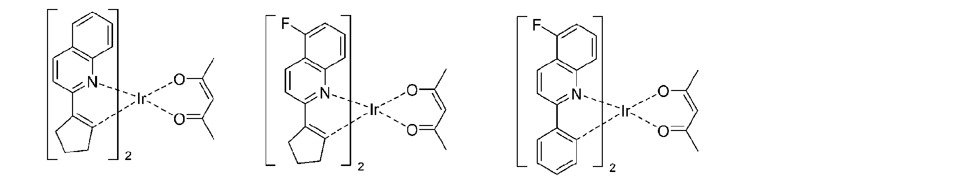

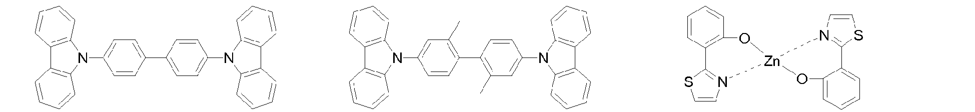

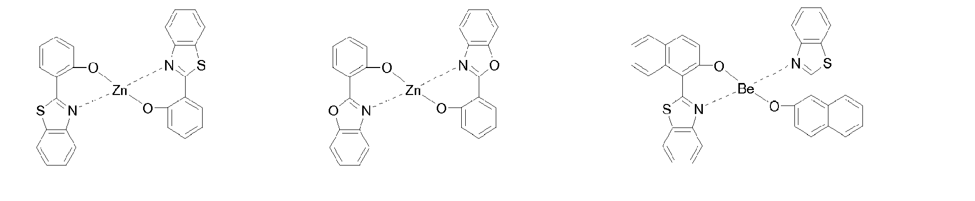

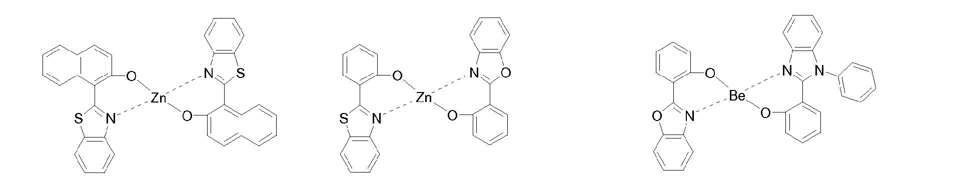

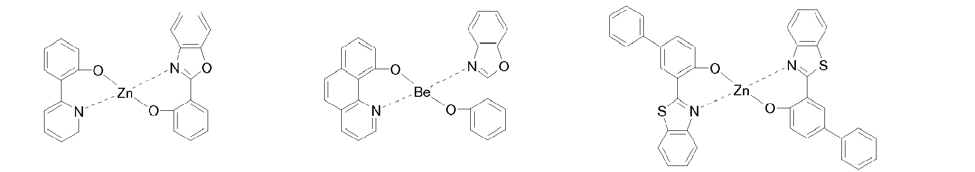

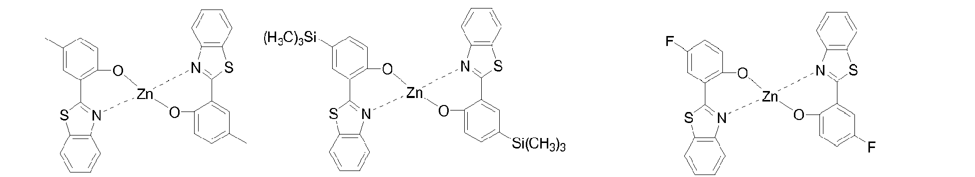

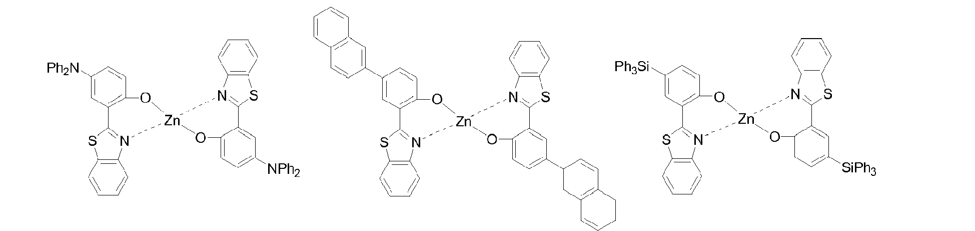

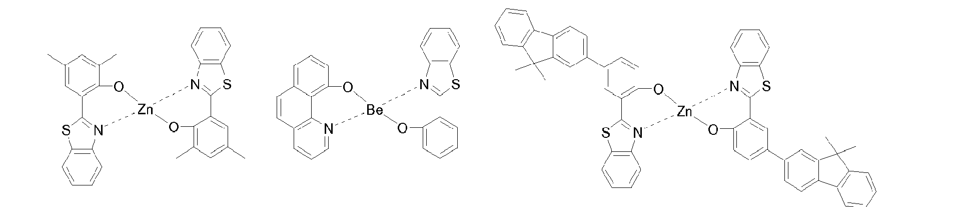

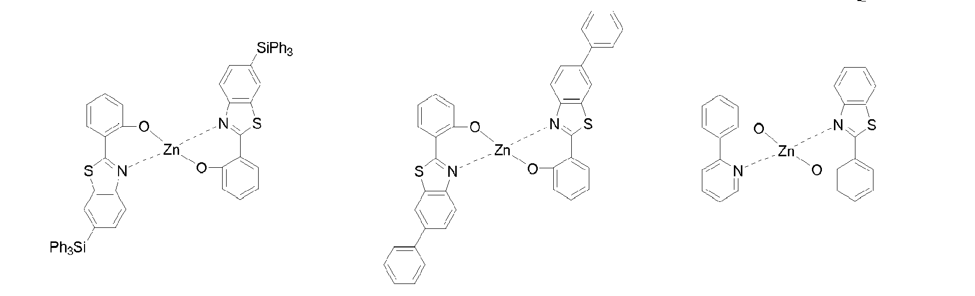

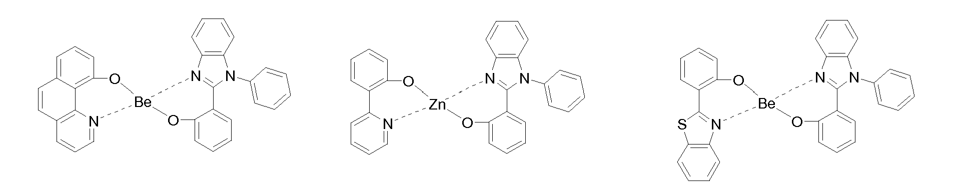

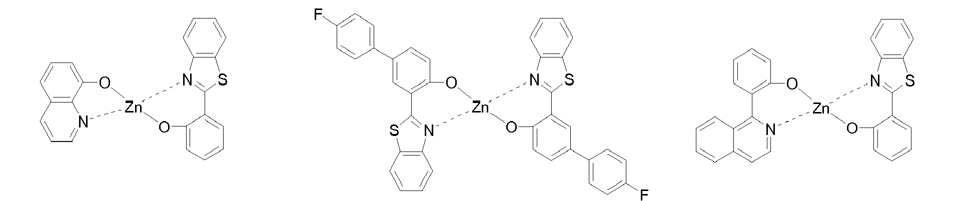

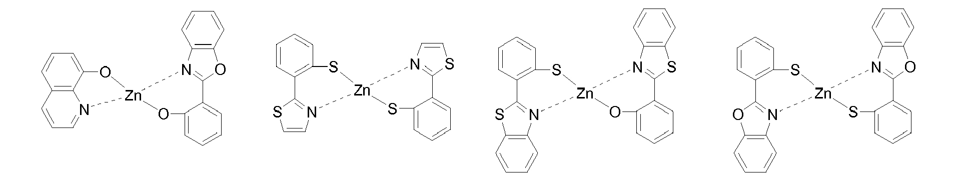

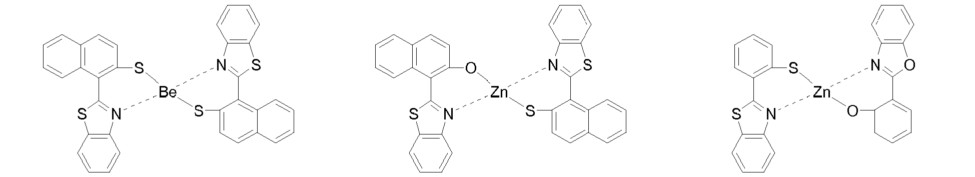

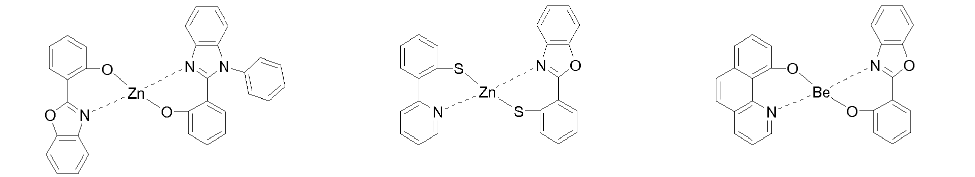

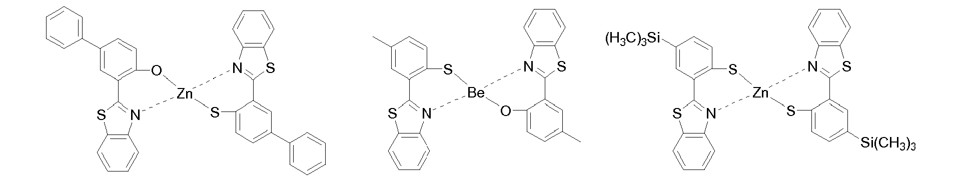

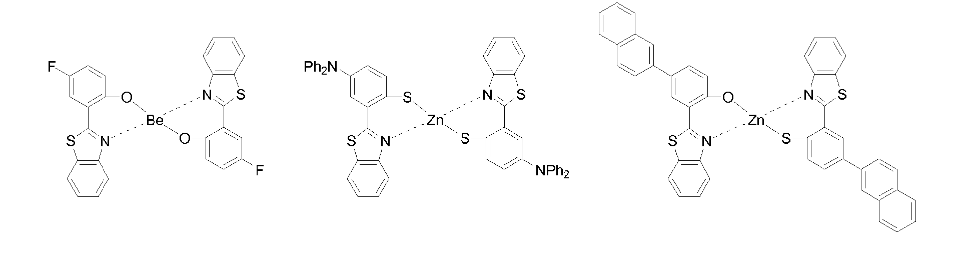

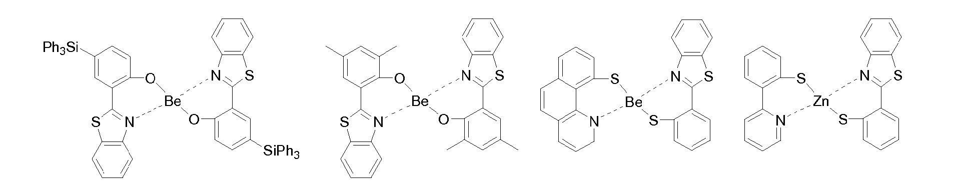

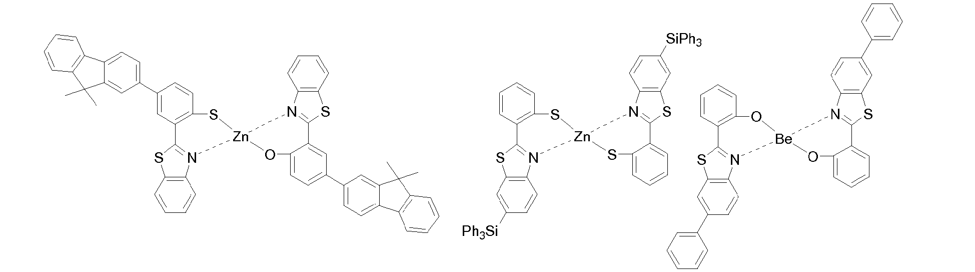

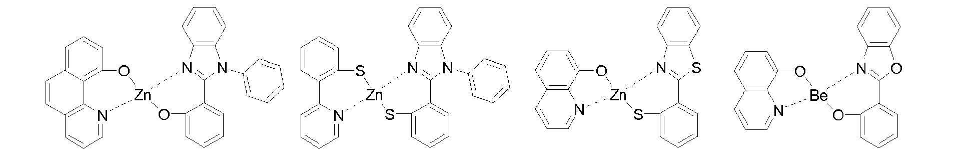

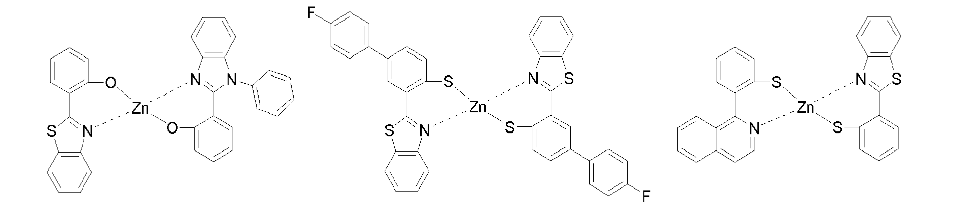

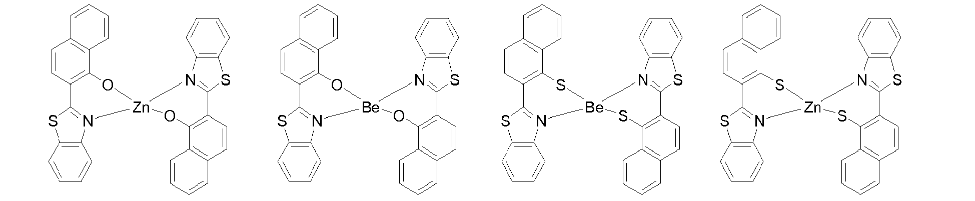

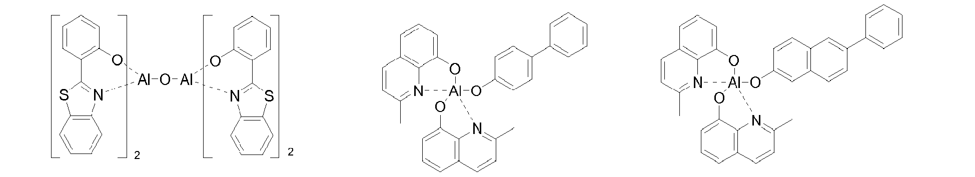

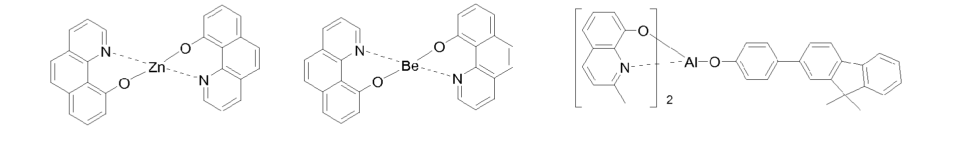

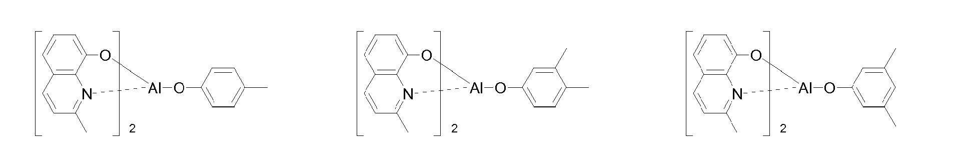

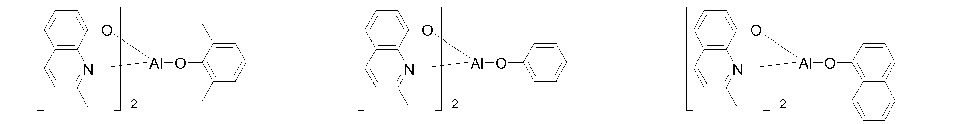

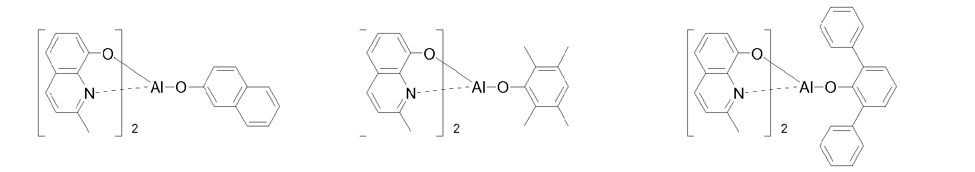

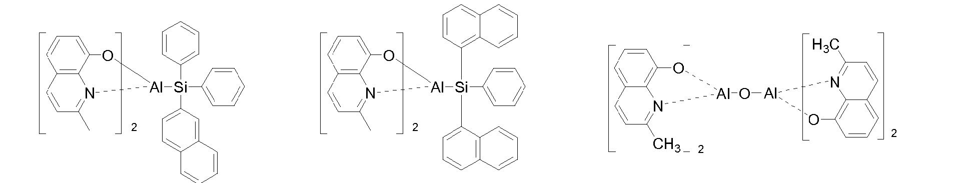

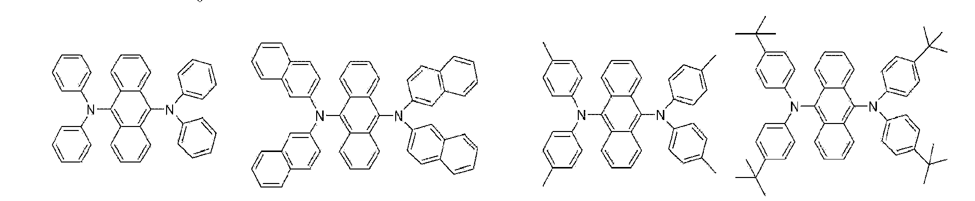

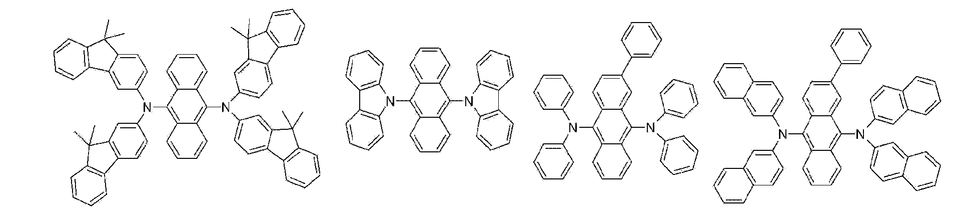

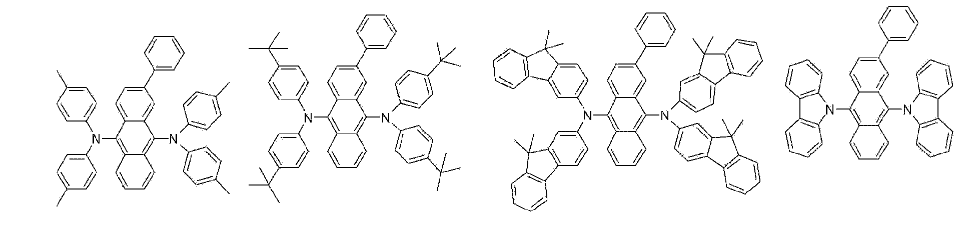

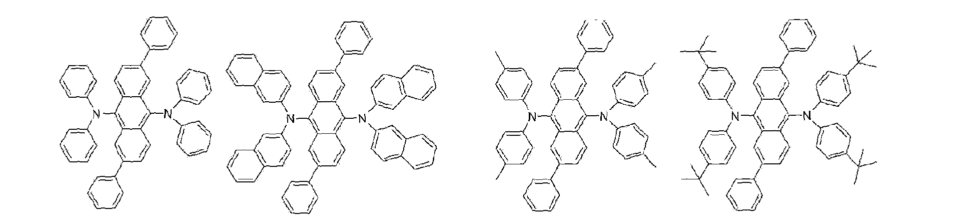

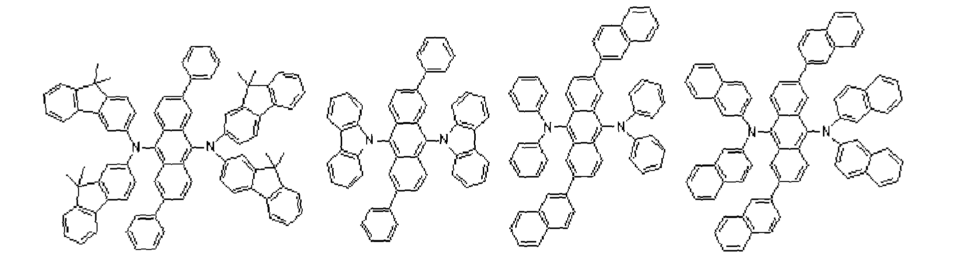

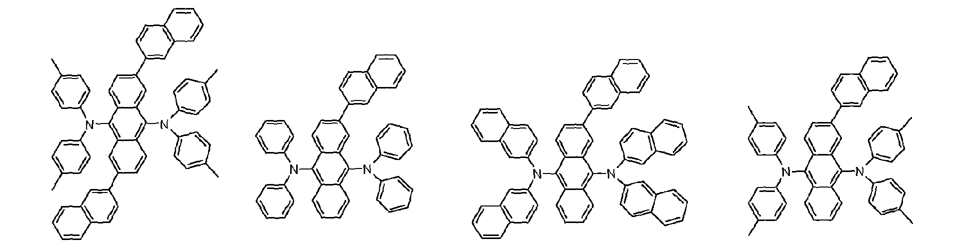

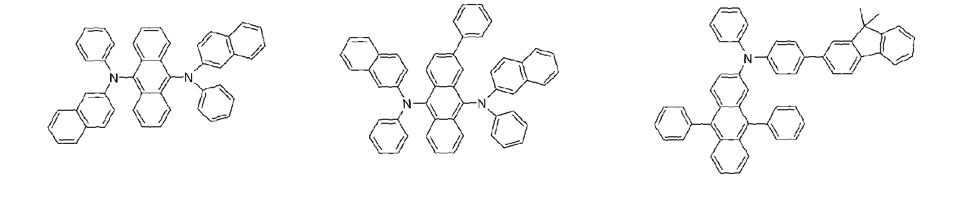

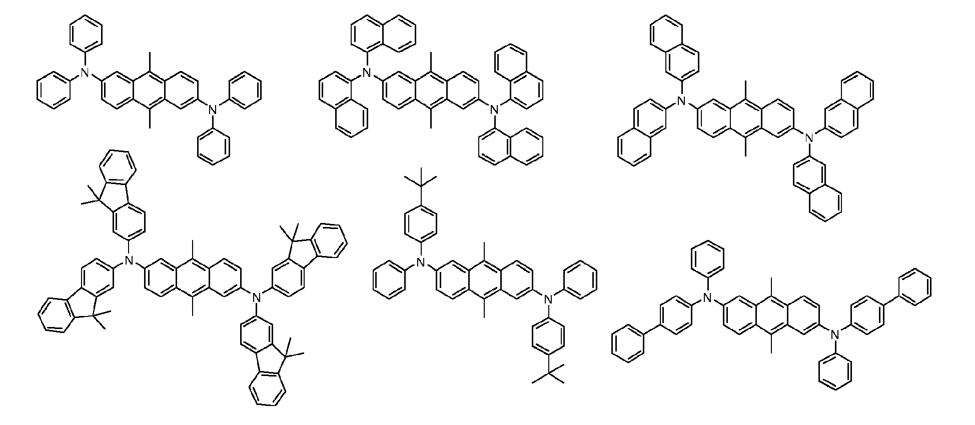

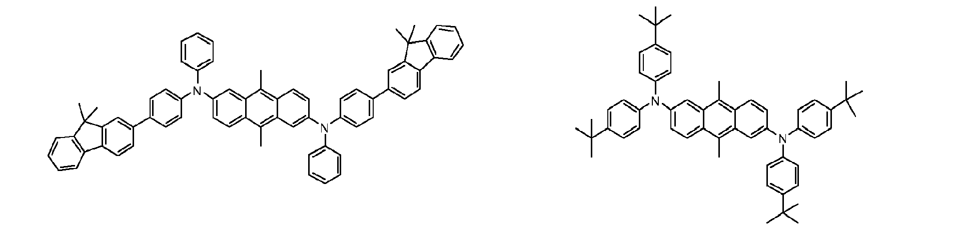

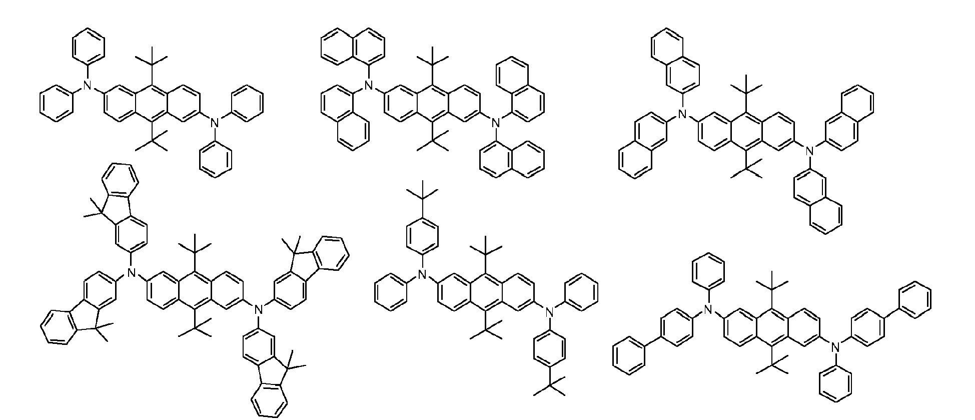

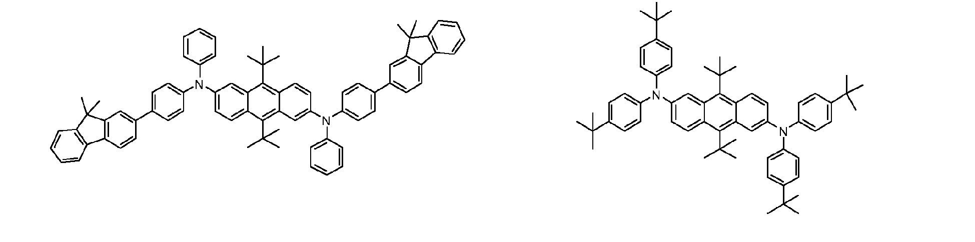

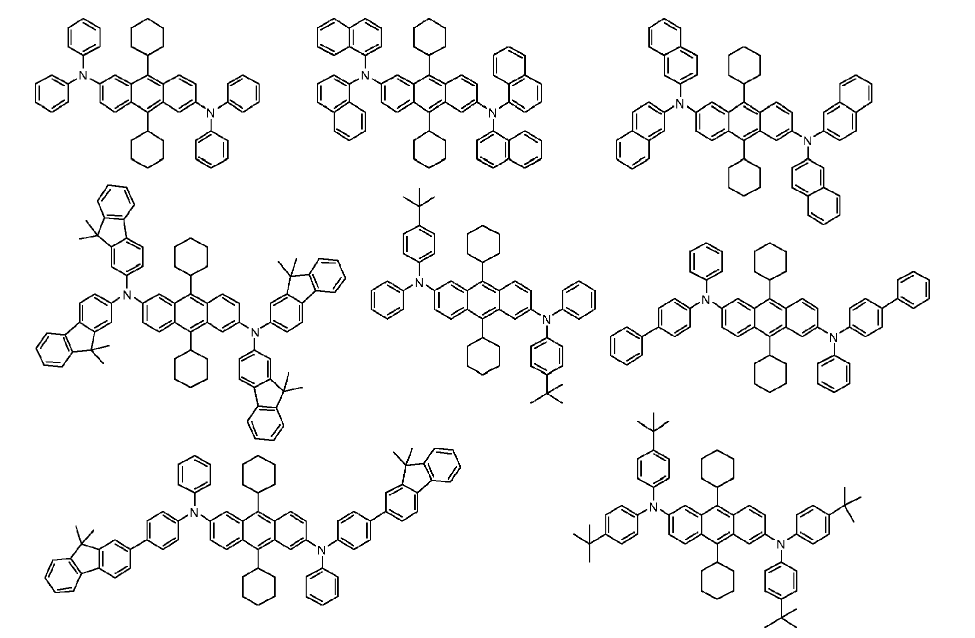

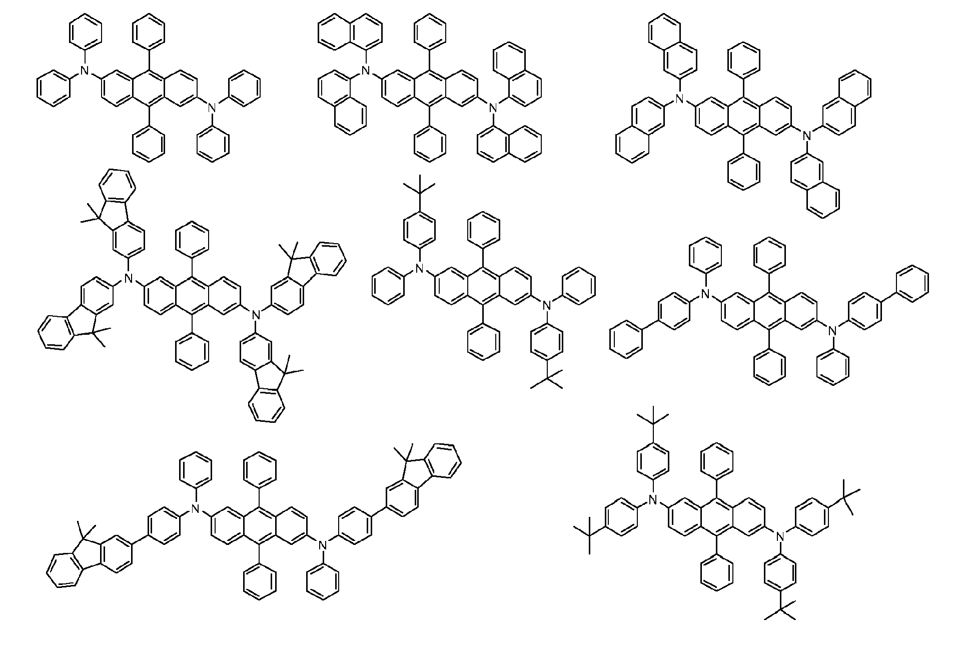

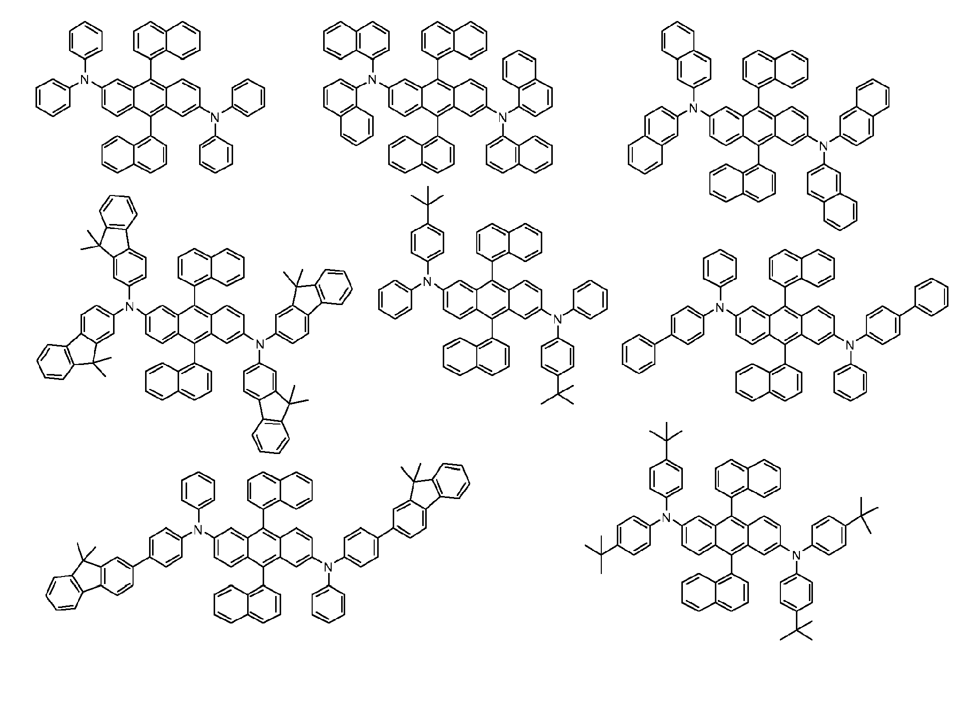

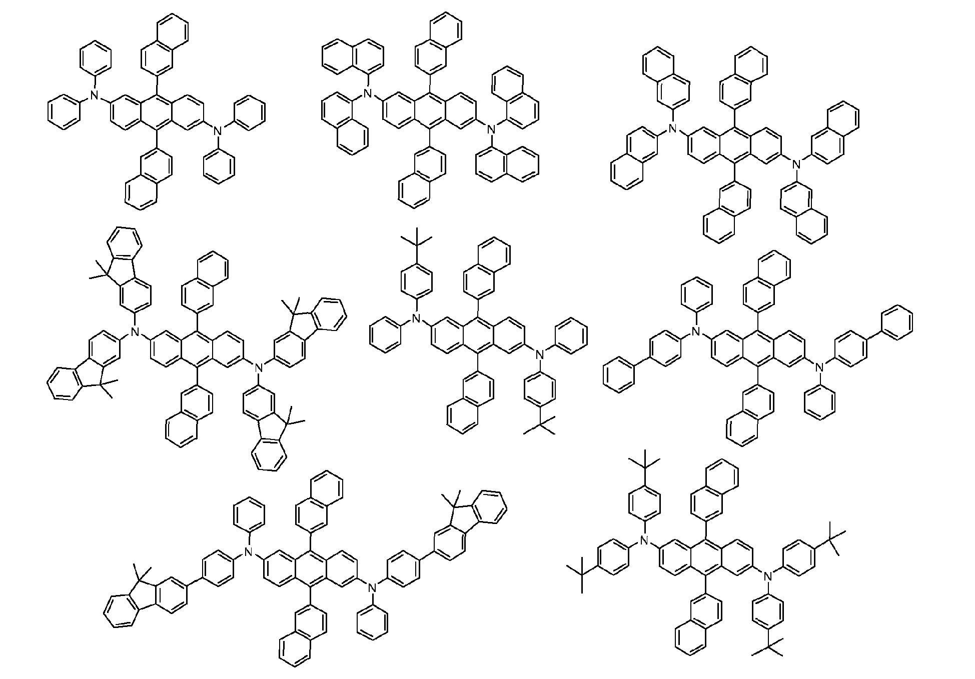

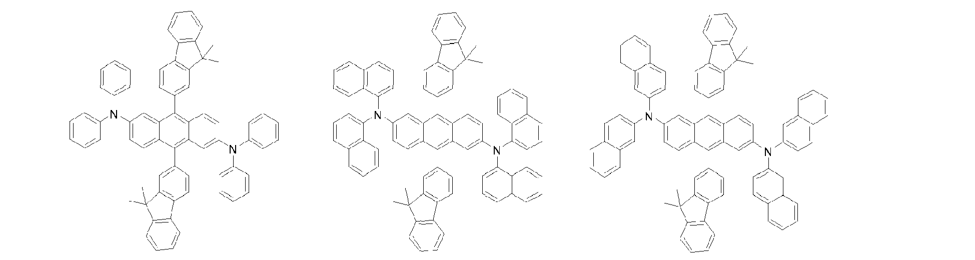

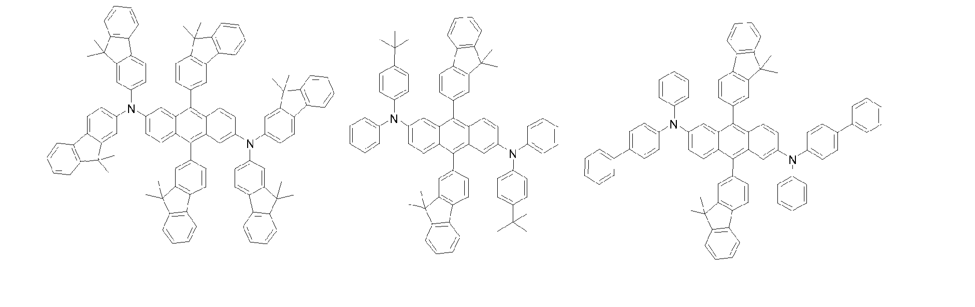

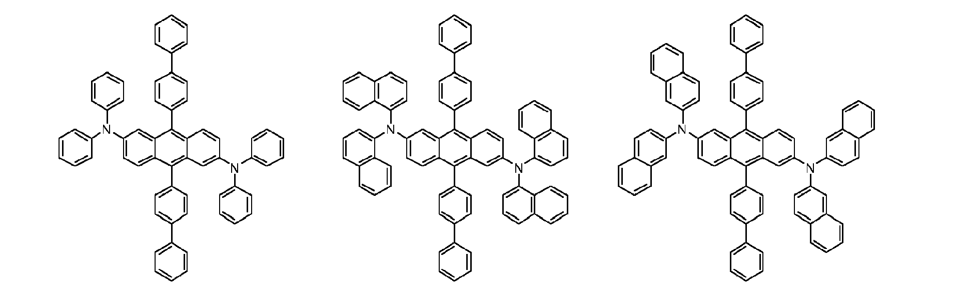

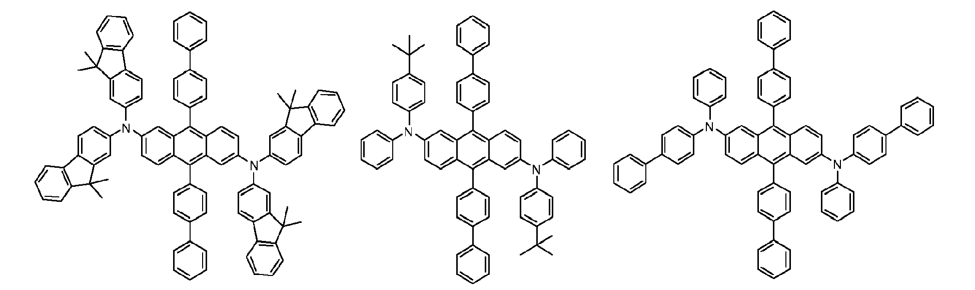

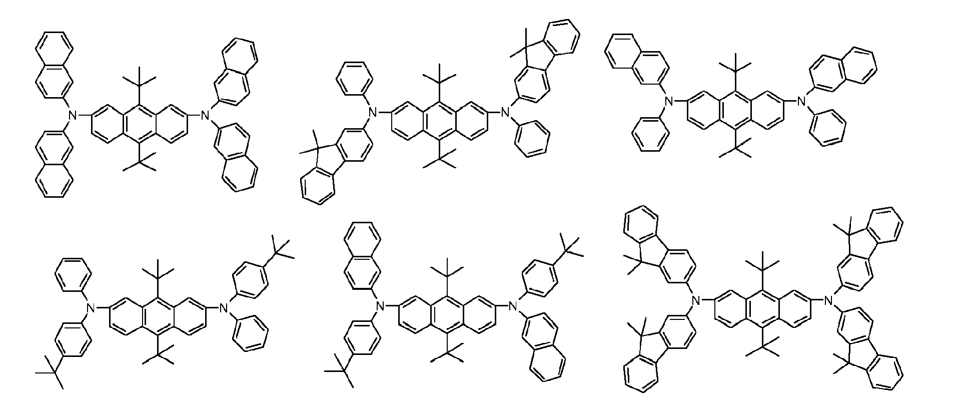

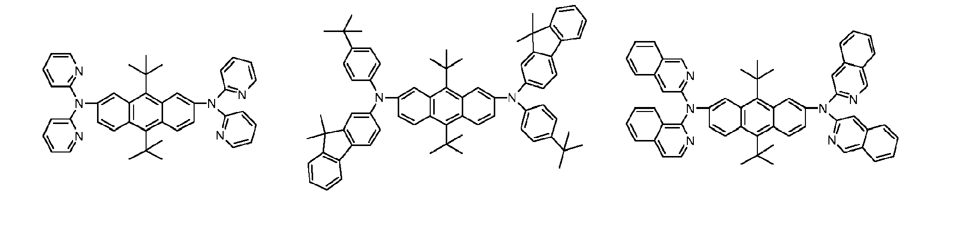

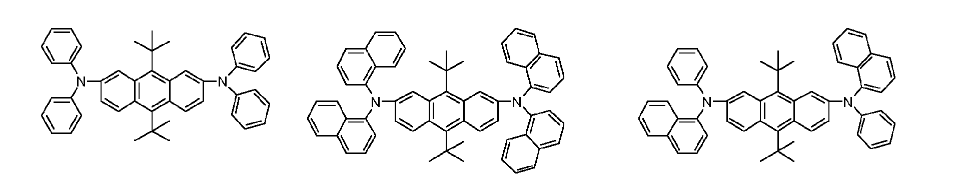

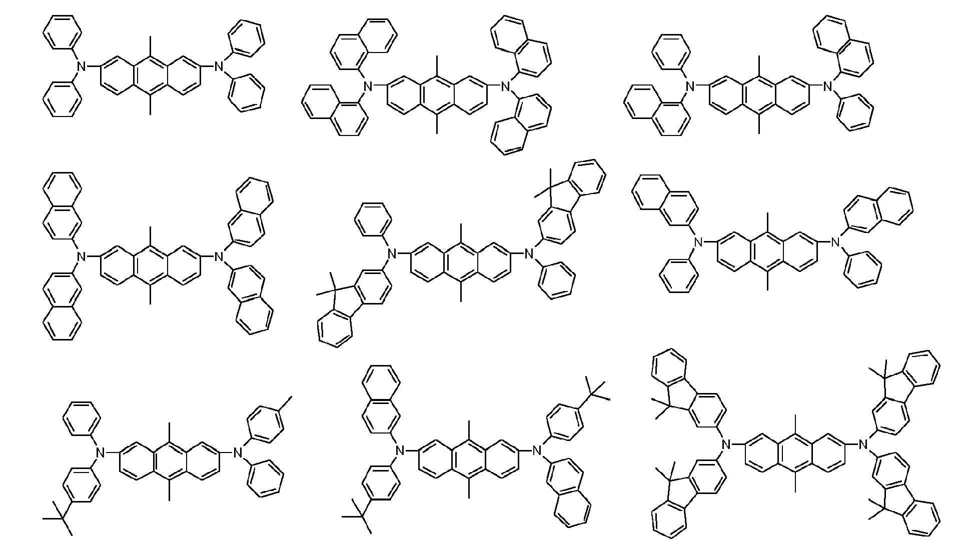

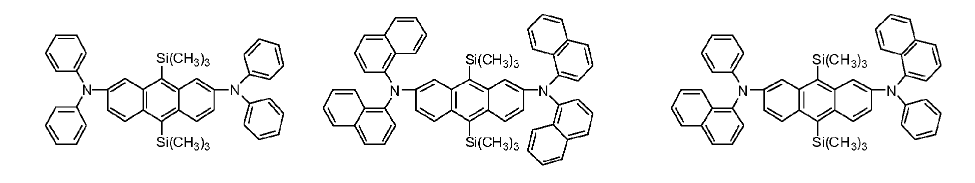

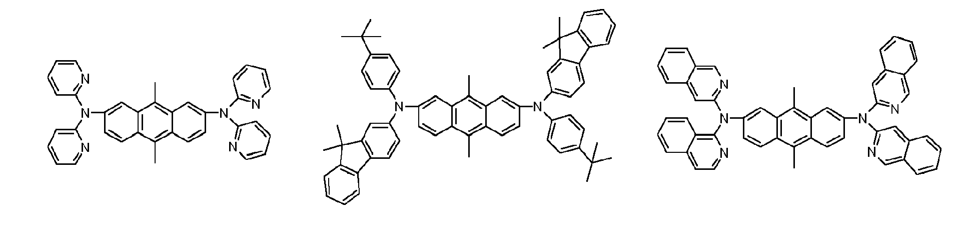

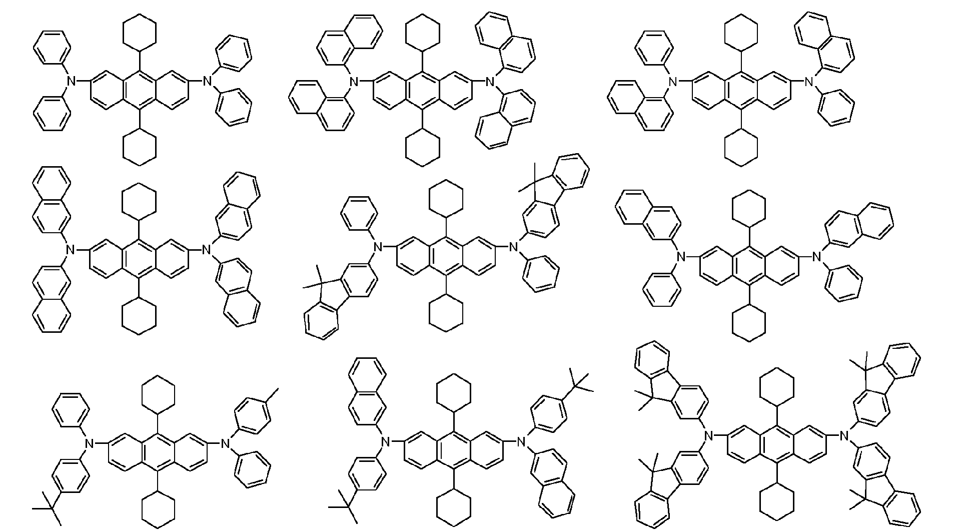

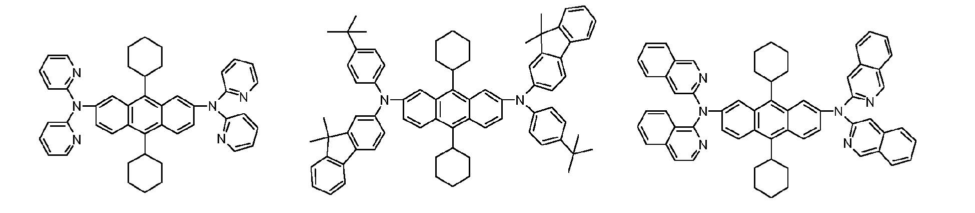

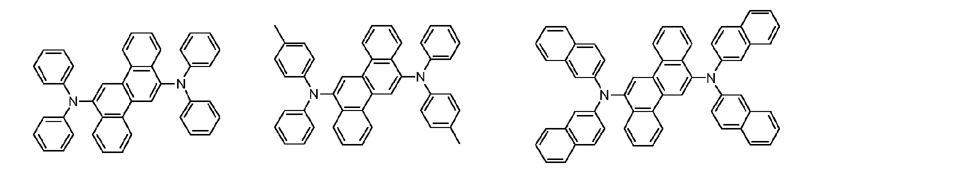

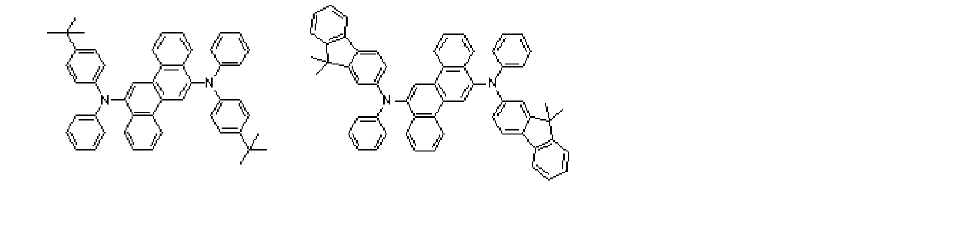

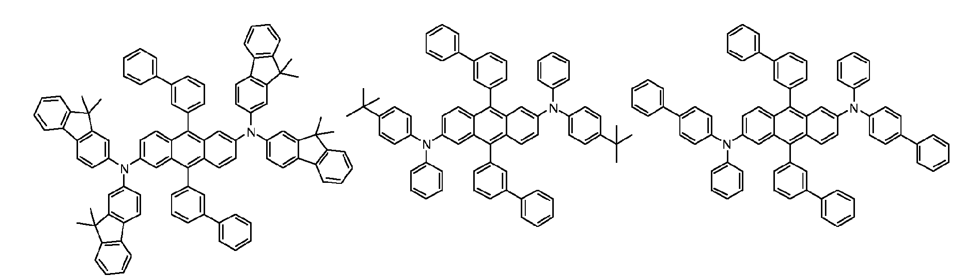

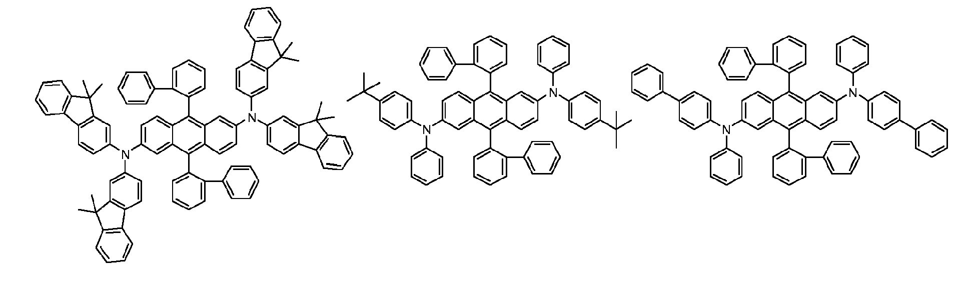

In the electroluminescent device according to the present invention, it is preferred that a layer (hereinafter referred to as "surface layer") selected from a metal chalcogenide layer, a metal halide layer and a metal oxide layer is placed on the inner surface of one or both electrode(s) among the pair of electrodes. More specifically, a metal chalcogenide (including oxide) layer of silicon or aluminum may be placed on the anode surface of the electroluminescent media layer, and a metal halide layer or metal oxide layer may be placed on the cathode surface of the electroluminescent media layer. A driving stability may be attained therefrom.

The chalcogenide may be, for example, SiOₓ (1 ≤ x ≤ 2), AlOₓ(1 ≤ x ≤ 1.5), SiON, SiAlON, etc. The metal halide may be, for example, LiF, MgF₂, CaF₂, a rare earth metal fluoride, etc. The metal oxide may be, for example, Cs₂O, Li₂O, MgO, SrO, BaO, CaO, etc.

Further, in the electroluminescent device according to the present invention, a mixed region of an electron transport compound and a reductive dopant or a mixed region of a hole transport compound and an oxidative dopant may be placed on the inner surface of one or both electrode(s) among the pair of electrodes. In that case, injection and transport of electrons from the mixed region to the electroluminescent media become easier, because the electron transport compound is reduced to an anion. Further, injection and transport of holes from the mixed region to the electroluminescent media become easier, because the hole transport compound is oxidized to a cation. Preferred examples of the oxidative dopant include various Lewis acids and acceptor compounds. Preferred examples of the reductive dopant include alkali metals, alkali metal compounds, alkaline earth metals, rare earth metals and mixtures thereof.

The present invention further provides an organic solar cell. The organic solar cell according to the present invention comprises one or more electroluminescent compound(s) represented by Chemical Formula 1, and the electroluminescent compound is a mixture of not less than 80% by weight and less than 100% by weight of the cis-form and more than 0% by weight and not more than 20% by weight of the trans-form.

The electroluminescent device according to the present invention, which comprises as a dopant a mixture of not less than 80% by weight and less than 100% by weight of an electroluminescent compound having cis configuration and more than 0% by weight and not more than 20% by weight of the electroluminescent compound having trans configuration, exhibits superior luminous efficiency, excellent color purity and very good operation life.

### EXAMPLES

Hereinafter, electroluminescence characteristics of the devices according to the present invention will be described for the understanding of the present invention. However, the following examples are for illustrative purposes only and not intended to limit the scope of the present invention.

### [Preparation Examples]

### [Preparation Example 1] Preparation of Compound 223

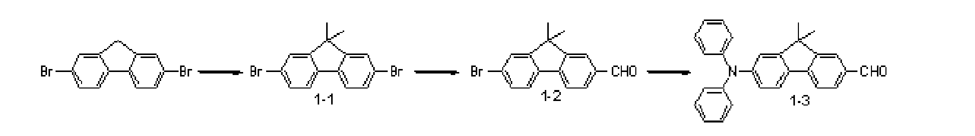

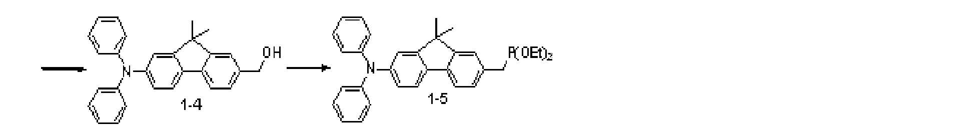

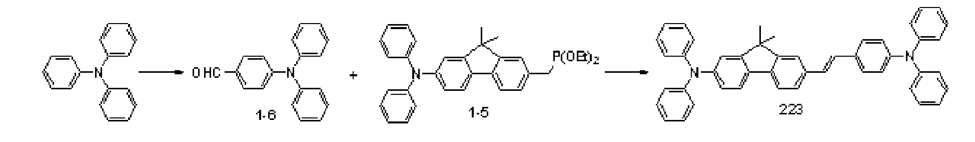

### Preparation of Compound 1-1

2,7-Dibromofluorene (50.0 g, 154.3 mmol) and potassium hydroxide (69.2 g, 1.23 mol) were dissolved in DMSO (700 mL) under nitrogen atmosphere. After cooling to 0 °C, followed by slowly adding distilled water (113 mL) dropwise, the mixture was stirred for 1 hour. Then, after slowly adding iodomethane (CH₃I) (38.5 mL, 0.617 mol), the mixture was slowly heated to room temperature and then stirred for 15 hours. Distilled water (200 mL) was added to the reaction solution to terminate the reaction. After extraction with dichloromethane (300 mL), the obtained organic layer was concentrated under reduced pressure. Compound **1-1** (53.0 g, 0.15 mol) was obtained by silica gel column chromatography (n-hexane/dichloromethane = 20/1).

### Preparation of Compound 1-2

Compound **1-1** (53.0 g, 0.15 mol) was dissolved in tetrahydrofuran (350 mL) and *n*-BuLi (1.6 M in n-hexane) (63.2 mL, 158 mmol) was slowly added dropwise at -78 °C. After stirring for 30 minutes, *N,N*-dimethylformamide (16.3 mL, 211 mmol) was added. After slowly heating, followed by stirring for 2 hours, aqueous NH₄Cl solution (20 mL) and distilled water (20 mL) were added to terminate the reaction. The organic layer was separated and concentrated under reduced pressure. Compound **1-2** (20.9 g, 69.4 mmol) was obtained by recrystallization with methanol/n-hexane (1/1, v/v, 100 mL).

### Preparation of Compound 1-3

Compound **1-2** (20.9 g, 69.4 mmol), diphenylamine (12.5 g, 104.1 mmol), cesium carbonate (24.1 g, 104.1 mmol) and palladium acetate (Pd(OAc)₂) (332 mg, 2.1 mmol) were suspended in toluene (800 mL). After adding tri(t-butyl)phosphine (P(t-Bu)₃) (0.60 g, 4.2 mmol), the mixture was stirred for 4 hours at 120 °C. After adding saturated aqueous ammonium chloride solution (100 mL), followed by extraction with ethyl acetate (150 mL) and filtration, Compound **1-3** (15.2 g, 39.0 mmol) was obtained by recrystallization with methanol/n-hexane (1/1, v/v, 100 mL).

### Preparation of Compound 1-4

Compound **1-3** (15.2 g, 39.0 mmol) and NaBH₄ (1.2 g, 42.9 mmol) were dissolved in tetrahydrofuran (150 mL). After cooling to 0 °C, methanol (80 mL) was slowly added dropwise. After stirring for 30 minutes, distilled water (100 mL) was added to terminate the reaction. After extraction with ethyl acetate (200 mL) and drying under reduced pressure, Compound **1-4** (13.2 g, 33.7 mmol) was obtained by column chromatography (dichloromethane/hexane = 1/1).

### Preparation of Compound 1-5

Compound **1-4** (13.2 g, 33.7 mmol) was added to a reactor. Triethyl phosphite (70 mL) was added under nitrogen flow and dissolved. Triethyl phosphite (30 mL) was added to another reactor. After opening the lid, stirring was carried out for 30 minutes at 0 °C while slowly adding iodine (11.2 g, 33.7 mmol). The mixture of iodine and triethyl phosphite was added to the reactor containing Compound **1-4**. After heating to 150 °C, the mixture was stirred for 4 hours. Upon completion of the reaction, triethyl phosphite was removed by distillation under reduced pressure. After washing with water (500 mL), followed by extraction with ethyl acetate (500 mL) and drying under reduced pressure, Compound **1-5** (14.2 g, 28.7 mmol) was obtained by column chromatography (ethyl acetate/hexane = 1/1).

### Preparation of Compound 1-6

Triphenylamine (10.0 g, 40.7 mmol) was dissolved in *N,N*-dimethylformamide (100 mL) and cooled to 0°C. *N,N*-dimethylformamide (32 mL, 407.6 mmol) was added to another reactor and cooled to 0 °C, and POCl₃ was slowly added. After stirring for 30 minutes, the mixture was slowly added dropwise at 0 °C to the reactor containing triphenylamine. After stirring further at 45 °C for 18 hours, the mixture was stirred after slowly adding saturated sodium hydroxide solution and adding excess water. The produced solid was filtered and washed twice with water and then twice with methanol. Compound **1-6** (10.0 g, 36.6 mmol) was obtained.

### Preparation of Compound 223

Compound **1-6** (7.8 g, 28.7 mmol) and Compound **1-5** (14.2 g, 28.7 mmol) were added to a reactor and dried under reduced pressure. After adding tetrahydrofuran (500 mL) under nitrogen atmosphere, the mixture was dissolved and cooled to 0 °C. Potassium *tert*-butoxide (t-BuOK) (8.6 g, 43.1 mmol) dissolved in tetrahydrofuran (100 mL) in another reactor was slowly added dropwise. After stirring for 2 hours at 0 °C, distilled water (800 mL) was added and the mixture was stirred. The solid was produced by filtering under reduced pressure. The resultant solid was washed 3 times with methanol (600 mL) and then was washed with ethyl acetate (100 mL). Compound **223** (11.2 g, 17.8 mmol, 64%) was obtained by recrystallization with tetrahydrofuran (80 mL) and methanol (500 mL).

[Preparation Example 2] Preparation of Compound **383**

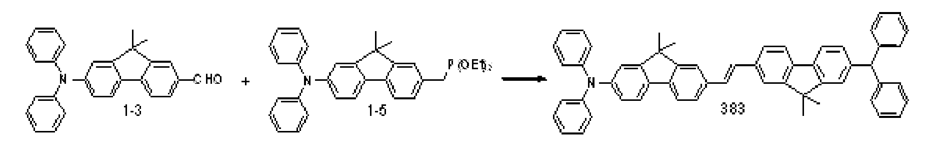

Compound **1-3** (10.8 g, 28.7 mmol) and Compound **1-5** (14.2 g, 28.7 mmol) were added to a reactor and dried under reduced pressure. After adding tetrahydrofuran (500 mL) under nitrogen atmosphere, the mixture was dissolved and cooled to 0 °C. Potassium *tert*-butoxide (t-BuOK) (8.6 g, 43.1 mmol) dissolved in tetrahydrofuran (100 mL) in another reactor was slowly added dropwise. After stirring for 2 hours at 0 °C, distilled water (800 mL) was added and the mixture was stirred. The solid was produced by filtered under reduced pressure. The resultant solid was washed 3 times with methanol (600 mL) and then was washed with ethyl acetate (100 mL). Compound **383** (12.9 g, 17.3 mmol, 62%) was obtained by recrystallization with tetrahydrofuran (80 mL) and methanol (500 mL).

Electroluminescent compounds (Compounds 1 to **786**) were prepared according to the method of Preparation Examples 1 and 2. Table 1 shows ¹H NMR and MS/FAB data of the prepared electroluminescent compounds.

**[Table 1]**

| compound | ¹H NMR(CDCl₃, 200 MHz) | MS/FAB | |
|---|---|---|---|
| | | found | calculated |
| 4 | δ = 6.63(12H, m), 6.81 (4H, m), 6.95(2H, m), 7.2(8H, m), 7.77(4H , m) 7.77(4H, m) | 514.66 | 514.24 |
| 6 | δ = 6.63(4H, m), 6.95(2H, m), 7.36(4H, m), 7.49∼7.5(8H, m), 7.74∼7.77(12H, m), 7.84∼7.88(8H, m) | 714.89 | 714.30 |
| 10 | δ = 6.63(8H, m), 6.81(2H, m), 6.95(2H, m), 7.2(4H, m), 7.36(2H, m), 7.49∼7.5(4H, m), 7.74∼7.77(8H, m), 7.84∼7.88(4H, m) | 614.78 | 614.27 |
| 20 | δ = 6.63(10H, m), 6.81(3H, m), 6.95(2H, m), 7.2(6H, m), 7.36(1H, m), 7.49∼7.5(2H, m), 7.74∼7.77(6H, m), 7.84∼7.88(2H, m) | 564.72 | 564.26 |
| 32 | δ = 1.35(9H, s), 6.55(2H, m), 6.63(8H, m), 6.81(2H, m), 6.95∼7.01 (4H, m), 7.2(4H, m), 7.36(1H, m), 7.49∼7.5(2H, m), 7.74∼7.77(6H, m), 7.84∼7.88(2H, m) | 620.82 | 620.32 |
| 65 | δ = 1.35(9H, s), 2.34(6H, s), 6.36(2H, m), 6.55(2H, m), 6.63(8H, m), 6.71(1H, m), 6.81 (2H, m), 6.95∼7.01(4H, m), 7.2(4H, m), 7.77(4H, m) | 598.82 | 598.33 |
| 86 | δ = 6.63(6H, m), 6.81(1H, m), 6.95∼6.98(3H, m), 7.2(2H, m), 7.36∼7.38(3H, m), 7.49∼7.57(7H, m), 7.74∼7.77(8H, m), 7.84∼7.88(4H, m), 8.02∼8.07(2H, m) | 664.83 | 664.29 |
| 125 | 6 = 1.35(9H, s), 6.55(2H, m), 6.63(6H, m), 6.69(4H, m), 6.81(1H, m), 6.95∼7.01(4H, m), 7.2(2H, m), 7.41(2H, m), 7.51∼7.54(12H, m), 7.77(4H, m) | 722.96 | 722.37 |
| 149 | δ = 1.72(6H, s), 6.58∼6.63(7H, m), 6.75∼6.81(2H, m), 6.95(2H, m), 7.2(2H, m), 7.28(1H, m), 7.36∼7.38(3H, m), 7.49∼7.55(5H, m), 7.62(1H, m), 7.74∼7.77(8H, m), 7.84∼7.88(5H, m) | 730.94 | 730.33 |
| 170 | δ = 1.35(9H, s), 6.55(2H, m), 6.63(6H, m), 6.81(1H, m), 6.95∼7.01 (4H, m), 7.2(2H, m), 7.36(2H, m), 7.49∼7.5(4H, m), 7.74∼7.77(8H, m), 7.84∼7.88(4H, m) | 670.88 | 670.33 |
| 177 | δ = 1.72(6H, s), 6.58∼6.63(7H, m), 6.75∼6.81(2H, m), 6_{.}95(2H, m), 7_{.}2(2H, m), 7.28(1H, m), 7.36∼7.38(3H, m), 7.49∼7.55(5H, m), 7.62(1H, m), 7.74∼7.77(8H, m), 7.84∼7.88(5H, m) | 730.94 | 730.33 |
| 203 | δ = 1.35(9H, s), 2.34(6H, s), 6.36(2H, m), 6.55(2H, m), 6.63(6H, m), 6.71 (1H, m), 6.81(1H, m), 6.95∼7.01(4H, m), 7.2(2H, m), 7.36(1H, m), 7.49∼7.5(2H, m), 7.74∼7.77(6H, m), 7.84∼7.88(2H, m) | 648.88 | 648.35 |
| 223 | δ = 1.72(6H, s), 6.58∼6.63(11H, m), 6.75∼6.81 (5H, m), 6.95(2H, m), 7.2(8H, m), 7.54(1H, m), 7.62(1H, m), 7.71∼-7.77(3H, m), 7.87(H, m) | 630.82 | 630.30 |
| 234 | δ = 1.72(6H, s), 6.58∼6.63(9H, m), 6.75∼6.81(4H, m), 6.95∼6.98(3H, m), 7.2(6H, m), 7.38(1H, m), 7.53∼7.62(5H, m), 7.71∼7.77(3H, m), 7.87(1H, m), 8.02∼8.07(2H, m) | 680.88 | 680.32 |
| 246 | δ = 1.35(9H, s), 1.72(6H, s), 6.55∼6.63(9H, m), 6.75∼6.81(3H, m), 6.95∼7.01(4H, m), 7.2(4H, m), 7.36(1H, m), 7.49∼7.54(3H, m), 7.62(1H, m), 7.71∼7.77(5H, m), 7.84∼7.88(3H, m) | 736.98 | 736.38 |
| 271 | δ = 1.72(6H, s), 2.34(9H, s), 6.36(2H, m), 6.44(1H, m), 6.55∼6.63(9H, m), 6.71∼6.81(4H, m), 6.95(2H, m), 7.08(1H, m), 7.2(4H, m), 7.54(1H, m), 7.62(1H, m), 7.71∼7.77(3H, m), 7.87(1H, m) | 672.90 | 672.35 |
| 297 | δ = 1.72(6H, s), 6.58∼6.63(7H, m), 6.75∼6.81(3H, m), 6.95(2H, m), 7.2(4H, m), 7.36(2H, m), 7.49∼7.54(5H, m), 7.62(1H, m), 7.71∼7.77(7H, m), 7.84∼7.88(5H, m) | 730.94 | 730.33 |
| 307 | δ = 1.72(6H, s), 6.58∼6.63(9H, m), 6.75∼6.81(4H, m), 6.95(2H, m), 7.2(6H, m), 7.36(1H, m), 7.49∼7.54(3H, m), 7.62(1H, m), 7.71∼7.77(5H, m), 7.84∼7.88(3H, m) | 680.88 | 680.32 |
| 319 | δ = 1.35(9H, s), 1.72(6H, s), 6.55∼6.63(9H, m), 6.75∼6.81(3H, m), 6.95∼7.01(4H, m), 7.2(4H, m), 7.36(1H, m), 7.49∼7.54(3H, m), 7.62(1H, m), 7.71∼7.77(5H, m), 7.84∼7.88(3H, m) | 736.98 | 736.38 |
| 352 | δ = 1.35(9H, s), 1.72(6H, s), 2.34(6H, s), 6.36(2H, m), 6.55∼6.63(9H, m), 6.71∼6.81(4H, m), 6.95∼7.01(4H, m), 7.2(4H, m), 7.54(1H, m), 7.62(1H, m), 7.71∼7.77(3H, m), 7.87(1H, m) | 714.98 | 714.40 |
| 367 | δ = 1.72(6H, s), 2.34(6H, s), 6.51(4H, m), 6.58∼6.63(7H, m), 6.75∼6.81 (3H, m), 6.95∼6.98(6H, m), 7.2(4H, m), 7.54(1H, m), 7.62(1H, m), 7.71∼7.77(3H, m), 7.87(1H, m) | 658.87 | 658.33 |
| 383 | δ = 1.72(12H, s), 6.58∼6.63(10H, m), 6.75∼6.81(6H, m), 6.95(2H, m), 7.2(8H, m), 7.54(2H, m), 7.62(2H, m), 7.71 (2H, m), 7.87(2H, m) | 746.98 | 746.37 |
| 387 | δ = 1.72(12H, s), 2.34(12H, s), 6.51(8H, m), 6.58(2H, m), 6.75(2H, m), 6.95∼6.98(10H, m), 7.54(2H, m), 7.62(2H, m), 7.71(2H, m), 7.87(2H, m) | 803.08 | 802.43 |
| 397 | δ = 1.72(12H, s), 2.34(12H, s), 6.36(4H, m), 6.58∼6.63(6H, m), 6.71∼6.81(6H, m), 6.95(2H, m), 7.2(4H, m), 7.54(2H, m), 7.62(2H, m), 7.71(2H, m), 7.87(2H, m) | 803.08 | 802.43 |
| 416 | δ = 1.72(12H, s), 2.34(6H, s), 6.36(2H, m), 6.58∼6.63(6H, m), 6.71∼6.81 (5H, m), 6.95(2H, m), 7.2(4H, m), 7.36(1H, m), 7.49∼7.54(4H, m), 7.62(2H, m), 7.71∼7.77(4H, m), 7.84∼7.88(4H, m) | 825.09 | 824.41 |
| 438 | δ = 1.72(12H, s), 2.34(9H, s), 6.36(2H, m), 6.44(1H, m), 6.55∼6.63(8H, m), 6.71∼6.81(5H, m), 6.95(2H, m), 7.08(1H, m), 7.2(4H, m), 7.54(2H, m), 7.62(2H, m), 7.71(2H, m), 7.87(2H, m) | 789.06 | 788.41 |
| 456 | δ = 1.35(9H, s), 1.72(18H, s), 6.55∼6.63(9H, m), 6.75∼6.81(5H, m), 6.95∼7.01(4H, m), 7.2(4H, m), 7.28(1H, m), 7.38(1H, m), 7.54∼7.55(3H, m), 7.62(3H, m), 7.71(2H, m), 7.87(3H, m) | 919.24 | 918.49 |
| 459 | δ = 1.72(12H, s), 6.58∼6.63(6H, m), 6.75∼6.81(4H, m), 6.95(2H, m), 7.2(4H, m), 7.36(2H, m), 7.49∼7.54(6H, m), 7.62(2H, m), 7.71∼7.77(6H, m), 7.84∼7.88(6H, m) | 847.10 | 846.40 |
| 468 | δ = 1.72(24H, s), 6.58∼6.63(8H, m), 6.75∼6.81(6H, m), 6.95(2H, m), 7.2(4H, m), 7.28(2H, m), 7.38(2H, m), 7.54∼7.55(4H, m), 7.62(4H, m), 7.71(2H, m), 7.87(4H, m) | 970.30 | 969.49 |
| 481 | δ = 1.35(18H, s), 1.72(12H, s), 6.55∼6.58(6H, m), 6.75(2H, m), 6.95∼7.01(8H, m), 7.38(2H, m), 7.53∼7.62(10H, m), 7.71(2H, m), 7.87(2H, m), 8.02∼8.07(4H, m) | 959.31 | 958.52 |
| 498 | δ = 1.35(18H, s), 1.72(12H, s), 2.12(6H, s), 6.51∼6.58(8H, m), 6.69∼6.75(4H, m), 6.95∼7.01(8H, m), 7.15(2H, m), 7.54(2H, m), 7.62(2H, m), 7.71(2H, m), 7.87(2H, m) | 887.24 | 886.52 |
| 507 | δ = 6.63(8H, m), 6.69(4H, m), 6.81(4H, m), 6.95(2H, m), 7.2(8H, m), 7.54∼7.56(8H, m), 7.64(4H, m) | 666.85 | 666.30 |
| 516 | δ = 2.34(12H, s), 6.51(8H, m), 6.69(4H, m), 6.95∼6.98(10H, m), 7.54∼7.56(8H, m), 7.64(4H, m) | 722.96 | 722.37 |
| 532 | δ = 1.35(9H, s), 6.55(2H, m), 6.63(6H, m), 6.69(4H, m), 6.81(3H, m), 6.95∼7.01 (4H, m), 7.2(6H, m), 7.54∼7.56(8H, m), 7.64(4H, m) | 722.96 | 722.37 |
| 568 | δ = 1.72(6H, s), 2.12(3H, s), 6.51(1H, m), 6.58∼6.63(5H, m), 6.69∼6.81(8H, m), 6.95∼7.01(3H, m), 7.15∼7.2(5H, m), 7.28(1H, m), 7.38(1H, m), 7.54∼7.56(9H, m), 7.62∼7.64(5H, m), 7.87(1H, m) | 797.04 | 796.38 |
| 574 | δ = 6.63(4H, m), 6.69(4H, m), 6.81(2H, m), 6.95∼6.98(4H, m), 7.2(4H, m), 7.38(2H, m), 7.53∼7.57(14H, m), 7.64(4H, m), 8.02∼8.07(4H, m) | 766.97 | 766.33 |
| 594 | δ = 1.72(12H, s), 6.58(2H, m), 6.69∼6.75(6H, m), 6.95∼6.98(4H, m), 7.28(2H, m), 7.38(4H, m), 7.53∼7.64(22H, m), 7.87(2H, m), 8.02∼8.07(4H, m) | 999.29 | 998.46 |
| 624 | δ = 1.35(18H, s), 1.72(12H, s), 6.55∼6.58(6H, m), 6.69∼6.75(6H, m), 6.95∼7.01(6H, m), 7.28(2H, m), 7.38(2H, m), 7.54∼7.56(10H, m), 7.62∼7.64(6H, m), 7.87(2H, m) | 1011.38 | 1010.55 |
| 627 | δ = 6.63(10H, m), 6.69(2H, m), 6.81(4H, m), 6.95(2H, m), 7.2(8H, m), 7.54∼7.56(4H, m), 7.64(2H, m), 7.77(2H, m) | 590.75 | 590.27 |
| 658 | δ = 6.63(6H, m), 6.69(2H, m), 6.81(4H, m), 6.95(2H, m), 7.2(4H, m), 7.36∼7.39(3H, m), 7.49∼7.56(6H, m), 7.64(2H, m), 7.74∼7.77(4H, m), 7.84∼7.88(2H, m) | 665.82 | 665.28 |
| 683 | δ = 1.35(9H, s), 2.34(3H, s), 6.44(1H, m), 6.55∼6.63(10H, m), 6.69(2H, m), 6.81(2H, m), 6.95∼7.01(4H, m), 7.08(1H, m), 7.2(4H, m), 7.54∼7.56(4H, m), 7.64(2H, m), 7.77(2H, m) | 660.89 | 660.35 |
| 707 | δ = 1.35(18H, s), 6.55(4H, m), 6.63(6H, m), 6.69(2H, m), 6.81(2H, m), 6.95∼7.01 (6H, m), 7.2(4H, m), 7.54∼7.56(4H, m), 7.64(2H, m), 7.77(2H, m) | 702.97 | 702.40 |
| 723 | δ = 1.35(9H, s), 6.55(2H, m), 6.63(6H, m), 6.69(2H, m), 6.81(2H, m), 6.95∼7.01(4H, m), 7.2(4H, m), 7.36(1H, m), 7.49∼7.56(6H, m), 7.64(2H, m), 7.74∼7.77(4H, m), 7.84∼7.88(2H, m) | 696.92 | 696.35 |
| 756 | δ = 1.72(6H, s), 2.12(3H, s), 6.51(1H, m), 6.58∼6.63(7H, m), 6.69∼6.81(6H, m), 6.95∼7.01(3H, m), 7.15∼7.2(5H, m), 7.28(1H, m), 7.38(1H, m), 7.54∼7.56(5H, m), 7.62∼7.64(3H, m), 7.77(2H, m), 7.87(1H, m) | 720.94 | 720.35 |
| 780 | δ = 2.34(12H, s), 6.36(4H, m), 6.63(2H, m), 6.69∼6.71 (4H, m), 6.95∼6.98(4H, m), 7.38(2H, m), 7.53∼7.57(10H, m), 7.64(2H, m), 7.77(2H, m), 8.02∼8.07(4H, m) | 746.98 | 746.37 |
| 784 | δ = 1.35(18H, s), 2.34(6H, s), 6.51∼6.55(8H, m), 6.63(2H, m), 6.69(2H, m), 6.95∼7.01((10H, m), 7.54∼7.56(4H, m), 7.64(2H, m), 7.77(2H, m) | 731.02 | 730.43 |
| 786 | δ = 6.63(6H, m), 6.69(2H, m), 6.81(2H, m), 6.95(2H, m), 7.02(2H, m), 7.2(4H, m), 7.54∼7.56(4H, m), 7.64(2H, m), 7.71∼7.88(16H, m), 8.12(2H, m) | 839.03 | 838.33 |

### [Examples] Manufacture of electroluminescence device (comprising not less than 80 % by weight of dopant having cis configuration)

First, a transparent electrode ITO thin film (15 Ω/□) 2 prepared from a glass substrate for an OLED (Samsung Corning) 1 was subjected to ultrasonic washing sequentially using trichloroethylene, acetone, ethanol and distilled water, and stored in isopropanol for later use.

Next, the ITO substrate was mounted on a substrate holder of a vacuum deposition apparatus. After filling 4,4',4"-tris(N,N-(2-naphthyl)-phenylamino)triphenylamine (2-TNATA) of the following structure in a cell of the vacuum deposition apparatus, the pressure inside the chamber was reduced to 10⁻⁶ torr. Then, 2-TNATA was evaporated by applying electrical current to the cell. A hole injecting layer 3 having a thickness of 60 nm was formed on the ITO substrate.

Subsequently, after filling *N*,*N*'-bis(α-naphthyl)-*N*,*N*'-diphenyl-4,4'-diamine (NPB) of the following structure in another cell of the vacuum deposition apparatus, NPB was evaporated by applying electrical current. A hole transport layer 4 having a thickness of 20 nm was formed on the hole injecting layer.

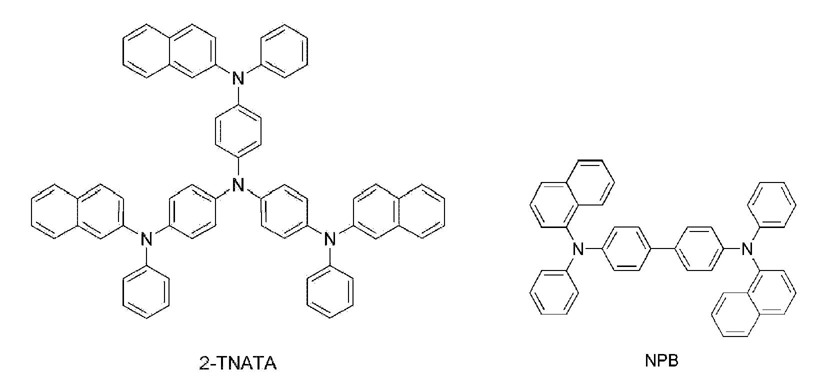

After forming the hole injecting layer and the hole transport layer, an electroluminescent layer 5 was formed thereon as follows. Compound H-33 of the following structure was filled in a cell of a vacuum deposition apparatus as a host, and Compound 223 (80 % by weight ≦ cis content < 100% by weight; 0 % by weight < trans content ≦ 20% by weight; cis content + trans content = 100% by weight) was filled in another cell as a dopant. The two materials were evaporated at different speed, so that an electroluminescent layer 5 having a thickness of 30 nm was formed on the hole transport layer at 2 to 5 wt% based on the host.

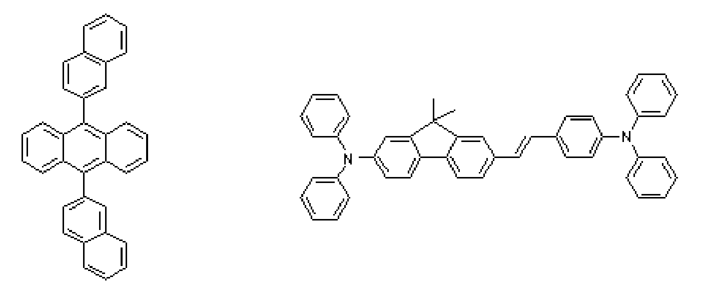

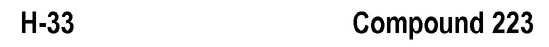

Thereafter, tris(8-hydroxyquinoline)-aluminum(III) (Alq) of the following structure was deposited with a thickness of 20 nm as an electron transport layer 6. Then, lithium quinolate (Liq) of the following structure was deposited with a thickness of 1 to 2 nm as an electron injection layer7. Then, an Al cathode 8 having a thickness of 150 nm was formed using another vacuum deposition apparatus to manufacture an OLED.

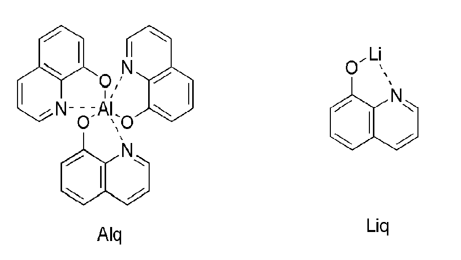

Each OLED electroluminescent material was purified by vacuum sublimation at 10⁻⁶ torr.

### [Comparative Examples] Manufacture of electroluminescence device (comprising less than 80 % by weight of dopant having cis configuration)

An OLED device was manufactured as in Examples, except that Compound 223 (0% by weight < cis content < 80% by weight; 20% by weight < trans content < 100% by weight; cis content + trans content = 100% by weight) was used as a dopant.

Luminous efficiency of the OLED devices manufactured in Example and Comparative Example, with different cis-trans proportion of the dopant compound, was measured at 1,000 cd/m². The result is given in Table 2.

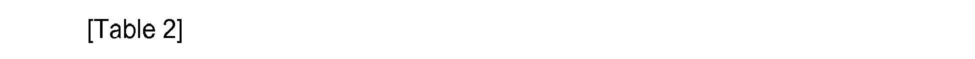

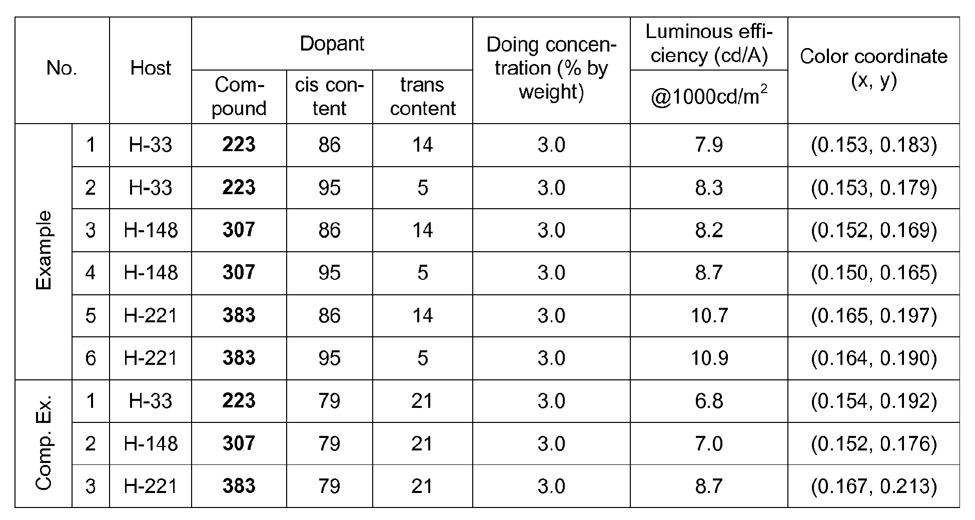

As seen in Table 2, the electroluminescent devices according to the present invention, which comprise a mixture of not less than 80% by weight and less than 100% by weight of a dopant compound having cis configuration and more than 0% by weight and not more than 20% by weight of the dopant compound having trans configuration, exhibited improved luminous efficiency and color purity as compared to the devices of Comparative Examples 1 to 3, which comprise less than 80% by weight of the dopant compound having cis configuration.

While the exemplary embodiments have been shown and described, it will be understood by those skilled in the art that various changes in form and details may be made thereto without departing from the spirit and scope of this disclosure as defined by the appended claims.

In addition, many modifications can be made to adapt a particular situation or material to the teachings of this disclosure without departing from the essential scope thereof. Therefore, it is intended that this disclosure not be limited to the particular exemplary embodiments disclosed as the best mode contemplated for carrying out this disclosure, but that this disclosure will include all embodiments falling within the scope of the appended claims.

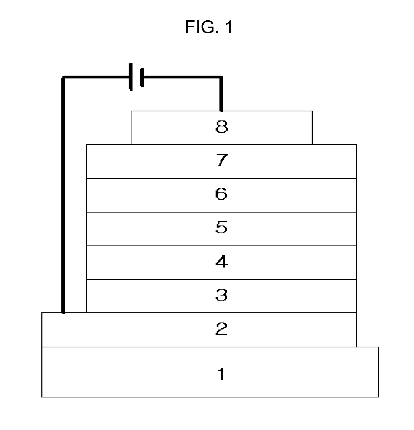

## Claims

1. An electroluminescent device comprising an organic layer interposed between an anode and a cathode on a substrate, wherein the organic layer comprises an electroluminescent layer comprising one or more dopant compound(s) represented by Chemical Formula 1, and the dopant compound is a mixture of not less than 80% by weight and less than 100% by weight of the cis-form and more than 0% by weight and not more than 20% by weight of the trans-form: 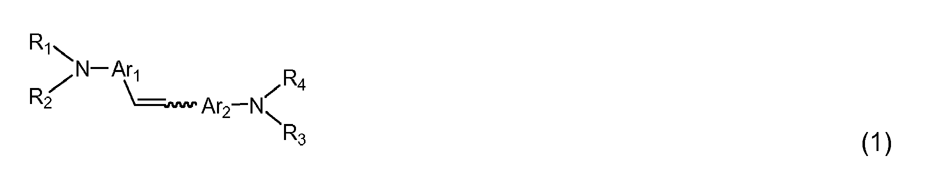 wherein
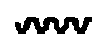 represents cis or trans configuration to the double bond;
Ar₁ and Ar₂ independently represent (C6-C60)arylene or (C5-C50)heteroarylene containing one or more heteroatom(s) selected from N, O and S;
R₁ through R₄ independently represent hydrogen, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₁ through R₄ may be linked to an adjacent substituent via (C3-C60)alkylene or (C3-C60)alkenylene with or without a fused ring to form an alicyclic ring or a monocyclic or polycyclic aromatic ring; and
the arylene or heteroarylene of Ar₁ and Ar₂, and the aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄ may be further substituted by one or more substituent(s) selected from a group consisting of deuterium, halogen, halo(C1-C60)alkyl, (C1-C60)alkyl, (C6-C60)aryl, (C3-C60)heteroaryl with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxy.

2. The electroluminescent device according to claim 1, wherein the electroluminescent layer further comprises one or more host compound(s) represented by Chemical Formula 2 or 3:
(Ar₁₁)ₐ-X-(Ar₁₂)_{b} (2)
(Ar₁₃)_{c}-Y-(Ar₁₄)_{d} (3)
wherein
X represents (C6-C60)arylene or (C4-C60)heteroarylene;
Y represents anthracenylene;
Ar₁₁ through Ar₁₄ independently represent hydrogen, (C1-C60)alkyl, (C1-C60)alkoxy, halogen, (C4-C60)heteroaryl, (C5-C60)cycloalkyl or (C6-C60)aryl;
the alkyl, cycloalkyl, aryl or heteroaryl of Ar₁₁ through Ar₁₄ may be further substituted by one or more substituent(s) selected from a group consisting of (C6-C60)aryl or (C4-C60)heteroaryl with or without one or more substituent(s) selected from a group consisting of deuterium, (C1-C60)alkyl with or without halogen substituent, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl, (C1-C60)alkyl with or without halogen substituent, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
a, b, c and d independently represent an integer from 1 to 4.

3. The electroluminescent device according to claim 1, wherein Ar₁ and Ar₂ are independently selected from the following structures: 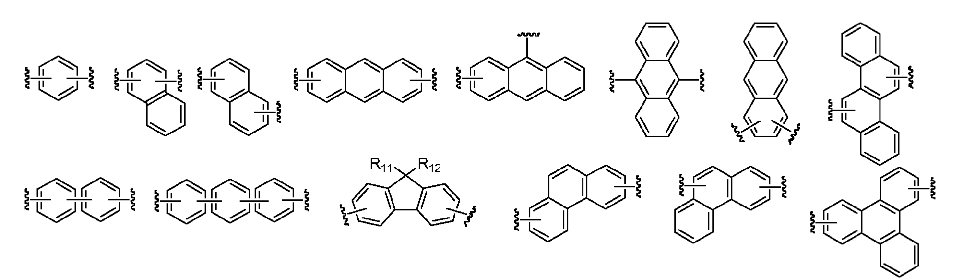 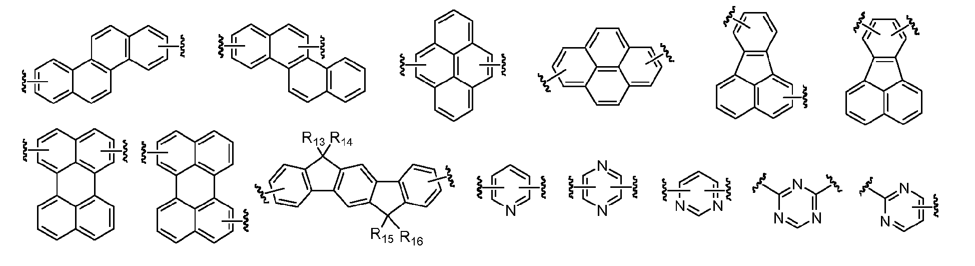 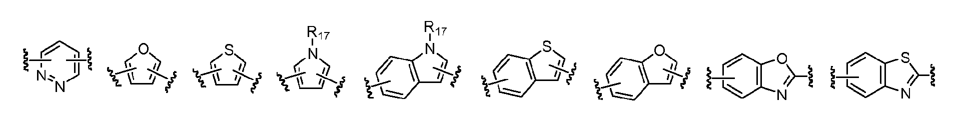 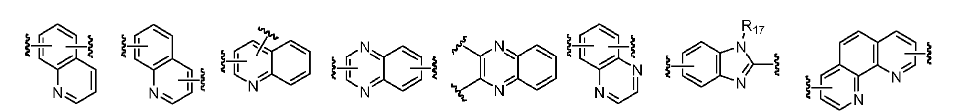 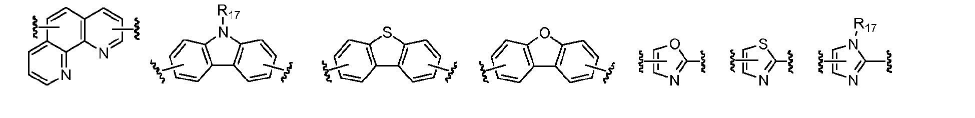 wherein
R₁₁ through R₁₇ independently represent hydrogen, deuterium, halogen, halo(C1-C60)alkyl, (C1-C60)alkyl, (C6-C60)aryl, (C3-C60)heteroaryl with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy.

4. The electroluminescent device according to claim 1, wherein R₁ through R₄ independently represent hydrogen, halogen, (C1-C60)alkyl, halo(C1-C60)alkyl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, cyano, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₁ through R₄ may be linked to an adjacent substituent via (C3-C60)alkylene or (C3-C60)alkenylene with or without a fused ring to form an alicyclic ring or a monocyclic or polycyclic aromatic ring, and R₁ through R₄ are independently selected from the following structures: 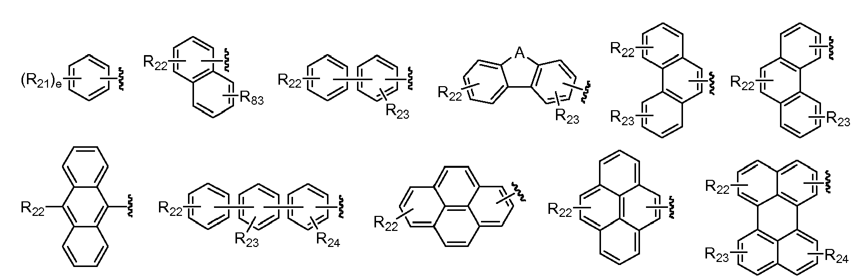 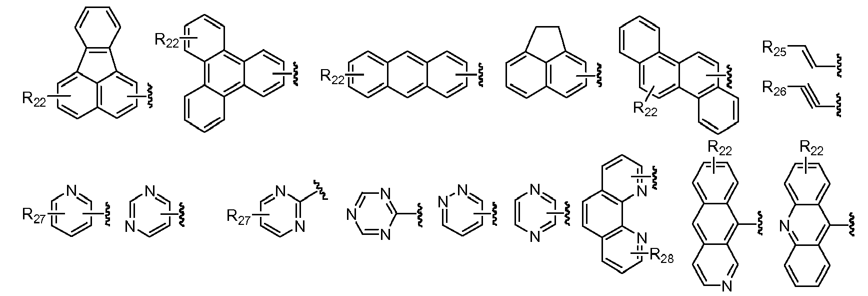 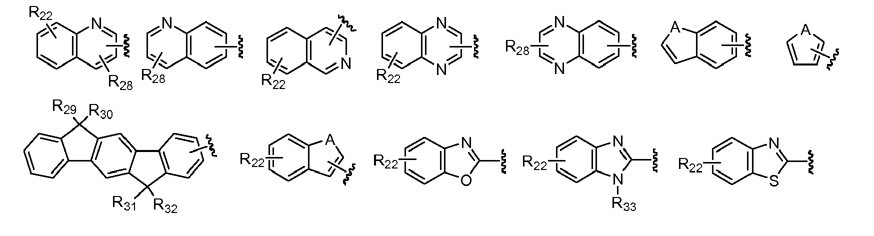 wherein
R₂₁ through R₃₃ independently represent hydrogen, deuterium, halogen, (C1-C60)alkyl, halo(C1-C60)alkyl, (C6-C60)aryl, (C3-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy;
A represents CR₃₄R₃₅, NR₃₅, S or O;
R₃₄ through R₃₅ independently represent hydrogen, deuterium, halogen, (C1-C60)alkyl, (C6-C60)aryl, (C3-C60)heteroaryl, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or R₃₄ and R₃₅ may be linked via (C3-C60)alkylene or (C3-C60)alkenylene with or without a fused ring to form an alicyclic ring or a monocyclic or polycyclic aromatic ring; and
e represents an integer from 1 to 5.

5. The electroluminescent device according to claim 2, wherein the host is selected from the compounds represented by Chemical Formulas 4 to 7: 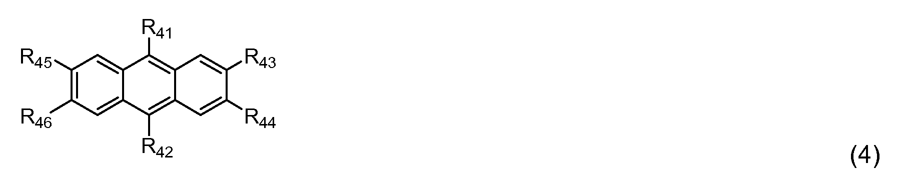 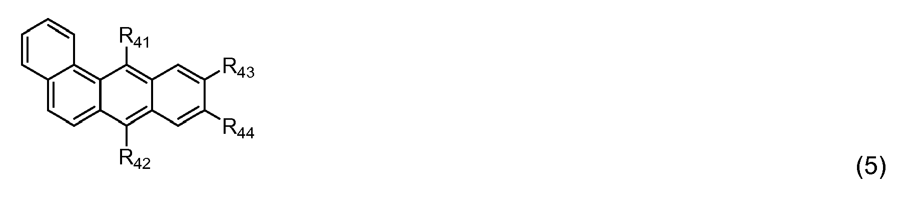 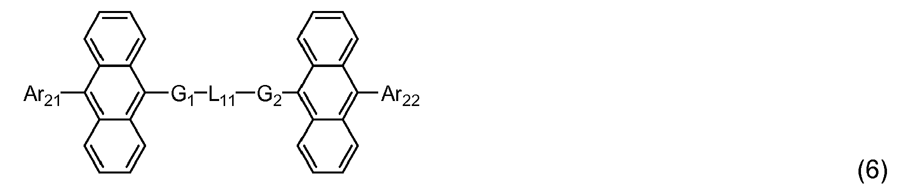 wherein
R₄₁ and R₄₂ independently represent (C6-C60)aryl, (C4-C60)heteroaryl, 5- or 6-membered heterocycloalkyl containing one or more heteroatom(s) selected from N, O and S or (C3-C60)cycloalkyl, and the aryl or heteroaryl of R₄₁ and R₄₂ may be further substituted by one or more substituent(s) selected from a group consisting of (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₄₃ through R₄₆ independently represent hydrogen, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₄₃ through R₄₆ may be further substituted by one or more substituent(s) selected from a group consisting of (C1-C60)alkyl with or without halogen substituent, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₂₁ and Ar₂₂ independently represent (C4-C60)heteroaryl or aryl selected from the following structures: 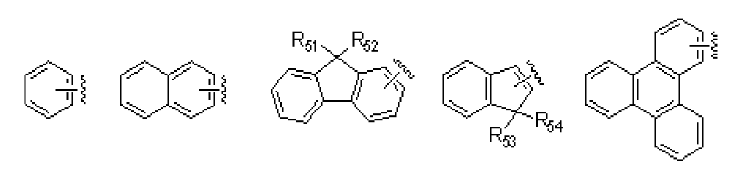 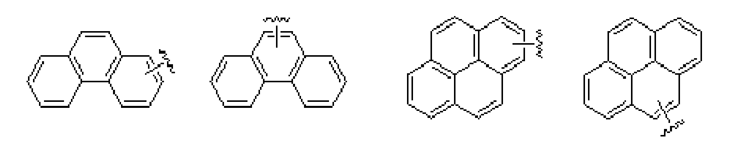 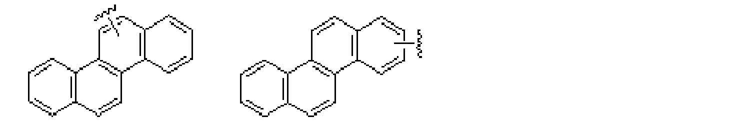 wherein
the aryl or heteroaryl of Ar₂₁ and Ar₂₂ may be substituted by one or more substituent(s) selected from (C1-C60)alkyl, (C1-C60)alkoxy, (C6-C60)aryl and (C4-C60)heteroaryl;
L₁₁ represents (C6-C60)arylene, (C4-C60)heteroarylene or a compound represented by the following structural formula: 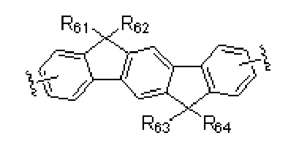 wherein
the arylene or heteroarylene of L₁₁ may be substituted by one or more substituent(s) selected from (C1-C60)alkyl, (C1-C60)alkoxy, (C6-C60)aryl, (C4-C60)heteroaryl and halogen;
R₅₁ through R₅₄ independently represent hydrogen, (C1-C60)alkyl or (C6-C60)aryl, or each of them may be linked to an adjacent substituent via (C3-C60)alkylene or (C3-C60)alkenylene with or without a fused ring to form an alicyclic ring or a monocyclic or polycyclic aromatic ring;
R₆₁ through R₆₄ independently represent hydrogen, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring or a monocyclic or polycyclic aromatic ring; 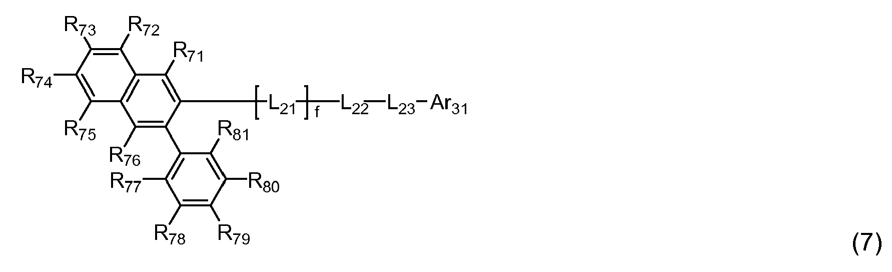 wherein
L₂₁ represents (C6-C60)arylene, (C3-C60)heteroarylene containing one or more heteroatom(s) selected from N, O and S or a divalent group selected from the following structures:; 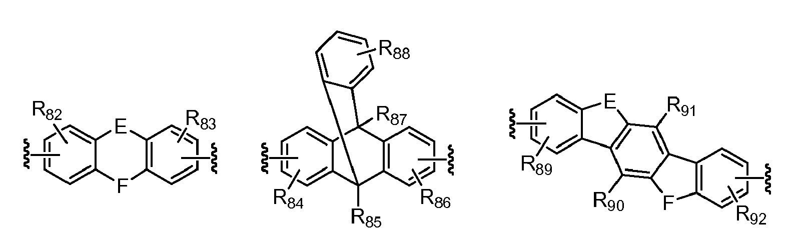 wherein
L₂₂ and L₂₃ independently represent a chemical bond, (C1-C60)alkyleneoxy, (C1-C60)alkylenethio, (C6-C60)aryleneoxy, (C6-C60)arylenethio, (C6-C60)arylene or (C3-C60)heteroarylene containing one or more heteroatom(s) selected from N, O and S;
Ar₃₁ represents NR₉₃R₉₄, (C6-C60)aryl, (C3-C60)heteroaryl containing one or more heteroatom(s) selected from N, O and S, 5- or 6-membered heterocycloalkyl containing one or more heteroatom(s) selected from N, O and S, (C3-C60)cycloalkyl, adamantyl, (C7-C60)bicycloalkyl or a substituent selected from the following structures: 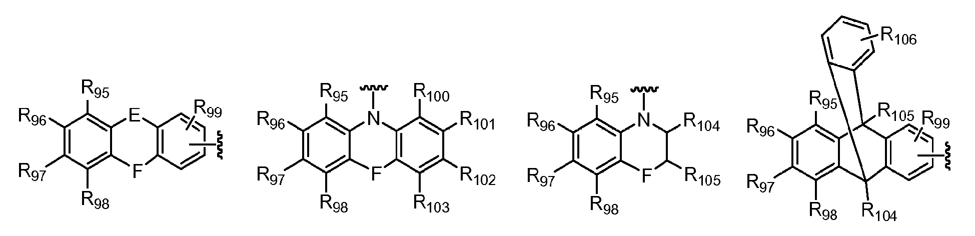 wherein
R₇₁ through R₈₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₇₁ through R₈₁ may be linked to an adjacent substituent via (C3-C60)alkylene or (C3-C60)alkenylene with or without a fused ring to form an alicyclic ring or a monocyclic or polycyclic aromatic ring;
R₈₂ through R₉₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₈₂ through R₉₂ may be linked to an adjacent substituent via (C3-C60)alkylene or (C3-C60)alkenylene with or without a fused ring to form an alicyclic ring or a monocyclic or polycyclic aromatic ring;
R₉₃ and R₉₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or R₉₃ and R₉₄ may be linked via (C3-C60)alkylene or (C3-C60)alkenylene with or without a fused ring to form an alicyclic ring or a monocyclic or polycyclic aromatic ring;
R₉₅ through R₁₀₆ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₉₅ through R₁₀₆ may be linked to an adjacent substituent via (C3-C60)alkylene or (C3-C60)alkenylene with or without a fused ring to form an alicyclic ring or a monocyclic or polycyclic aromatic ring;
E and F independently represent a chemical bond, -(CR₁₀₇R₁₀₂)_{g}-, -N(R₁₀₃)-, -S-, -O-, -Si(R₁₀₄)(R₁₀₅)-, -P(R₁₀₆)-, -C(=O)-, -B(R₁₀₇)-, -In(R₁₀₈)-, -Se-, -Ge(R₁₀₉)(R₁₁₀)-, -Sn(R₁₁₁)(R₁₁₂)-, -Ga(R₁₁₃)- or -(R₁₁₄)C=C(R₁₁₅)-;
R₁₀₇ through R₁₁₅ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or R₁₀₁ and R₁₀₂, R₁₀₄ and R₁₀₅, R₁₀₉ and R₁₁₀, R₁₁₁ and R₁₁₂, and R₁₁₄ and R₁₁₅ may be linked via (C3-C60)alkylene or (C3-C60)alkenylene with or without a fused ring to form an alicyclic ring or a monocyclic or polycyclic aromatic ring;
the arylene or heteroarylene of L₂₁ through L₂₃, the aryl or heteroaryl of Ar₃₁, or the alkyl, aryl, heteroaryl, heterocycloalkyl, cycloalkyl, trialkylsilyl, dialkylarylsilyl, triarylsilyl, alkenyl, alkynyl, alkylamino or arylamino of R₇₁ through R₈₁, R₈₂ through R₉₂, R₉₃, R₉₄, R₉₅ through R₁₀₆ or R₁₀₇ through R₁₁₅ may be independently further substituted by one or more substituent(s) selected from deuterium, halogen, (C1-C60)alkyl, halo(C1-C60)alkyl, (C6-C60)aryl, (C3-C60)heteroaryl containing one or more heteroatom(s) selected from N, O and S with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro, hydroxy, 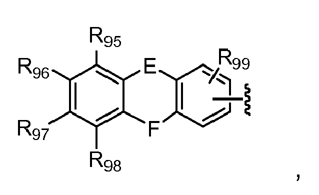 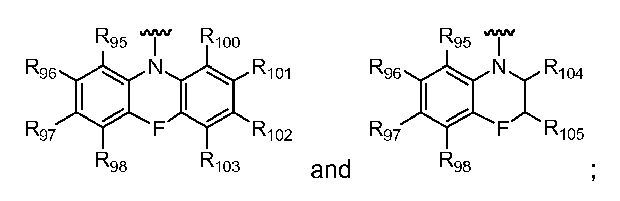
g represents an integer from 1 to 4; and
f represents an integer from 1 to 4.

6. The electroluminescent device according to claim 1, wherein the organic layer comprises one or more compound(s) selected from a group consisting of arylamine compounds and styrylamine compounds.

7. The electroluminescent device according to claim 1, wherein the organic layer further comprises one or more metal(s) selected from a group consisting of organic metals of Group 1, Group 2, 4th period and 5th period transition metals, lanthanide metals and d-transition elements.

8. The electroluminescent device according to claim 1, wherein the organic layer comprises an electroluminescent layer and a charge generating layer.

9. A white electroluminescent device comprising an electroluminescent compound represented by Chemical Formula 1, wherein the electroluminescent compound is a mixture of not less than 80% by weight and less than 100% by weight of the cis-form and more than 0% by weight and not more than 20% by weight of the trans-form: 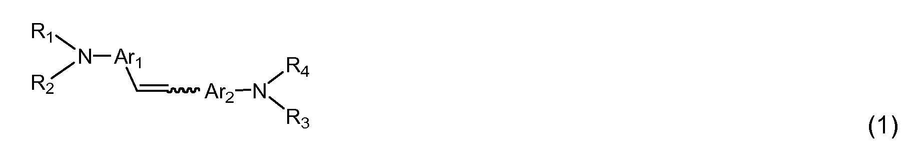 wherein
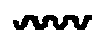 represents cis or trans configuration to the double bond;
Ar₁ and Ar₂ independently represent (C6-C60)arylene or (C5-C50)heteroarylene containing one or more heteroatom(s) selected from N, O and S;
R₁ through R₄ independently represent hydrogen, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₁ through R₄ may be linked to an adjacent substituent via (C3-C60)alkylene or (C3-C60)alkenylene with or without a fused ring to form an alicyclic ring or a monocyclic or polycyclic aromatic ring; and
the arylene or heteroarylene of Ar₁ and Ar₂, and the aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄ may be further substituted by one or more substituent(s) selected from a group consisting of deuterium, halogen, halo(C1-C60)alkyl, (C1-C60)alkyl, (C6-C60)aryl, (C3-C60)heteroaryl with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxy.

10. An organic solar cell comprising an electroluminescent compound represented by Chemical Formula 1, wherein the electroluminescent compound is a mixture of not less than 80% by weight and less than 100% by weight of the cis-form and more than 0% by weight and not more than 20% by weight of the trans-form: 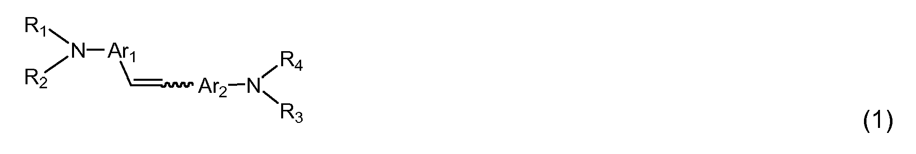 wherein
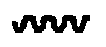 represents cis or trans configuration to the double bond;
Ar₁ and Ar₂ independently represent (C6-C60)arylene or (C5-C50)heteroarylene containing one or more heteroatom(s) selected from N, O and S;
R₁ through R₄ independently represent hydrogen, halogen, (C1-C60)alkyl, (C6-C60)aryl, (C3-C60)heteroaryl containing one or more heteroatom(s) selected from N, O and S, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxy, or each of R₁ through R₄ may be linked to an adjacent substituent via (C3-C60)alkylene or (C3-C60)alkenylene with or without a fused ring to form an alicyclic ring or a monocyclic or polycyclic aromatic ring; and
the arylene or heteroarylene of Ar₁ and Ar₂, and the aryl, heteroaryl, heterocycloalkyl, cycloalkyl, trialkylsilyl, dialkylarylsilyl, triarylsilyl, adamantyl, bicycloalkyl, alkenyl, alkynyl, aralkyl, alkyloxy, alkylthio, aryloxy, arylthio, alkylamino, arylamino, alkoxycarbonyl, alkylcarbonyl or arylcarbonyl of R₁ through R₄ may be further substituted by one or more substituent(s) selected from a group consisting of deuterium, halogen, halo(C1-C60)alkyl, (C1-C60)alkyl, (C6-C60)aryl, (C3-C60)heteroaryl with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, carbazolyl, mono- or di(C1-C60)alkylamino, mono- or di(C6-C60)arylamino, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxy.
